(19) Europäisches Patentamt
European Patent Office
Office européen des brevets

(11) EP 2 582 206 A1

(12) **EUROPEAN PATENT APPLICATION**
published in accordance with Art. 153(4) EPC

(43) Date of publication:
**17.04.2013 Bulletin 2013/16**

(21) Application number: **11792465.4**

(22) Date of filing: **08.06.2011**

(51) Int Cl.:
*H05B 33/12* (2006.01) *H01L 51/50* (2006.01)

(86) International application number:
**PCT/JP2011/063103**

(87) International publication number:
**WO 2011/155508 (15.12.2011 Gazette 2011/50)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **08.06.2010 JP 2010131538**

(71) Applicant: **Idemitsu Kosan Co., Ltd.**
**Chiyoda-ku**
**Tokyo 100-8321 (JP)**

(72) Inventors:
- **NISHIMURA Kazuki**
  **Sodegaura-shi**
  **Chiba 299-0293 (JP)**
- **KUMA Hitoshi**
  **Sodegaura-shi**
  **Chiba 299-0293 (JP)**
- **HOSOKAWA Chishio**
  **Sodegaura-shi**
  **Chiba 299-0293 (JP)**
- **NAGASHIMA Hideaki**
  **Sodegaura-shi**
  **Chiba 299-0293 (JP)**
- **NUMATA Masaki**
  **Sodegaura-shi**
  **Chiba 299-0293 (JP)**

(74) Representative: **Gille Hrabal**
**Patentanwälte**
**Brucknerstrasse 20**
**40593 Düsseldorf (DE)**

(54) **ORGANIC ELECTROLUMINESCENT ELEMENT**

(57) An organic electroluminescence device includes: an anode (3); a cathode (4) being opposed to the anode (3); and a first emitting layer (51) and a second emitting layer (52) being provided between the anode (3) and the cathode (4) in this sequence from the anode (3). The first emitting layer (51) and the second emitting layer (52) each include a host and a phosphorescent dopant. The host of the first emitting layer (51) and the host of the second emitting layer (52) each have a triplet energy of 2.8 eV or more. The host of the first emitting layer (51) has an ionization potential of 5.5 eV or less. An affinity $Af_1$ of the host of the first emitting layer (51) is smaller than an affinity $Af_2$ of the host of the second emitting layer (52).

FIG. 1

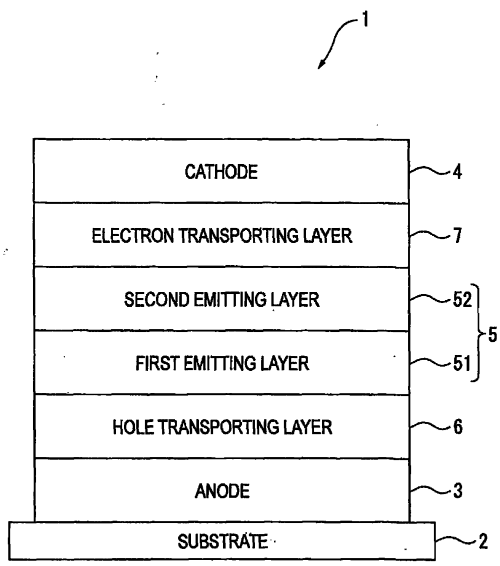


EP 2 582 206 A1

## Description

### TECHNICAL FIELD

The present invention relates to an organic electroluminescence device.

### BACKGROUND ART

An organic electroluminescence device (hereinafter, electroluminescence is occasionally abbreviated as EL) is a self-emitting device based on the principle that, when an electrical field is applied, a fluorescent material emits light using energy generated by a recombination of holes injected from an anode with electrons injected from a cathode. Organic EL devices formed from organic materials have been vigorously studied since a report on a low voltage-driven organic electroluminescence device formed by laminating layers was made by C. W. Tang et al. of Eastman Kodak Company.
There has been proposed a phosphorescent organic electroluminescence device in which an organic phosphorescent material is used in an emitting layer. Such a phosphorescent organic electroluminescence device uses excited states of the organic phosphorescent material, i.e., a singlet state and a triplet state, to provide a high luminous efficiency. When electrons and holes are recombined in an organic EL device, it is presumed that singlet excitons and triplet excitons are produced at a rate of 1:3 due to difference in spin multiplicity. Thus, a device using a phosphorescent material presumably achieves three to four times higher luminous efficiency than a device using only fluorescence.
Various studies have been made for improving the luminous efficiency of an organic electroluminescence device using a phosphorescent material.
As a result of one of such studies, there has been proposed an organic electroluminescence device in which a plurality of emitting layers are layered between the anode and the cathode (see, for instance, Patent Literatures 1 to 4 and Non-Patent Literature 1).

### CITATION LIST

### PATENT LITERATURES

Patent Literature 1: JP-A-2001-319779
Patent Literature 2: JP-A-2008-84913
Patent Literature 3: JP-A-2010-34484
Patent Literature 4: W02005/079118

### NON-PATENT LITERATURE

Non-Patent Literature 1: X.Zhou et al.,Appl.Phys.Lett.,Vol.81,p.4070-4072(2002)

### SUMMARY OF THE INVENTION

### PROBLEMS TO BE SOLVED BY THE INVENTION

One of two emitting layers in an organic EL device disclosed in Non-Patent Literature 1 includes TCTA as a host and a phosphorescent dopant. Since TCTA is a hole transporting material that is less tolerant to electrons, the lifetime of the organic EL device is shortened.
An organic EL device disclosed in Patent Literature 1 emits orange light because a host used in two layered emitting layers 1 has a small triplet energy.
A carbazole host, which is excellent in electron tolerance as compared with the host disclosed in Non-Patent Literature 1 and has a large triplet energy enabling blue emission, is used in organic EL devices disclosed in Patent Literatures 2 to 4. However, while enabling blue emission, such a carbazole host disclosed in Patent Literatures 2 to 4 shortens the lifetime of the device.

An object of the invention is to provide a highly efficient and long-life organic electroluminescence device capable of blue emission.

MEANS FOR SOLVING THE PROBLEMS

According to an aspect of the invention, an organic electroluminescence device includes: an anode; a cathode being opposed to the anode; and a first emitting layer and a second emitting layer being provided between the anode and the cathode in this sequence from the anode, in which the first emitting layer and the second emitting layer each includes a host and a phosphorescent dopant, the host of the first emitting layer and the host of the second emitting layer each have a triplet energy of 2.8 eV or more, the host of the first emitting layer has an ionization potential of 5.5 eV or less, and an affinity $Af_1$ of the host of the first emitting layer is smaller than an affinity $Af_2$ of the host of the second emitting layer.

In the above aspect, it is preferable that the affinity $Af_1$ of the host of the first emitting layer and the affinity $Af_2$ of the host of the second emitting layer satisfy a relationship of $Af_2 - Af_1 \geq 0.4$ [eV].

In the above aspect, it is preferable that a difference between a singlet energy of the host of the first emitting layer and the triplet energy of the host of the first emitting layer is smaller than a difference between a singlet energy of the host of the second emitting layer and the triplet energy of the host of the second emitting layer.

In the above aspect, it is preferable that the first emitting layer and the second emitting layer are layered on each other.

In the above aspect, it is preferable that an emission peak of the phosphorescent dopants is 480 nm or less.

In the above aspect, it is preferable that a material for forming the phosphorescent dopant of the first emitting layer is different from a material for forming the phosphorescent dopant of the second emitting layer.

EFFECTS OF THE INVENTION

According to the invention, a highly efficient and long-life organic electroluminescence device capable of blue emission can be provided.

BRIEF DESCRIPTION OF DRAWINGS

Fig. 1 schematically shows an exemplary arrangement of an organic electroluminescence device according to an exemplary embodiment of the invention.

Fig. 2 shows an energy diagram of the organic electroluminescence device according to the exemplary embodiment.

DESCRIPTION OF EMBODIMENT(S)

Embodiment(s) of the invention will be described below.

Arrangement of Organic Electroluminescence Device

An arrangement of an organic electroluminescence device (hereinafter abbreviated as organic EL device) will be described below.

The following are representative arrangement examples of the organic EL device.

(1) anode / emitting layer / cathode
(2) anode / hole injecting layer / emitting layer / cathode
(3) anode / emitting layer / electron injecting·transporting layer / cathode
(4) anode / hole injecting layer / emitting layer / electron injecting·transporting layer / cathode
(5) anode / hole injecting·transporting layer / emitting layer / electron injecting·transporting layer / cathode

In the organic EL device according to the exemplary embodiment, the emitting layer of each of the above arrangements is provided by two or more emitting layers. The emitting layer provided near the anode is defined as a first emitting layer and the emitting layer provided near the cathode is defined as a second emitting layer. The first emitting layer and the second emitting layer may be adjacently layered on each other. Alternatively, other emitting layers or intermediate layers that are not emitting layers may be provided between the first emitting layer and the second emitting layer, or other emitting layer and intermediate layers that are not emitting layers may be layered to be provided between the first emitting layer and the second emitting layer.

It should be noted that the "hole injecting/transporting layer (or hole injecting·transporting layer)" herein means "at least one of hole injecting layer and hole transporting layer" while "electron injecting/transporting layer (or electron

injecting·transporting layer)" herein means "at least one of electron injecting layer and electron transporting layer".

While the arrangement (5) is preferably used among the above, the arrangement of the invention is not limited to the above arrangements.

Fig. 1 shows an organic EL device 1 according to the exemplary embodiment.
The organic EL device 1 includes a transparent substrate 2, an anode 3, a cathode 4, a hole transporting layer 6, an emitting layer 5 including a first emitting layer 51 and a second emitting layer 52, and an electron transporting layer 7. The hole transporting layer 6, the first emitting layer 51, the second emitting layer 52, the electron transporting layer 7 and the cathode 4 are in this sequence layered on the anode 3.

First Emitting Layer

The first emitting layer 51 is layered between the hole transporting layer 6 and the second emitting layer 52. The first emitting layer 51 is adjacent to the hole transporting layer 6 and the second emitting layer 52.
The first emitting layer 51 contains a first host and a phosphorescent dopant.
A concentration of the phosphorescent dopant is not particularly limited in the exemplary embodiment but is preferably in a range from 0.1 mass% to 30 mass%, more preferably in a range from 1 mass% to 20 mass%.

First Host

In the exemplary embodiment, the triplet energy of the first host is 2.8 eV or more and the ionization potential of the first host is 5.5 eV or less.

The first host is preferably a non-amine-based compound, more preferably a compound represented by the following formula (1).

[Formula 1]

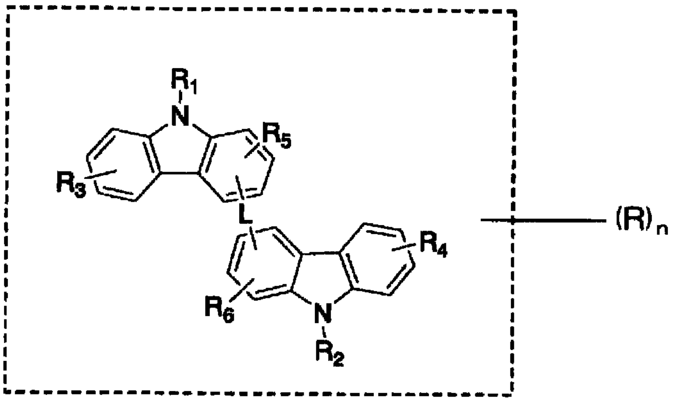

(1)

In the formula (1), R represents a substituent substitutable for a carbazole skeleton or L. n represents the number of R. n is 0 to 6, preferably 0 to 4. When n is 2 or larger, a plurality of R may be mutually different.

Examples of R are as follows:

an alkyl group having 1 to 20 carbon atoms;
a cycloalkyl group having 3 to 20 carbon atoms;
an alkoxy group having 1 to 20 carbon atoms;
a cycloalkoxy group having 3 to 20 carbon atoms;
an aryl group having 6 to 18 carbon atoms;
an aryloxy group having 6 to 18 carbon atoms;
a heteroaryl group having 5 to 18 carbon atoms (including carbazole, dibenzofuran and dibenzothiophene);
an amino group (which may have a substituent such as the above alkyl group, cycloalkyl group and aryl group);
a silyl group (which may have a substituent such as the above alkyl group, cycloalkyl group and aryl group);
a fluoro group; and
a cyano group.

The above substituents may be further substituted with these substituents.

In the formula (1), each of $R_1$ to $R_6$ represents a substituent, examples of which are the same as those mentioned in relation to R in the formula (1).

In the formula (1), L, which bonds two carbazole skeletons, is a single bond or a divalent bonding group containing an element such as carbon (C), nitrogen (N), oxygen (O), silicon (Si), phosphorus (P) and sulfur (S).

Examples of L are as follows:

an oxygen (O) atom;
a sulfur (S) atom;
a sulfoxide group;
a divalent phosphoxide group;
a divalent alkylene group having 1 to 20 carbon atoms;
a divalent cycloalkylene group having 3 to 20 carbon atoms;
a divalent arylene group having 6 to 18 carbon atoms;
a divalent heteroarylene group having 5 to 18 carbon atoms (including carbazole, dibenzofuran and dibenzothiophene);
a divalent amino group (which may have a substituent such as the alkyl group, cycloalkyl group and aryl group described in relation to R in the formula (1)); and
a divalent silyl group (which may have a substituent such as the alkyl group, cycloalkyl group and aryl group described in relation to R in the formula (1)).

These bonding groups may further have a substituent. Examples of the substituent may be the same as those mentioned in relation to R in the formula (1).

In the formula (1), R may be a hydrogen atom. Herein, "hydrogen" is meant to also include deuterium.

In the formula (1), the aryl group (aromatic hydrocarbon group) as R may have 6 to 30 carbon atoms forming the aromatic ring (hereinafter referred to as ring carbon atoms). The aryl group may have a fused ring structure.

In the formula (1), the alkyl group as R may be substituted with halogen to be a haloalkyl group and the alkoxy group as R may be substituted with halogen to be a haloalkoxy group.

In the formula (1), the heteroaryl group (aromatic heterocyclic group) as R may have 2 to 30 ring carbon atoms. The heteroaryl group may have a fused ring structure.

In the formula (1), $R_1$ and $R_2$ may be bonded at N-position (9-position) of the carbazole skeleton directly or via a bonding group. Examples of the bonding group are $X^1$ and $X^2$ in a formula (1A) described below and $L^2$ and $L^3$ in a formula (1C) described below.

In the formula (1), an adjacent set of the substituents substituted for the carbazole skeleton may be mutually bonded to form a ring structure.

In the exemplary embodiment, the first host is more preferably a compound represented by the following formula (2).

[Formula 2]

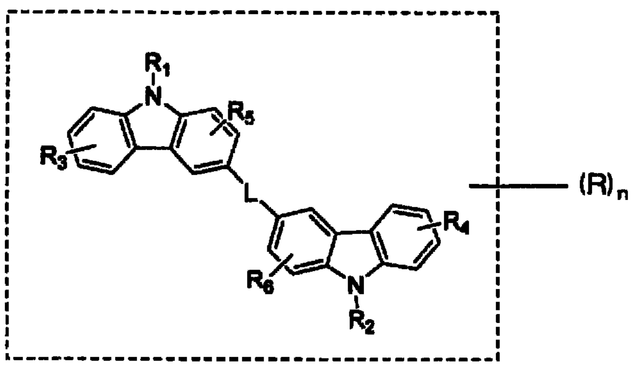

(2)

In the formula (2), examples of R and $R_1$ to $R_6$ are the same as those of R in the formula (1).

Examples ofn are the same as those ofn in the formula (1).

Examples of L are the same as those of L in the formula (1). In the formula (2), L bonds carbon atoms provided at 3-positions of two carbazole skeletons.

In the formula (1) or (2), $R_1$ and $R_2$ may preferably contain no azine ring.

In the formula (1) or (2), preferable examples of $R_1$ to $R_6$ are as follows:

an aromatic heterocyclic group containing an oxygen atom as a hetero atom;
an aromatic heterocyclic group containing a sulfur atom as a hetero atom;
an aromatic heterocyclic group containing an oxygen atom and a sulfur atom as hetero atoms; and
a monovalent residue of an N-arylcarbazole.

Preferably, the monovalent residue of the N-arylcarbazole, which is provided by substituting N of carbazole with an aryl group, is not bonded to a biscarbazole skeleton represented by the formula (1) or (2) via the aryl group.
In the exemplary embodiment, among the compounds represented by the formula (1), the first host is preferably a compound represented by the following formula (1A).

[Formula 3]

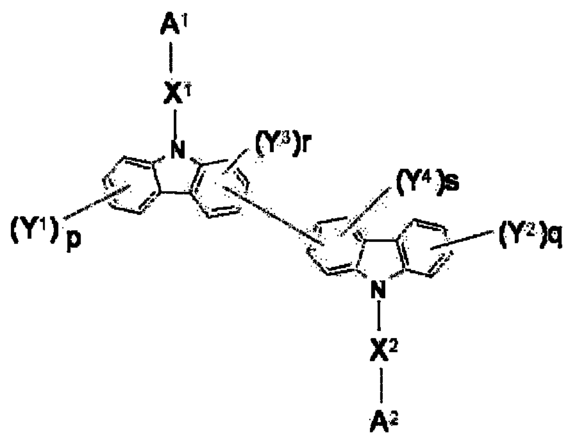

(1 A)

In the formula (1A), $A^1$ represents a substituted or unsubstituted nitrogen-containing heterocyclic group having 1 to 30 ring carbon atoms.
In the formula (1A), $A^2$ represents a substituted or unsubstituted aromatic hydrocarbon group having 6 to 30 ring carbon atoms, or a substituted or unsubstituted nitrogen-containing heterocyclic group having 1 to 30 ring carbon atoms.
In the formula (1A), $X^1$ and $X^2$ are bonding groups and each independently represent one of the following:

a single bond;
a substituted or unsubstituted aromatic hydrocarbon group having 6 to 30 ring carbon atoms;
a substituted or unsubstituted fused aromatic hydrocarbon group having 6 to 30 ring carbon atoms;
a substituted or unsubstituted aromatic heterocyclic group having 2 to 30 ring carbon atoms; and
a substituted or unsubstituted fused aromatic heterocyclic group having 2 to 30 ring carbon atoms.

In the formula (1A), $Y^1$ to $Y^4$ each independently represent one of the following:

a hydrogen atom;
a fluorine atom;
a cyano group;
a substituted or unsubstituted alkyl group having 1 to 20 carbon atoms;
a substituted or unsubstituted alkoxy group having 1 to 20 carbon atoms;
a substituted or unsubstituted haloalkyl group having 1 to 20 carbon atoms;
a substituted or unsubstituted haloalkoxy group having 1 to 20 carbon atoms;
a substituted or unsubstituted alkylsilyl group having 1 to 10 carbon atoms;
a substituted or unsubstituted arylsilyl group having 6 to 30 carbon atoms;
a substituted or unsubstituted aromatic hydrocarbon group having 6 to 30 ring carbon atoms;
a substituted or unsubstituted fused aromatic hydrocarbon group having 6 to 30 ring carbon atoms;

a substituted or unsubstituted aromatic heterocyclic group having 2 to 30 ring carbon atoms; and
a substituted or unsubstituted fused aromatic heterocyclic group having 2 to 30 ring carbon atoms.

In the formula (1A), an adjacent set of $Y^1$ to $Y^4$ may be mutually bonded to form a ring structure.

In the formula (1A), each of p and q is an integer of 1 to 4.
In the formula (1A), each of r and s is an integer of 1 to 3.
When each of p and q is an integer of 2 to 4 and each of r and s is an integer of 2 to 3, a plurality of $Y^1$ to $Y^4$ may be mutually the same or different.

When $Y^1$ to $Y^4$ are mutually bonded to form a ring structure, the ring structure is exemplified by structures represented by the following formulae (1B).

[Formula 4]

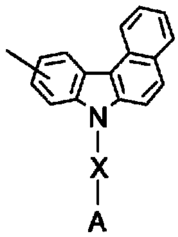
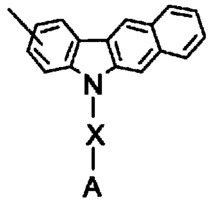
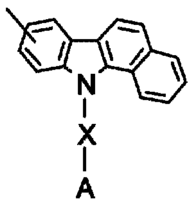
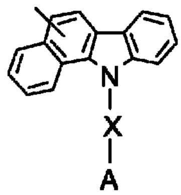

(1 B)

In the exemplary embodiment, among the compounds represented by the formula (1A), the first host is preferably a compound represented by the following formula (2A).

[Formula 5]

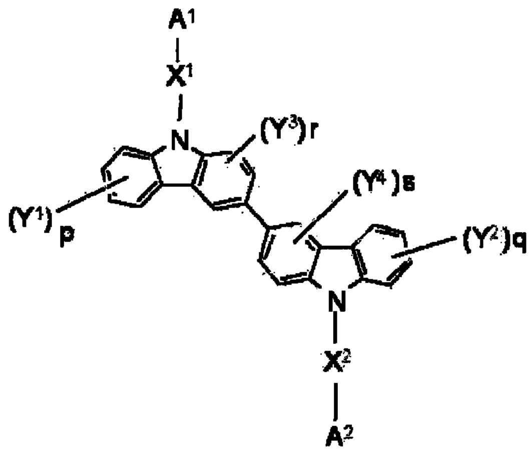

(2 A)

In the formula (2A), $A^1$, $A^2$, $X^1$, $X^2$, $Y^1$ to $Y^4$, p, q, r and s are the same as those in the formula (1A).

In the formula (2A), it is preferable that $A^1$ and $A^2$ are simultaneously nitrogen-containing heterocyclic groups. In this case, each of $A^1$ and $A^2$ is preferably a substituted or unsubstituted aromatic heterocyclic group having 2 to 30 ring carbon atoms, or a substituted or unsubstituted fused aromatic heterocyclic group having 2 to 30 ring carbon atoms. Further, in the formula (2A), $A^1$ is preferably selected from a group consisting of a substituted or unsubstituted pyridine ring, substituted or unsubstituted pyrimidine ring, and substituted or unsubstituted triazine ring, more preferably selected from a substituted or unsubstituted pyrimidine ring, and substituted or unsubstituted triazine ring.

In the exemplary embodiment, $A^1$ in the formula (2A) is preferably a substituted or unsubstituted pyrimidine ring, and the first host is preferably a compound represented by the following formula (2B).

[Formula 6]

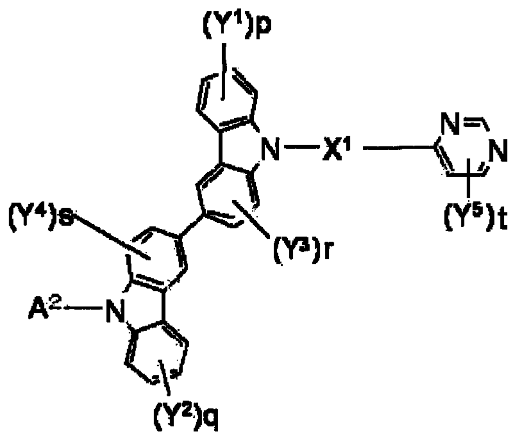

(2 B)

In the formula (2B), $A^2$, $X^1$, $Y^1$ to $Y^4$, p, q, r and s are the same as those in the formula (2A).
In the formula (2B), $Y^5$ represents the same as $Y^1$ to $Y^4$ in the formula (2A).
In the formula (2B), t is an integer of 1 to 3. When t is an integer of 2 or 3, a plurality of $Y^5$ may be mutually the same or different.

In the formula (2B), $A^2$ is preferably a nitrogen-containing heterocyclic group. In this case, $A^2$ 2 is preferably a substituted or unsubstituted aromatic heterocyclic group having 2 to 30 ring carbon atoms, or a substituted or unsubstituted fused aromatic heterocyclic group having 2 to 30 ring carbon atoms.

In the formula (1A) or (2A), $A^1$ is preferably a substituted or unsubstituted quinazoline ring.

In the formulae (1A), (2A) and (2B), $X^1$ is preferably a single bond or a substituted or unsubstituted divalent aromatic hydrocarbon group having 6 to 30 ring carbon atoms. $X^1$ is more preferably a substituted or unsubstituted divalent aromatic hydrocarbon group having 6 to 30 ring carbon atoms. $X^1$ is particularly preferably a phenylene group provided by removing two hydrogen atoms from a benzene ring or a naphthylene group provided by removing two hydrogen atoms from a naphthalene ring.

In the formulae (1A), (2A) and (2B), when $X^1$ is a substituted or unsubstituted benzene ring, $A^1$ and a carbazolyl group, which are bonded to $X^1$, are preferably at meta positions or para positions. Particularly preferably, $X^1$ is unsubstituted para-phenylene.

In the formulae (1A), (2A) and (2B), the pyridine ring, pyrimidine ring and triazine ring are more preferably represented by the following formulae (2C). In the formulae, each of Y and Y' represents a substituent. Examples of the substituent are the same groups as $Y^1$ to $Y^4$ as described above. Y and Y' may be the same or different. Preferred examples thereof are the substituted or unsubstituted aromatic hydrocarbon group or fused aromatic hydrocarbon group having 6 to 30 ring carbon atoms, and the substituted or unsubstituted aromatic heterocyclic group or fused aromatic heterocyclic group having 2 to 30 ring carbon atoms. In the following formulae (2C), * represents a bonding position to $X^1$ or $X^2$.

[Formula 7]

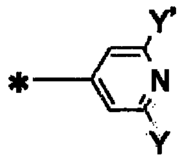 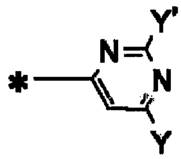 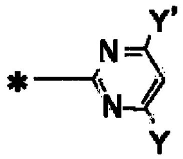 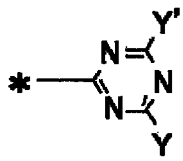

(2C)

In the formulae (1A), (2A) and (2B), the quinazoline ring is represented by the following formula (2D).

In the formula (2D), Y represents a substituent.

In the formula (2D), u is an integer of 1 to 5. When u is an integer of 2 to 5, a plurality of Y may be mutually the same or different.

Examples of the substituent Y in the formula (2D) may be the same as the groups $Y^1$ to $Y^4$ described above. Preferred examples of the substituent Y are the substituted or unsubstituted aromatic hydrocarbon group or fused aromatic hydrocarbon group having 6 to 30 ring carbon atoms, and the substituted or unsubstituted aromatic heterocyclic group or fused aromatic heterocyclic group having 2 to 30 ring carbon atoms.

In the following formula (2D), * also represents a bonding position to $X^1$ or $X^2$.

[Formula 8]

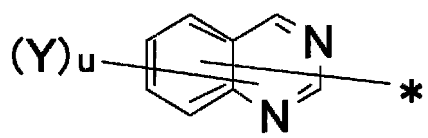

(2D)

In the formulae (1A), (2A) and (2B), the alkyl group, alkoxy group, haloalkyl group, haloalkoxy group and alkylsilyl group, which are represented by $Y^1$ to $Y^5$, may have a linear, branched or cyclic structure.

In the formulae (1A), (2A) and (2B), examples of the alkyl group having 1 to 20 carbon atoms are a methyl group, ethyl group, propyl group, isopropyl group, n-butyl group, s-butyl group, isobutyl group, t-butyl group, n-pentyl group, n-hexyl group, n-heptyl group, n-octyl group, n-nonyl group, n-decyl group, n-undecyl group, n-dodecyl group, n-tridecyl group, n-tetradecyl group, n-pentadecyl group, n-hexadecyl group, n-heptadecyl group, n-octadecyl group, neo-pentyl group, 1-methylpentyl group, 2-methylpentyl group, 1-pentylhexyl group, 1-butylpentyl group, 1-heptyloctyl

group, 3-methylpentyl group, cyclopentyl group, cyclohexyl group, cycloheptyl group, cyclooctyl group and 3,5-tetramethylcyclohexyl group. Examples of the alkyl group having 1 to 10 carbon atoms are a methyl group, ethyl group, propyl group, isopropyl group, n-butyl group, s-butyl group, isobutyl group, t-butyl group, cyclopentyl group, cyclohexyl group and cycloheptyl group.

In the formulae (1A), (2A) and (2B), as the alkoxy group having 1 to 20 carbon atoms, an alkoxy group having 1 to 6 carbon atoms is preferable and specific examples thereof are a methoxy group, ethoxy group, propoxy group, butoxy group, pentyloxy group, and hexyloxy group.

In the formulae (1A), (2A) and (2B), the haloalkyl group having 1 to 20 carbon atoms is exemplified by a haloalkyl group provided by substituting the alkyl group having 1 to 20 carbon atoms with one or more halogen atoms. Preferred one of the halogen atoms is fluorine. The haloalkyl group is exemplified by a trifluoromethyl group and a 2,2,2-trifluoroethyl group.

In the formulae (1A), (2A) and (2B), the haloalkoxy group having 1 to 20 carbon atoms is exemplified by a haloalkoxy group provided by substituting the alkoxy group having 1 to 20 carbon atoms with one or more halogen atoms.

In the formulae (1A), (2A) and (2B), examples of the alkylsilyl group having 1 to 10 carbon atoms are a trimethylsilyl group, triethylsilyl group, tributylsilyl group, dimethylethylsilyl group, dimethylisopropylsilyl group, dimethylpropylsilyl group, dimethylbutylsilyl group, dimethyl-tertiary-butylsilyl group and diethylisopropylsilyl group.

In the formulae (1A), (2A) and (2B), examples of the arylsilyl group having 6 to 30 carbon atoms are a phenyldimethylsilyl group, diphenylmethylsilyl group, diphenyl-tertiary-butylsilyl group and triphenylsilyl group.

In the formulae (1A), (2A) and (2B), examples of the aromatic heterocyclic group or fused aromatic heterocyclic group having 2 to 30 ring carbon atoms are a pyroryl group, pyrazinyl group, pyridinyl group, indolyl group, isoindolyl group, furyl group, benzofuranyl group, isobenzofuranyl group, dibenzofuranyl group, dibenzothiophenyl group, quinolyl group, isoquinolyl group, quinoxalinyl group, carbazolyl group, phenantridinyl group, acridinyl group, phenanthrolinyl group, thienyl group and a group formed from a pyridine ring, pyrazine ring, pyrimidine ring, pyridazine ring, triazine ring, indol ring, quinoline ring, acridine ring, pirrolidine ring, dioxane ring, piperidine ring, morpholine ring, piperadine ring, carbazole ring, furan ring, thiophene ring, oxazole ring, oxadiazole ring, benzooxazole ring, thiazole ring, thiadiazole ring, benzothiazole ring, triazole ring, imidazole ring, benzoimidazole ring, pyrane ring and dibenzofuran ring. Among the above, the aromatic heterocyclic group or fused aromatic heterocyclic group having 2 to 10 ring carbon atoms is preferable.

In the formulae (1A), (2A) and (2B), examples of the aromatic hydrocarbon group or fused aromatic hydrocarbon group having 6 to 30 ring carbon atoms are a phenyl group, naphthyl group, phenanthryl group, biphenyl group, terphenyl group, quarterphenyl group, fluoranthenyl group, triphenylenyl group, phenanthrenyl group, pyrenyl group, chrysenyl group, fluorenyl group, and 9,9-dimethylfluorenyl group. Among the above, the aromatic hydrocarbon group or fused aromatic hydrocarbon group having 6 to 20 ring carbon atoms is preferable.

When $A^1$, $A^2$, $X^1$, $X^2$ and $Y^1$ to $Y^5$ in the formulae (1A), (2A) and (2B) each have one or more substituents, the substituents are preferably a linear, branched or cyclic alkyl group having 1 to 20 carbon atoms; linear, branched or cyclic alkoxy group having 1 to 20 carbon atoms; linear, branched or cyclic haloalkyl group having 1 to 20 carbon atoms; linear, branched or cyclic alkylsilyl group having 1 to 10 carbon atoms; arylsilyl group having 6 to 30 ring carbon atoms; cyano group; halogen atom; aromatic hydrocarbon group or fused aromatic hydrocarbon group having 6 to 30 ring carbon atoms; or aromatic heterocyclic group or fused aromatic heterocyclic group having 2 to 30 ring carbon atoms.

Examples of the linear, branched or cyclic alkyl group having 1 to 20 carbon atoms; linear, branched or cyclic alkoxy group having 1 to 20 carbon atoms; linear, branched or cyclic haloalkyl group having 1 to 20 carbon atoms; linear, branched or cyclic alkylsilyl group having 1 to 10 carbon atoms; arylsilyl group having 6 to 30 ring carbon atoms; aromatic hydrocarbon group or fused aromatic hydrocarbon group having 6 to 30 ring carbon atoms; and aromatic heterocyclic group or fused aromatic heterocyclic group having 2 to 30 ring carbon atoms are the above-described groups. The halogen atom is exemplified by a fluorine atom.

Exemplary compounds of the first host according to the exemplary embodiment represented by the formulae (1A), (2A) and (2B) are shown below.

[Formula 9]

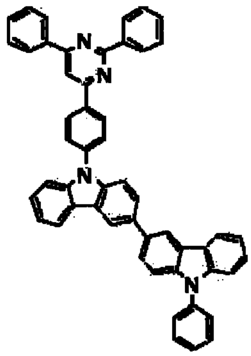

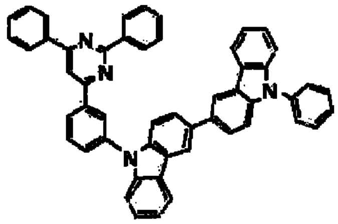

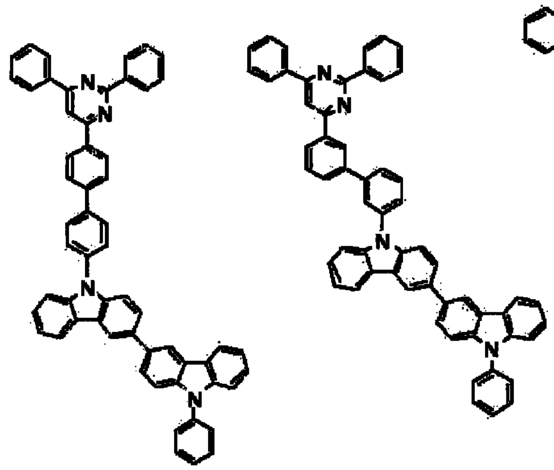

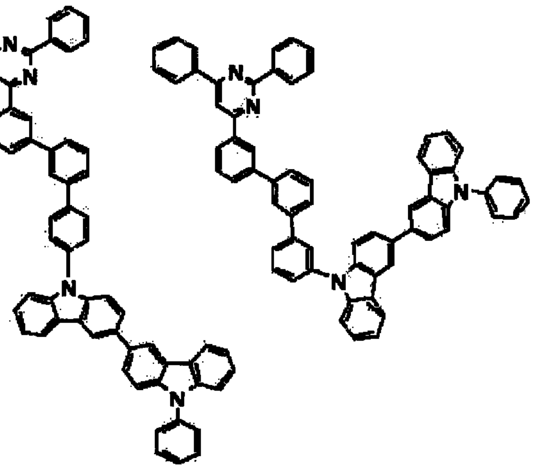

[Formula 10]

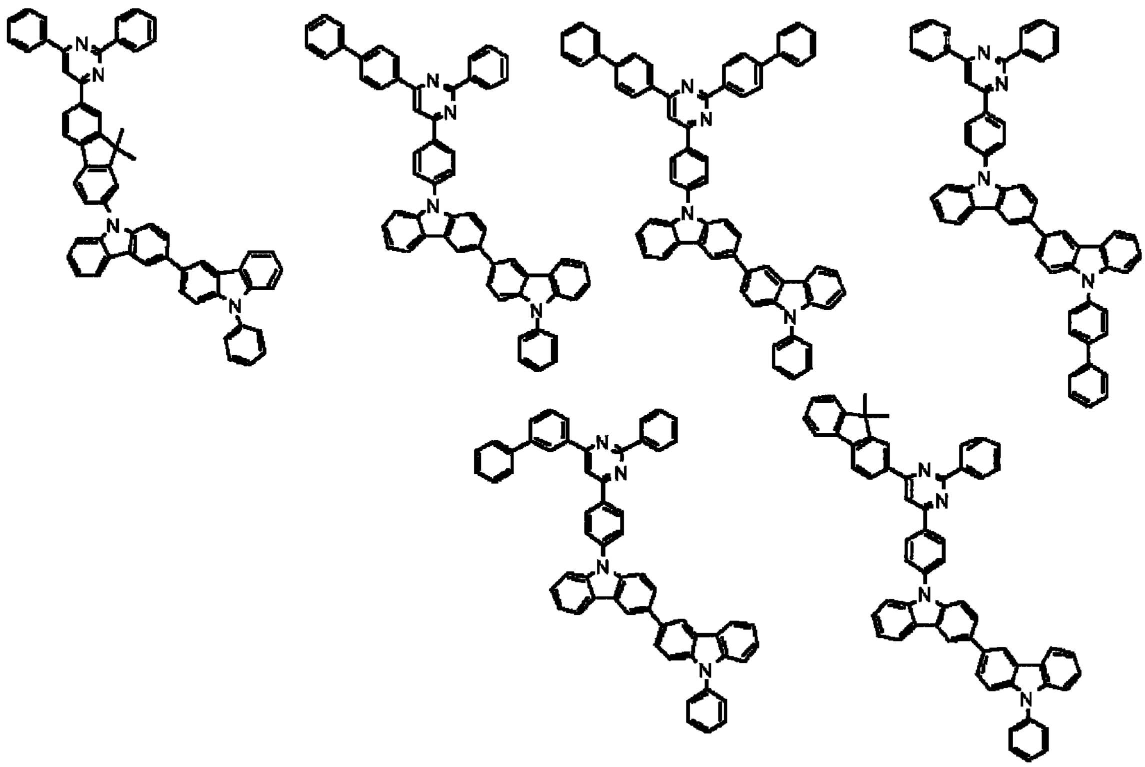

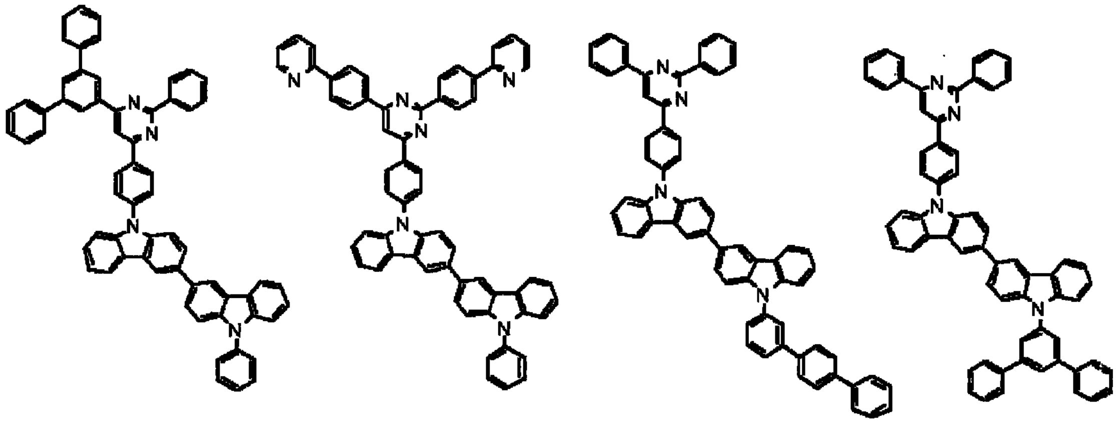

[Formula 11]

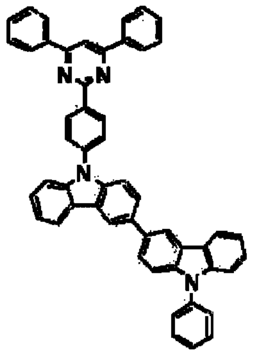

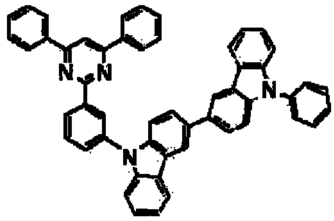

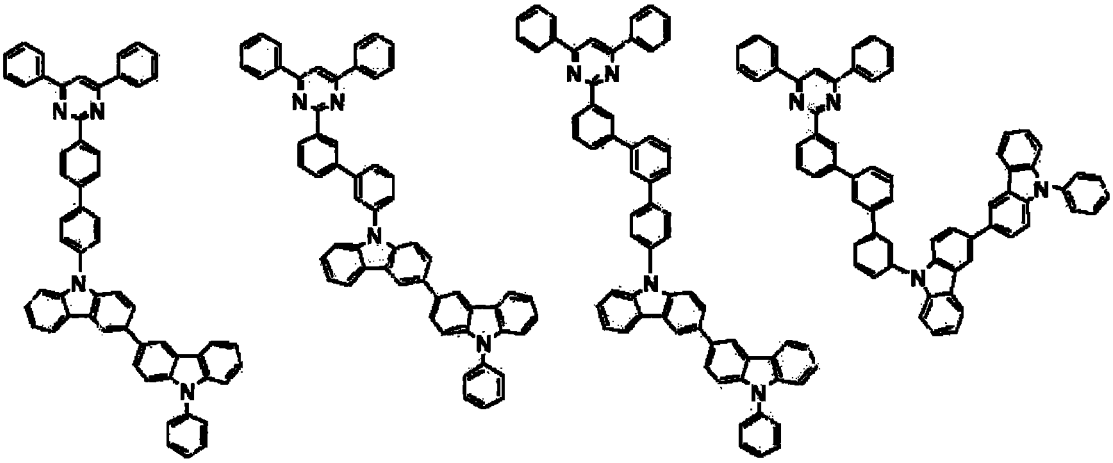

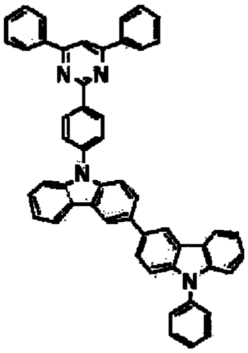

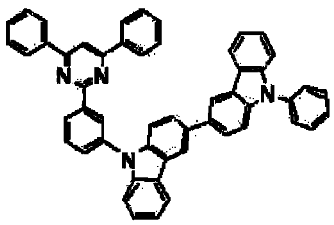

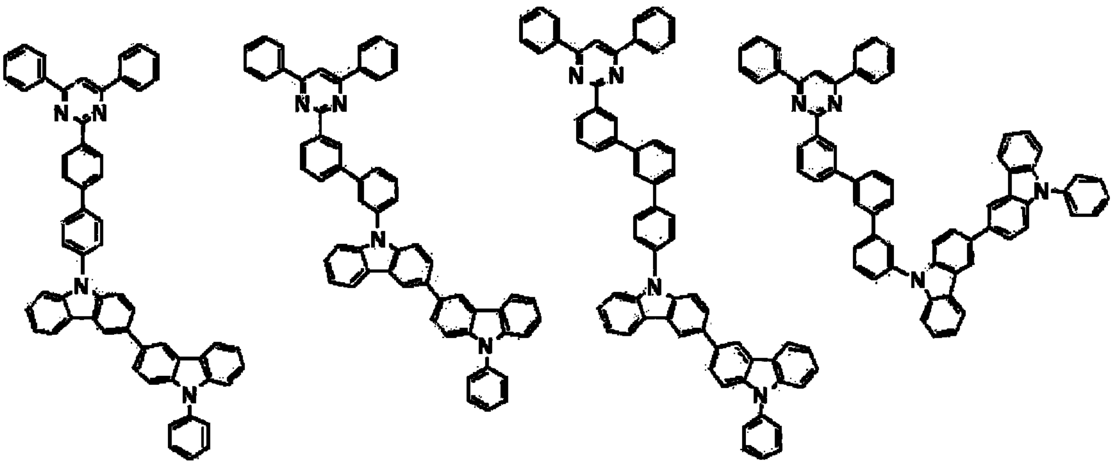

[Formula 12]

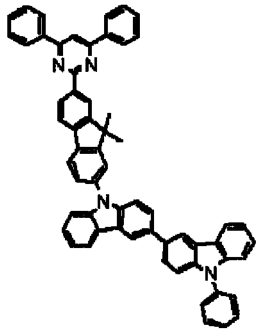

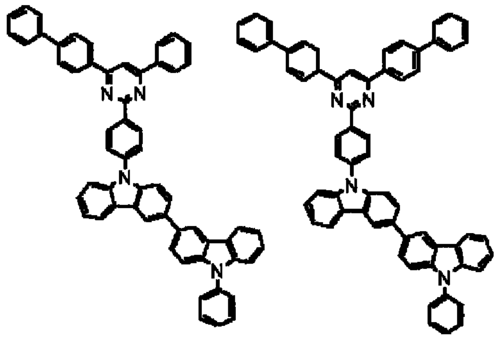

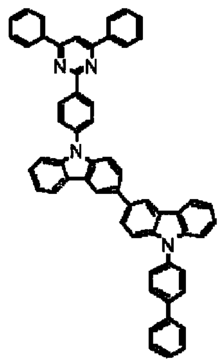

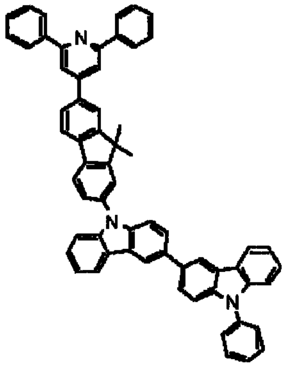

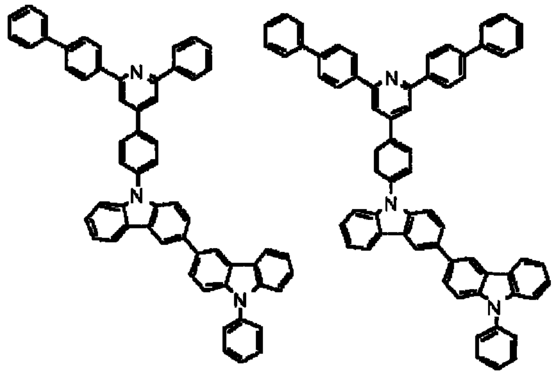

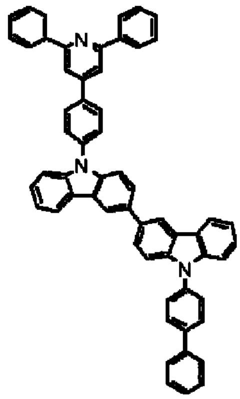

[Formula 13]

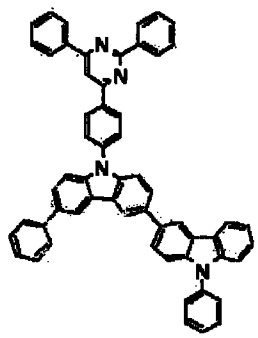

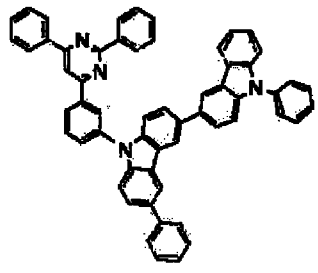

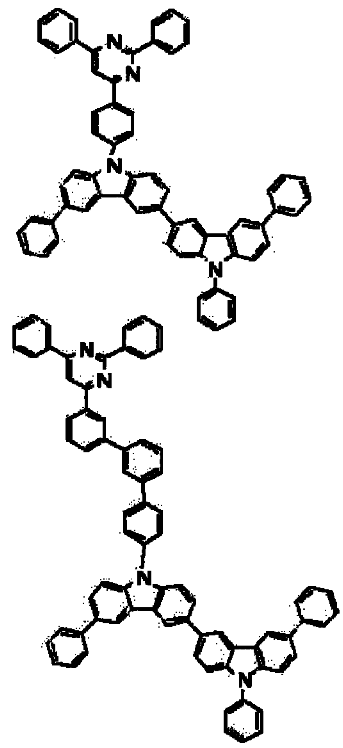

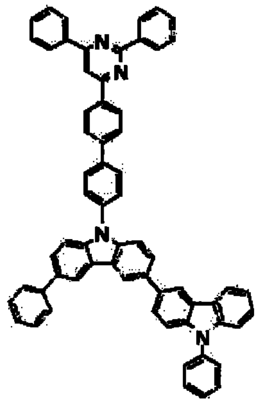

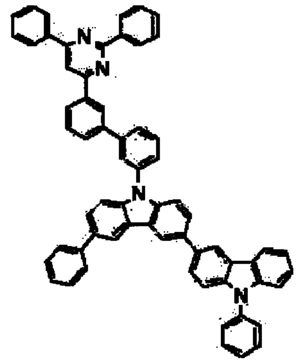

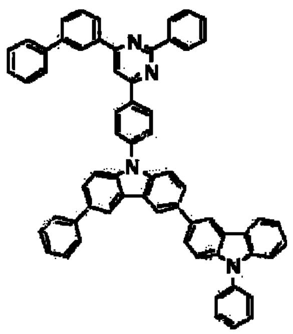

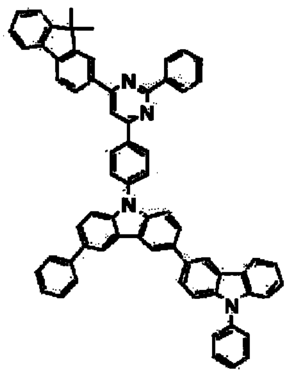

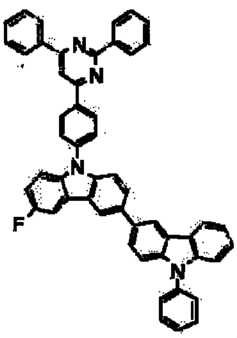

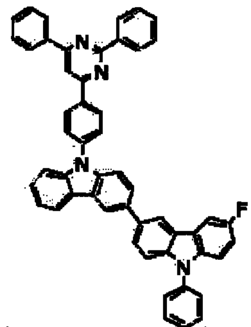

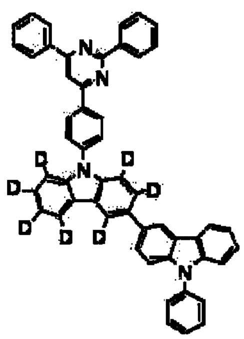

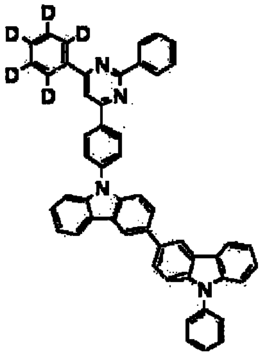

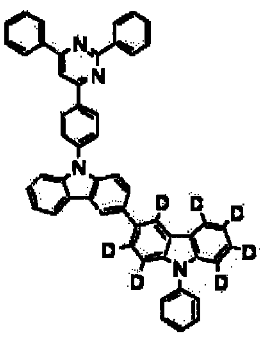

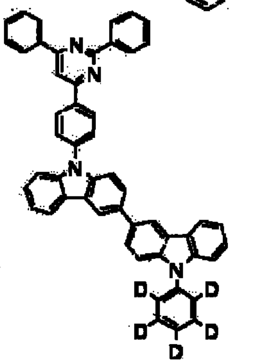

[Formula 14]

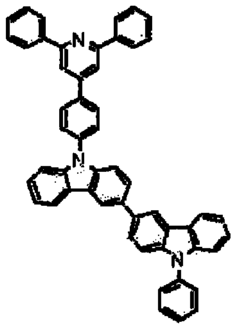

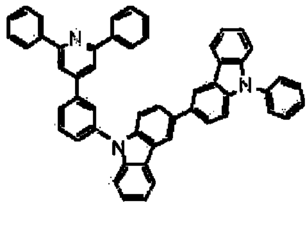

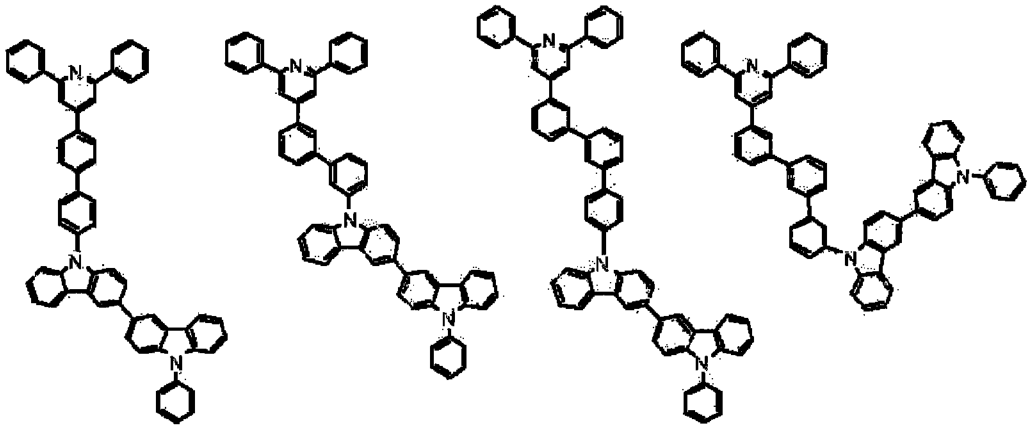

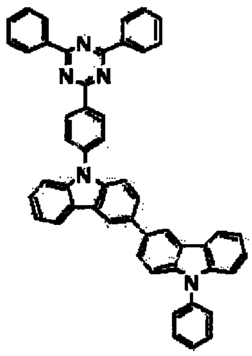

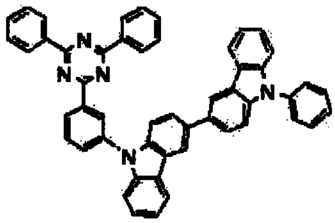

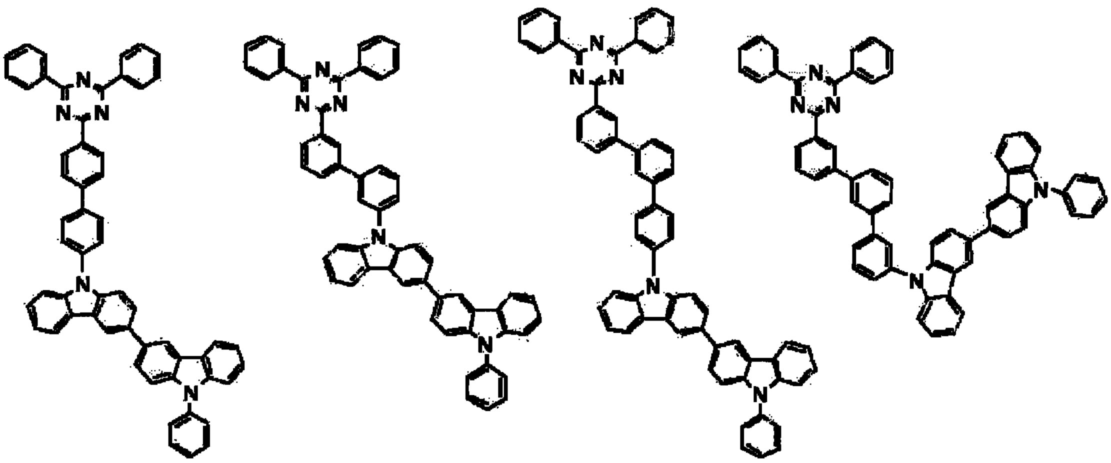

[Formula 15]

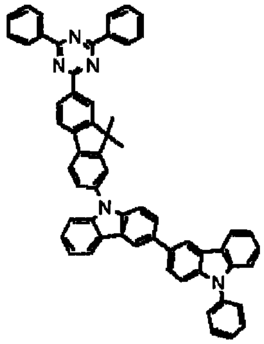
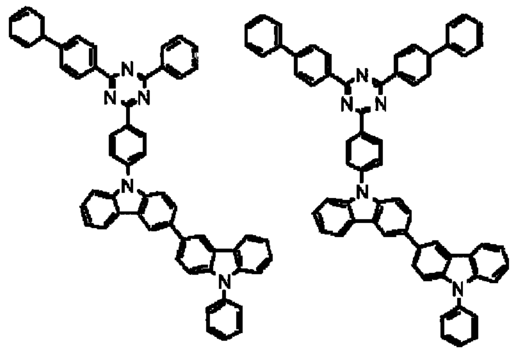
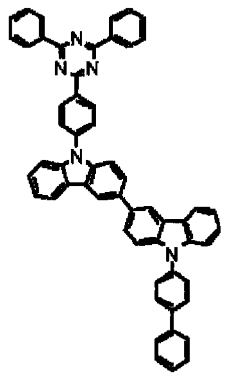
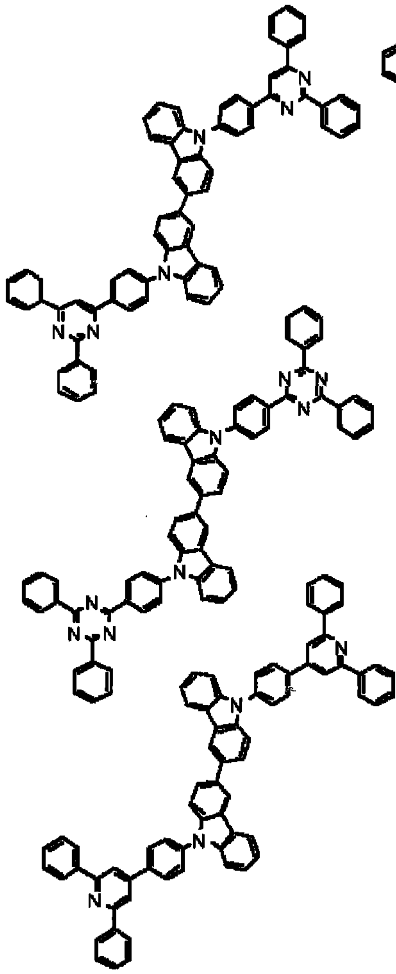
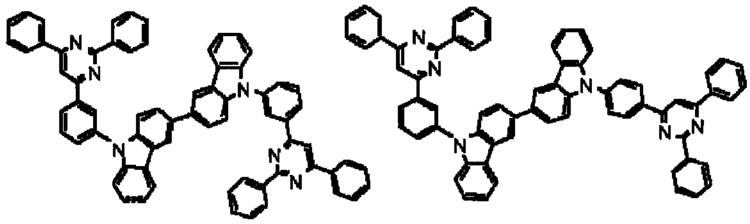
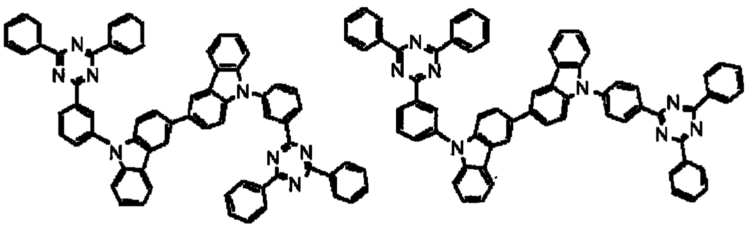
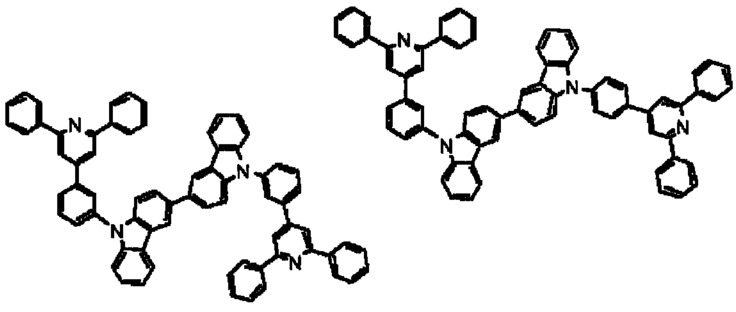

[Formula 16]

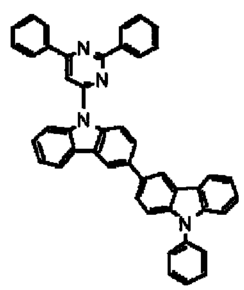
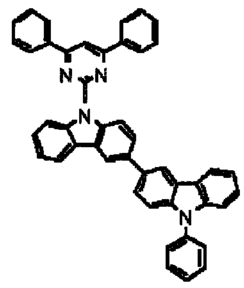
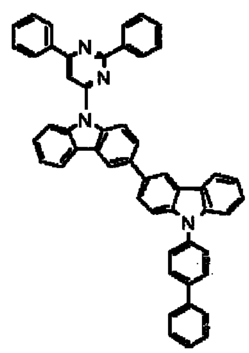
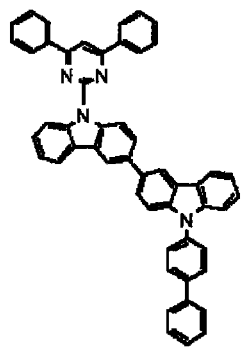

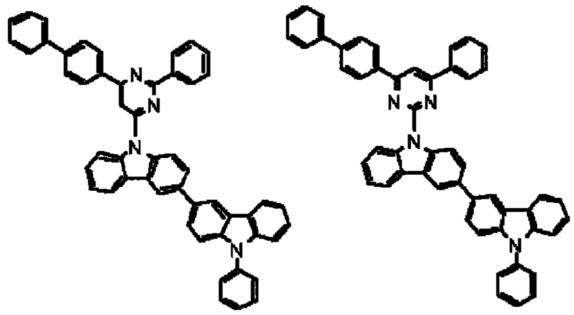
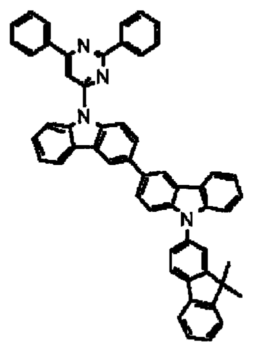
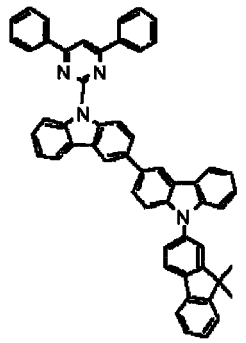

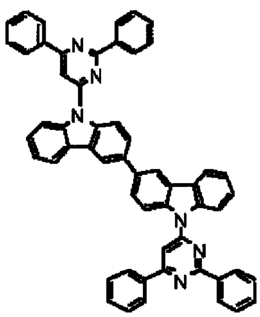
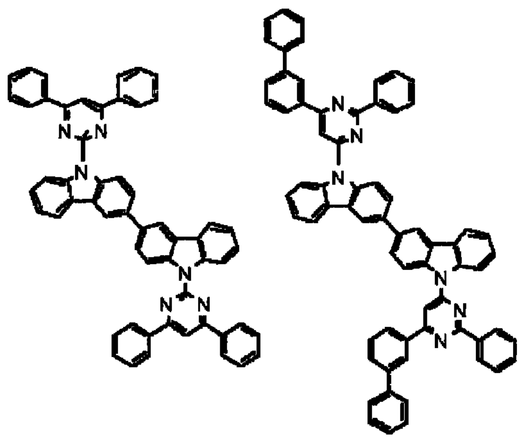
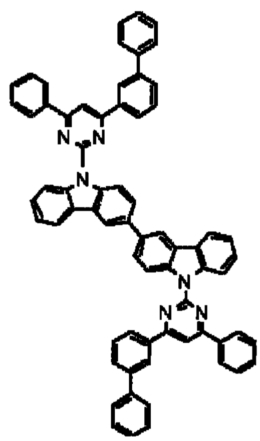

[Formula 17]

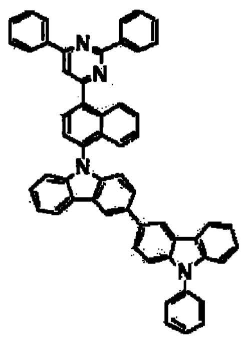 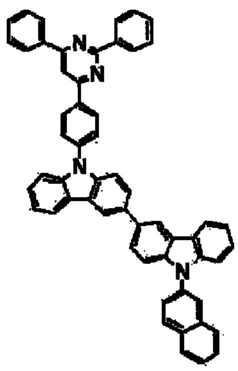 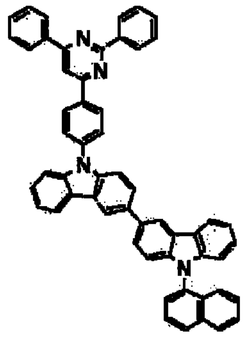 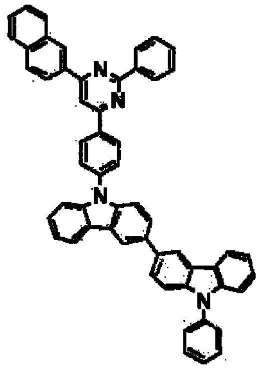

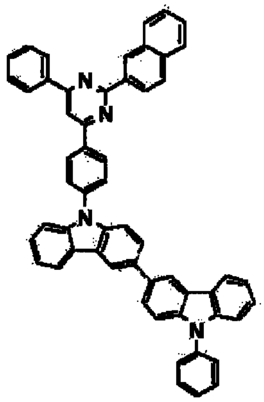 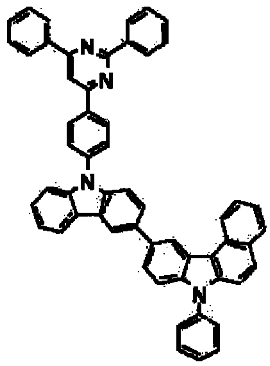 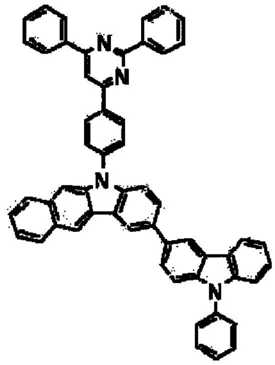

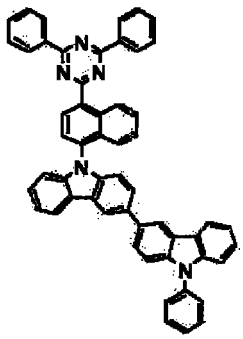 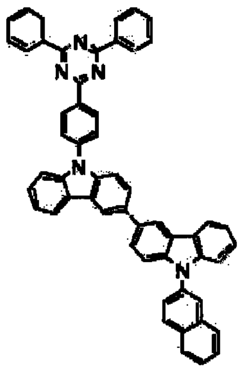 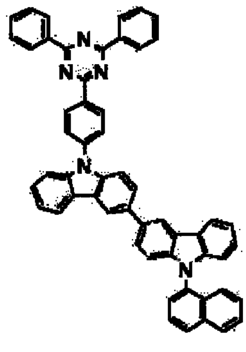 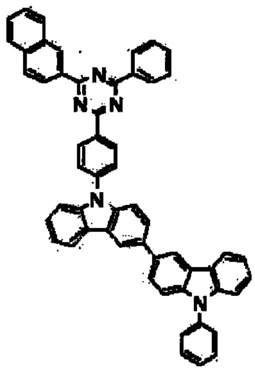

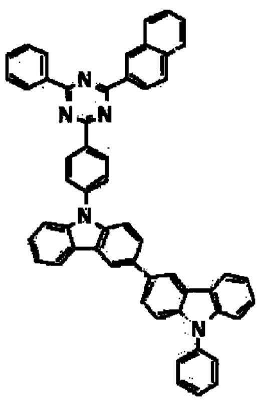 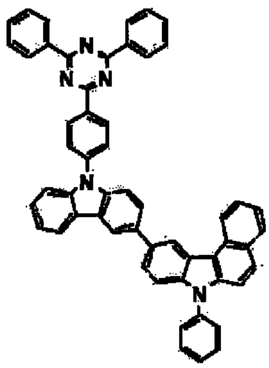 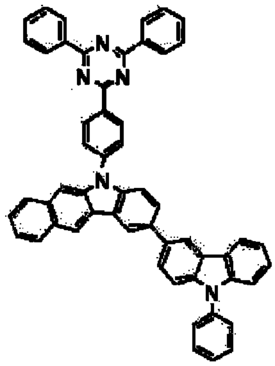

In the exemplary embodiment, among the compounds represented by the formula (1), the first host is preferably a compound represented by the following formula (1C).

[Formula 18]

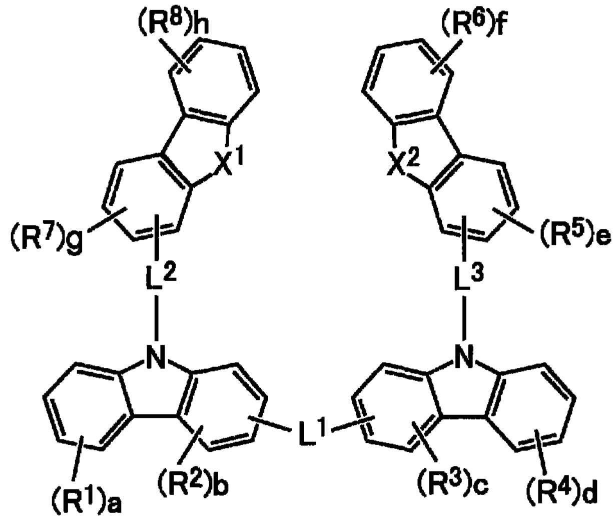

(1 C)

In the formula (1C), $X^1$ and $X^2$ each independently represent an oxygen atom or a sulfur atom, and are not simultaneously sulfur atoms. In other words, $X^1$ and $X^2$ are simultaneously oxygen atoms, or, alternatively, one of $X^1$ and $X^2$ is an oxygen atom while the other thereof is a sulfur atom.

In the formula (1C), $R^1$ to $R^8$ each independently represent one of the following:

an alkyl group having 1 to 20 carbon atoms;
a cycloalkyl group having 3 to 20 ring carbon atoms;
an alkoxy group having 1 to 20 carbon atoms;
a cycloalkoxy group having 3 to 20 ring carbon atoms;
an aryl group having 6 to 18 ring carbon atoms;
an aryloxy group having 6 to 18 ring carbon atoms;
a heteroaryl group having 5 to 18 atoms forming a ring (hereinafter referred to as ring atoms);
an amino group;
a silyl group;
a fluoro group; and
a cyano group.

$R^1$ to $R^8$ in the formula (1C) may be further substituted with these substituents. $R^1$ to $R^8$ in the formula (1C) are hereinafter collectively referred to as "substituents $R_{1C}$" as needed. When a plurality of $R^1$ exist in the formula (1C), the plurality of $R^1$ may be mutually the same or different. The same applies to each of $R^2$ to $R^8$.

a, d, f and h in the formula (1C) each independently represent an integer of 0 to 4. b, c, d and g in the formula (1 C) each independently represent an integer of 0 to 3. The sum of a to h in the formula (1C) is 6 or less.

$L^1$ in the formula (1C) represents one of the following:

a single bond;
a divalent bonding group containing N;
a divalent bonding group containing O;
a divalent bonding group containing Si;
a divalent bonding group containing P;
a divalent bonding group containing S;
an alkylene group having 1 to 20 carbon atoms;
a cycloalkylene group having 3 to 20 ring carbon atoms;
an arylene group having 6 to 18 ring carbon atoms;

a heteroarylene group having 5 to 18 ring atoms;
a divalent amino group; and
a divalent silyl group.

In the formula (1 C), $L^2$ and $L^3$ each independently represent one of the following:

a single bond;
an alkylene group having 1 to 20 carbon atoms;
a cycloalkylene group having 3 to 20 ring carbon atoms;
an arylene group having 6 to 18 ring carbon atoms; and
a heteroarylene group having 5 to 18 ring atoms.

$L^1$, $L^2$ and $L^3$ in the formula (1C) may be substituted with any one of the above substituents $R_{1C}$.
In the formula (1C), when $L^1$ is an arylene group having 6 to 18 ring carbon atoms or a heteroarylene group having 5 to 18 ring atoms, a and b each independently represent an integer of 1 to 4.
When a dibenzofuranyl group or a dibenzothiophenyl group is bonded at N-position (9-position) of the carbazole skeleton directly or via a bonding group as in the formula (1C), the LUMO level of dibenzofuran or dibenzothiophene becomes deeper, so that it becomes easier to inject electrons into the emitting layer or the like of the organic EL device according to the exemplary embodiment. As a result, carrier balance can be easily adjusted to favorably provide the effects of the invention.
Examples of the alkyl group as $R^1$ to $R^8$ in the formula (1C) are a methyl group, ethyl group, propyl group, isopropyl group, n-butyl group, s-butyl group, isobutyl group, t-butyl group, n-pentyl group, n-hexyl group, n-heptyl group, n-octyl group, n-nonyl group, n-decyl group, n-undecyl group, n-dodecyl group, n-tridecyl group, n-tetradecyl group, n-pentadecyl group, n-hexadecyl group, n-heptadecyl group, n-octadecyl group, neo-pentyl group, 1-methylpentyl group, 2-methylpentyl group, 1-pentylhexyl group, 1-butylpentyl group, 1-heptyloctyl group and 3-methylpentyl group.
Examples of the cycloalkyl group as $R^1$ to $R^8$ in the formula (1C) are a cyclopropyl group, cyclobutyl group, cyclopentyl group, cycloheptyl group, norbornyl group and adamantyl group.
Examples of the alkoxy group as $R^1$ to $R^8$ in the formula (1C) are a methoxy group, ethoxy group, propoxy group, butoxy group, pentyloxy group and hexyloxy group, among which ones having 3 or more carbon atoms may have a liner, cyclic or branched structure.
Examples of the cycloalkoxy group as $R^1$ to $R^8$ in the formula (1C) are a cyclopentoxy group and a cyclohexyloxy group.
Examples of the aryl group as $R^1$ to $R^8$ in the formula (1C) are a phenyl group, tolyl group, xylyl group, mesityl group, o-biphenyl group, m-biphenyl group, p-biphenyl group, o-terphenyl group, m-terphenyl group, p-terphenyl, naphthyl group and phenanthryl group. Among the above, a phenyl group and a mesityl group are preferable.
Examples of the aryloxy group as $R^1$ to $R^8$ in the formula (1C) are a phenoxy group and biphenyloxy group.
Examples of the heteroaryl group as $R^1$ to $R^8$ in the formula (1C) are a carbazolyl group, dibenzofuranyl group, dibenzothiophenyl group, pyrrolyl group, furyl group, thienyl group, silolyl group, pyridyl group, quinolyl group, isoquinolyl group, benzofuryl group, imidazolyl group, pyrimidyl group, selenophenyl group, oxadiazolyl group and triazolyl group.
The amino group and the silyl group as $R^1$ to $R^8$ in the formula (1C) may be substituted with the substituents described above. The silyl group is preferably a trimethylsilyl group.
a, d, f and h in the formula (1C) preferably each independently represent an integer of 0 to 3, more preferably an integer of 0 to 2.
b, c, d and g in the formula (1C) preferably each independently represent an integer of 0 to 2, more preferably an integer of 0 to 1.
In consideration of sublimability and thermal decomposition frequently caused by an excessive molecular weight during vapor deposition, the sum of a to h in the formula (1C) is preferably 4 or less.
The divalent bonding group containing N, the divalent bonding group containing O, the divalent bonding group containing Si, the divalent bonding group containing P and the divalent bonding group containing S as $L^1$ in the formula (1C) are exemplified by bonding groups represented by the following formulae (1D).

[Formula 19]

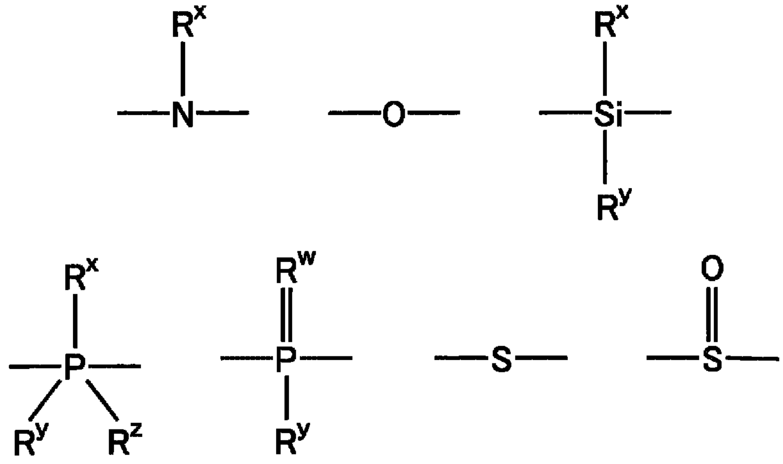

(1 D)

In the groups represented by the formulae (1D), $R^x$, $R^y$ and $R^z$ each independently represent a hydrogen atom or a group selected from the above substituents $R_{1C}$. $R^w$ is an oxygen atom.
Among the groups represented by the formulae (1D), "-S-" group (sulfide group), phosphoxide group and ether group are preferable.

The alkylene group having 1 to 20 carbon atoms, the cycloalkylene group having 3 to 20 ring carbon atoms, the arylene group having 6 to 18 ring carbon atoms, the heteroarylene group having 5 to 18 ring atoms, the divalent amino group, or the divalent silyl group as $L^1$, $L^2$ and $L^3$ in the formula (1 C) may be provided by removing one hydrogen atom in one of the substituents described above in relation to $R^1$ to $R^8$ in the formula (1C).
In the exemplary embodiment, the arylene group includes a 9,9-fluorenylidene group.
Examples of the arylene group as $L^1$, $L^2$ and $L^3$ in the formula (1C) are a 1,4-phenylene group, 1,2-phenylene group, 1,3-phenylene group, 1,4-naphthylene group, 2,6-naphthylene group, 1,5-naphthylene group, 9,10-anthranylene group, 9,10-phenanthrenylene group, 3,6-phenanthrenylene group, 1,6-pyrenylene group, 2,7-pyrenylene group, 6,12-chrysenylene group, 4,4'-biphenylene group, 3,3'-biphenylene group, 2,2'-biphenylene group and 2,7-fluorenylene group. Among the above, a p-phenylene group (1,4-phenylene group), an m-phenylene group (1,3-phenylene group) and a biphenylene group are preferable.
Examples of the heteroarylene group as $L^1$, $L^2$ and $L^3$ in the formula (1C) are a 2,5-thiophenylene group, 2,5-silolylene group and 2,5-oxadiazolylene group.
Examples of the amino group as $L^1$, $L^2$ and $L^3$ in the formula (1C) are an amino group, alkylamino group, arylamino group, aralkylamino group, acylamino group, alkoxycarbonylamino group, aryloxycarbonylamino group and sulfonylamino group. Among the above, a biphenylamino group is preferable.
Each of the bonding groups represented by $L^1$, $L^2$ and $L^3$ in the formula (1C) may have a substituent. Examples of such a substituent are the same as those of the substituents $R_{1C}$ in the formula (1C).

In the exemplary embodiment, among the compounds represented by the formula (1C), the first host is preferably a compound represented by the following formula (2E).

[Formula 20]

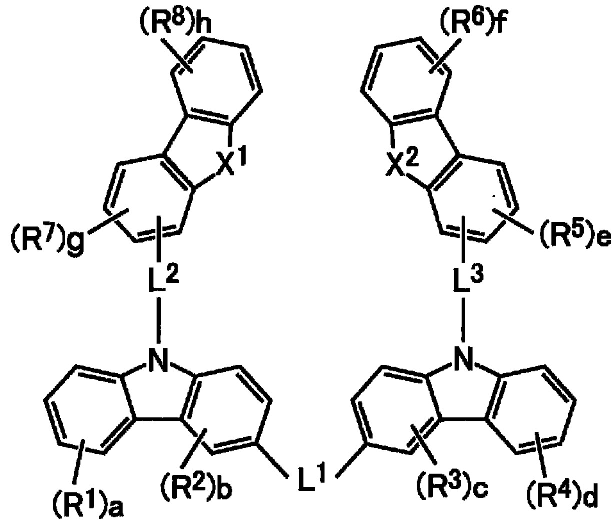

(2E)

Advantages of bonding two carbazolyl groups to each other at 3-positions thereof directly or via a bonding group as in the compound represented by the formula (2) or (2E) are as follows.

(1) Such an arrangement is highly convenient in synthesis.
(2) Although the 3-position and the 6-position of carbazole are positions with less chemical stability, by introducing a substituent other than a hydrogen atom at one of the 3-position and the 6-position, the chemical stability may be enhanced. In view of the above, an arrangement in which a substituent is introduced also at the 6-position is further preferable.
(3) When carbazoles are bonded to each other at 3-positions thereof via a single bond, nitrogen atoms on the two carbazoles are mutually conjugated, so that HOMO level becomes shallower. As a result, hole-injecting capability and hole-transporting capability are enhanced to facilitate carrier balance adjustment.

In the formula (2E), $X^1$, $X^2$, $R^1$ to $R^8$, a to h, and $L^1$ to $L^3$ are the same as those in the formula (1C).
In the exemplary embodiment, the first host is preferably a compound represented by the following formula (2F). This is because the compound represented by the formula (2F) exhibits a higher chemical stability.

[Formula 21]

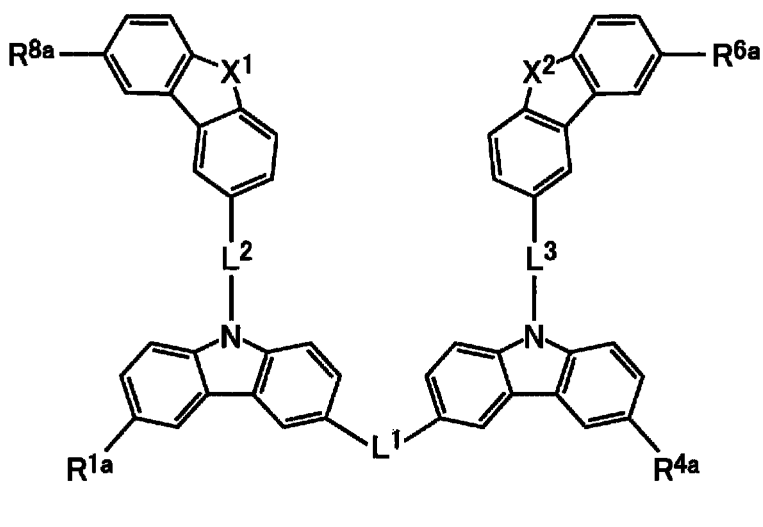

(2F)

$R^{1a}$, $R^{4a}$, $R^{6a}$ and $R^{8a}$ in the formula (2F) each independently represent a hydrogen atom or an aryl group having 6 to 18 ring carbon atoms (which is the same as the aryl group described in relation to the substituents $R_{1C}$). An arrangement in which each of $R^{1a}$, $R^{4a}$, $R^{6a}$ and $R^{8a}$ is a hydrogen atom corresponds to an arrangement in which each of a, d, h and h in the formula (1F) is 0. The aryl group may be further substituted with one of the substituents $R_{1C}$.

In the formula (2F), $X^1$, $X^2$ and $L^1$ to $L^3$ are the same as those in the formula (1C).

In the formula (2F), each of $L^2$ and $L^3$ is preferably a single bond and $L^1$ is also preferably a single bond. This is because sublimability and an excessive molecular weight may frequently cause thermal decomposition during vapor deposition. In terms of lowering voltage and of time elapsed until luminescence intensity is reduced by half, $L^1$ to $L^3$ in the formula (2F) are preferably arranged as follows:

"$L^1$ is a single bond while each of $L^2$ and $L^3$ is any other bonding group";
"each of $L^2$ and $L^3$ is a single bond while $L^1$ is any other bonding group"; or
"all of $L^1$, $L^2$ and $L^3$ are single bonds".

Each of $X^1$ and $X^2$ in the formulae (1C), (2E) and (2F) is preferably an oxygen atom in terms of external quantum efficiency and lifetime.

In the exemplary embodiment, in terms of lowing voltage and of time elapsed until luminescence intensity is reduced by half, the first host is preferably a compound represented by the following formula (2G) among the compounds represented by the above formula (2F).

[Formula 22]

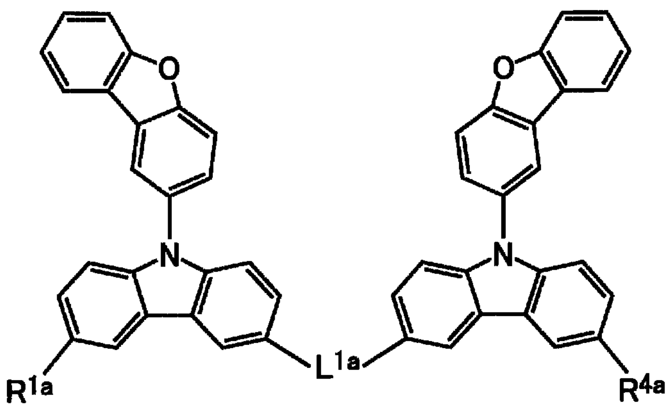

(2 G)

$R^{1a}$ and $R^{4a}$ in the formula (2G) each independently represent a hydrogen atom or a phenyl group that may be substituted with a methyl group.

$L^{1a}$ in the formula (2G) is a single bond or a phenylene group.

It should be noted that when both of $R^{1a}$ and $R^{4a}$ are hydrogen atoms, $L^{1a}$ is not a phenylene group. When $L^{1a}$ is a phenylene group while both of $R^{1a}$ and $R^{4a}$ are hydrogen atoms in the formula (2G), the carbazoles have the hydrogen atoms at 6-positions thereof and are not bonded to each other at 3-positions thereof via a single bond. Such a material should not be a particularly excellent material for forming the first host in terms of chemical stability and carrier balance adjustment.

In the exemplary embodiment, the first host is preferably a compound represented by the following formula (9).

[Formula 23]

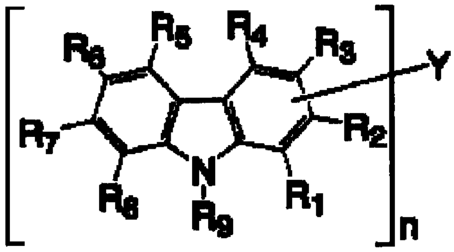

(9)

In the formula (9), each of $R_1$ to $R_8$ is selected from hydrogen, an alkyl group, a cycloalkyl group, an aralkyl group, an alkenyl group, a cycloalkenyl group, an alkynyl group, a hydroxyl group, a mercapto group, an alkoxy group, an alkylthio group, an arylether group, an arylthioether group, an aryl group, a heterocyclic group, halogen, haloalkane, haloalkene, haloalkyne, a cyano group, an aldehyde group, a carbonyl group, a carboxyl group, an ester group, a carbamoyl group, an amino group, a nitro group, a silyl group, a siloxanyl group and a ring structure between adjacent substituents.

At least one of $R_1$ to $R_4$ in the formula (9) is a bonding group Y. The bonding group Y in the formula (9) is one of or a combination of two or more of a single bond, alkyl chain, alkylene chain, cycloalkyl chain, aryl chain, amino chain, heterocyclic chain, silyl chain, ether chain and thioether chain.

$R_9$ in the formula (9) is selected from hydrogen, an alkyl group and an aryl group. n in the formula (9) is a natural number of 2 or more.

The alkyl group in the formula (9) is a saturated aliphatic hydrocarbon group, such as a methyl group, ethyl group, propyl group and butyl group, which may be substituted or unsubstituted.

The cycloalkyl group in the formula (9) is a saturated alicyclic hydrocarbon group, such as cyclopropyl, cyclohexyl, norbornyl and adamantyl, which may be substituted or unsubstituted.

The aralkyl group in the formula (9), which is exemplified by a benzyl group or a phenylethyl group, contains an aromatic hydrocarbon group and an aliphatic hydrocarbon. The aliphatic hydrocarbon and the aromatic hydrocarbon may be substituted or unsubstituted.

The alkenyl group in the formula (9) is an unsaturated aliphatic hydrocarbon group containing a double bond, such as a vinyl group, allyl group and butadienyl group, which may be substituted or unsubstituted.

The cycloalkenyl group in the formula (9) is an unsaturated alicyclic hydrocarbon group containing a double bond, such as a cyclopentenyl group, cyclopentadienyl group and cyclohexene group, which may be substituted or unsubstituted.

The alkynyl group in the formula (9) is an unsaturated aliphatic hydrocarbon group containing a triple bond, such as an acetylenyl group, which may be substituted or unsubstituted.

The alkoxy group in the formula (9), which is exemplified by a methoxy group, contains an aliphatic hydrocarbon group and an ether bond. The aliphatic hydrocarbon group may be substituted or unsubstituted.

The alkylthio group in the formula (9) is formed by substituting an oxygen atom of an ether bond in an alkoxy group with a sulfur atom. The arylether group, which is exemplified by a phenoxy group, contains an aromatic hydrocarbon group and an ether bond. The aromatic hydrocarbon group may be substituted or unsubstituted.

The arylthioether group in the formula (9) is formed by substituting an oxygen atom of an ether bond in an arylether group with a sulfur atom.

The aryl group in the formula (9) represents an aromatic hydrocarbon group, such as a phenyl group, naphthyl group, biphenyl group, phenanthryl group, terphenyl group and pyrenyl group, which may be substituted or unsubstituted.

The heterocyclic group in the formula (9) represents a cyclic structure group containing an atom other than carbon, such as a furyl group, thienyl group, oxazolyl group, pyridyl group, quinolyl group and carbazolyl group, which may be substituted or unsubstituted.

The halogen in the formula (9) is fluorine, chlorine, bromine or iodine.

The haloalkane in the formula (9) is provided by substituting a part or the entirety of the above alkyl group with the halogen, an example of which is a trifluoromethyl group. The haloalkene in the formula (9) is likewise provided by substituting a part or the entirety of the above alkenyl group with the above halogen. The haloalkyne in the formula (9) is likewise provided by substituting a part or the entirety of the above alkynyl with the halogen. The other part of each of the alkyl group, alkenyl group and alkynyl may be substituted or unsubstituted.

Each of the aldehyde group, carbonyl group, ester group, carbamoyl group and amino group in the formula (9) may be substituted with an aliphatic hydrocarbon, alicyclic hydrocarbon, aromatic hydrocarbon, heterocycle or the like. The

aliphatic hydrocarbon, alicyclic hydrocarbon, aromatic hydrocarbon and heterocycle may be substituted or unsubstituted. The silyl group in the formula (9) represents a silicon compound group such as a trimethylsilyl group, which may be substituted or unsubstituted.

The siloxanyl group in the formula (9), which is exemplified by a trimethylsiloxanyl group, contains a silicon compound group and an ether bond. The silicon compound group may be substituted or unsubstituted.

In the formula (9), an adjacent set of substituents may form a cyclic structure. The formed cyclic structure may be substituted or unsubstituted.

Among compounds having a carbazole skeleton, in particular, a compound having a carbazole skeleton represented by the following formula (9A) is preferably usable in the exemplary embodiment because a compound having a dicarbazolyl skeleton has a rigid molecular structure and is excellent in heat resistance.

[Formula 24]

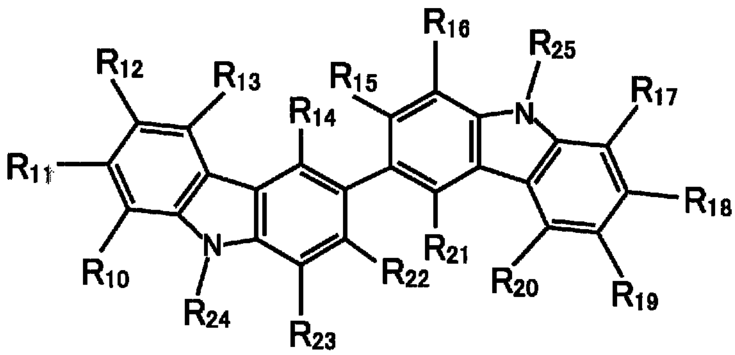

(9 A)

Each of $R_{10}$ to $R_{23}$ in the formula (9A) is selected from the same as those mentioned in relation to $R_1$ to $R_8$ in the formula (9).

Each of $R_{24}$ and $R_{25}$ in the formula (9A) is selected from hydrogen, an alkyl group and an aryl group. Dicarbazolyl skeletons may be mutually bonded via the substituents of $R_{24}$ and $R_{25}$.

Compounds having a carbazole skeleton represented by the formulae (9) and (9A) are exemplarily structured as follows.

[Formula 25]

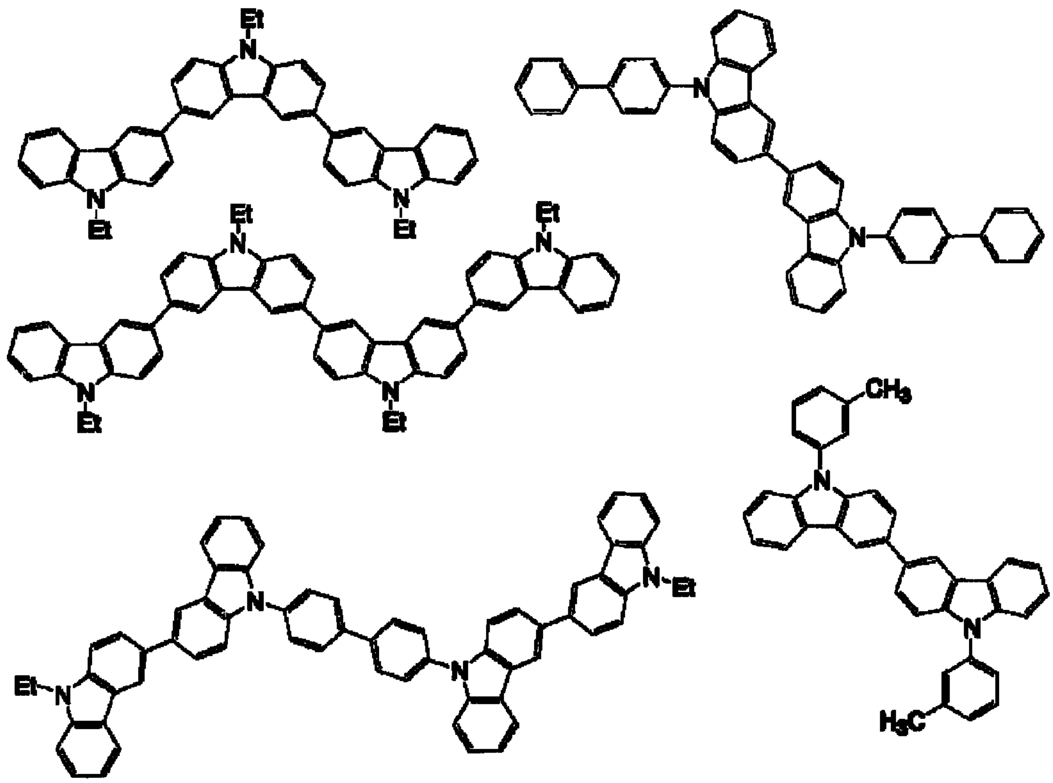

In the exemplary embodiment, the first host is also preferably a compound represented by the following formula (10).

[Formula 26]

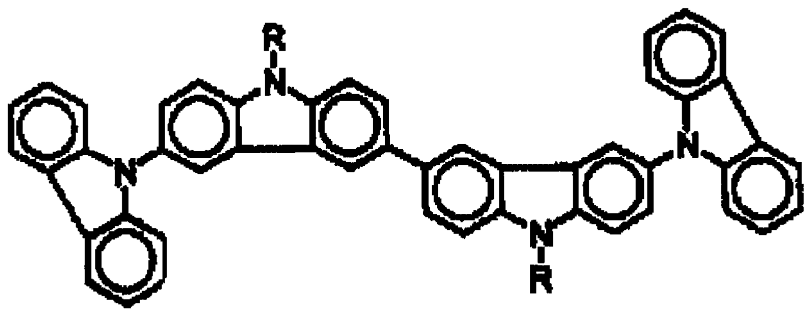

(10)

In the formula (10), R is hydrogen, an aliphatic alkyl group having 1 to 12 carbon atoms, a branched alkyl group having 1 to 12 carbon atoms, a cyclic alkyl group having 1 to 12 carbon atoms, or an aromatic group having 4 to 14 carbon atoms. The aromatic group may be substituted with one or more or two or more alkoxy or amine.

In the exemplary embodiment, the first host is preferably a compound represented by the following formula (11).

[Formula 27]

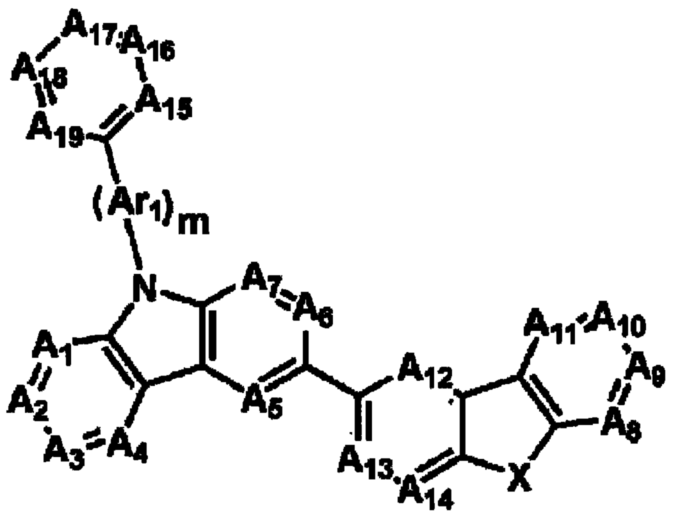

(1 1)

In the formula (11), each of $A_1$ to $A_7$ and $A_{12}$ to $A_{14}$ is $CR_1$.
In the formula (11), each of $A_8$ to $A_{11}$ and $A_{15}$ to $A_{19}$ is $CR_1$ or N.
In the formula (11), X is $-N(R_4)-$.
In the formula (11), $Ar_1$ is a substituted or unsubstituted arylene having 6 to 40 carbon atoms, or a substituted or unsubstituted heteroarylene having 3 to 40 carbon atoms. $A_{15}$ to $A_{19}$ are not simultaneously $CR_1$ when m is equal to 0.
In the formula (11), each of $R_1$ and $R_4$ represents any one of the following:

hydrogen;
deuterium;
halogen;
a substituted or unsubstituted alkyl group having 1 to 30 carbon atoms;
a substituted or unsubstituted aryl group having 6 to 30 carbon atoms; and a substituted or unsubstituted heteroaryl group having 3 to 30 carbon atoms.

An adjacent set of substituents in the carbazole skeleton may be bonded to each other to form a ring structure.
When the alkyl group, aryl group or heteroaryl group as $R_1$ to $R_4$ is substituted, examples of the substituent are the same as those mentioned in relation to R in the formula (1).
Compounds having the carbazole skeleton represented by the formula (11) are exemplarily structured as follows.

[Formula 28]

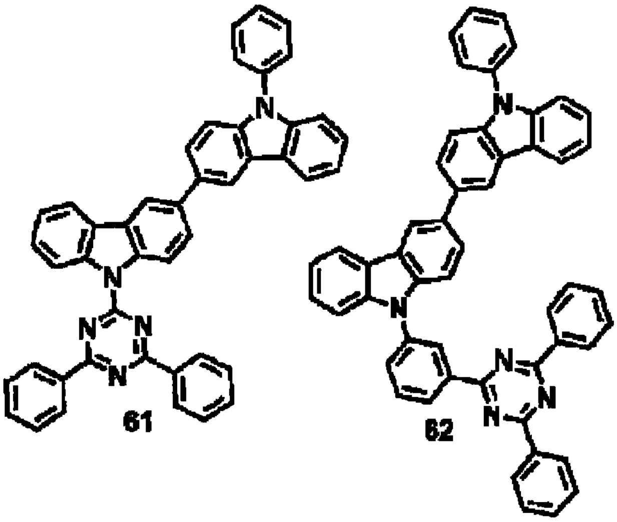

61

62

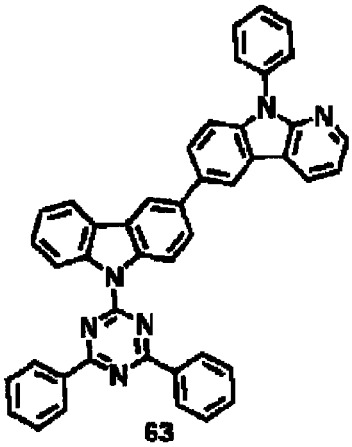

63

[Formula 29]

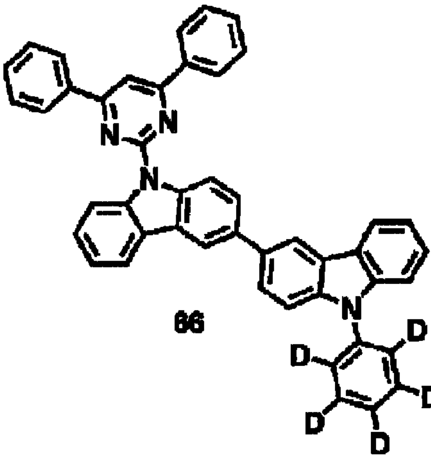

66

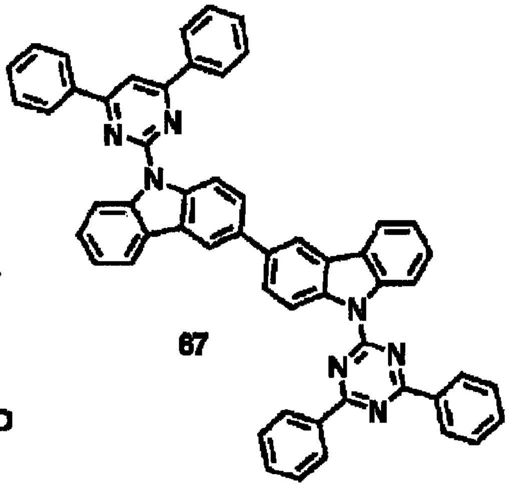

67

In the exemplary embodiment, the first host is preferably a compound represented by the following formula (12).

[Formula 30]

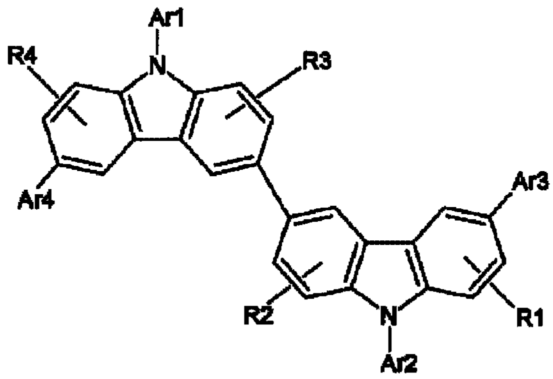

(12)

In the formula (12), R1 to R4 represent the same as R in the formula (1).
In the formula (12), Ar1 and Ar2 represent the aryl group or the heteroaryl group described in relation to R in the formula (1).
In the formula (12), Ar3 and Ar4 represent the aryl group described in relation to R in the formula (1).
Among the compounds represented by the formula (12), a compound represented by the following formula (12A) is preferable.

[Formula 31]

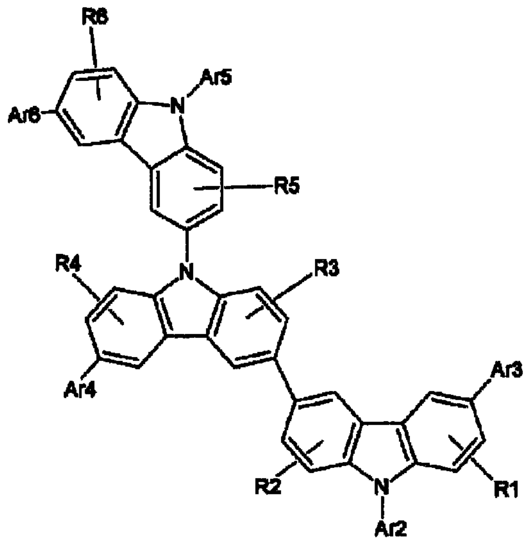

(12A)

In the formula (12A), R1 to R6 represent the same as R in the formula (1).
In the formula (12A), Ar5 represents the aryl group described in relation to R in the formula (1).
In the formula (12A), Ar6 represents a hydrogen atom or the aryl group described in relation to R in the formula (1).
Examples of the compounds represented by the formulae (12) and (12A) are shown below.

[Formula 32]

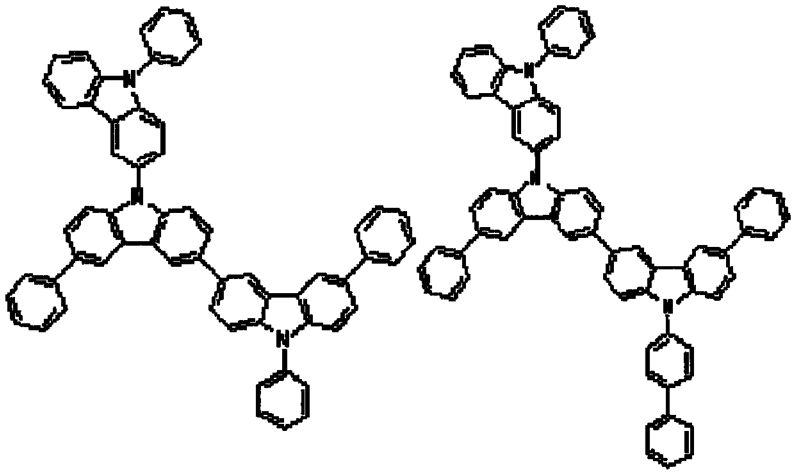

[Formula 33]

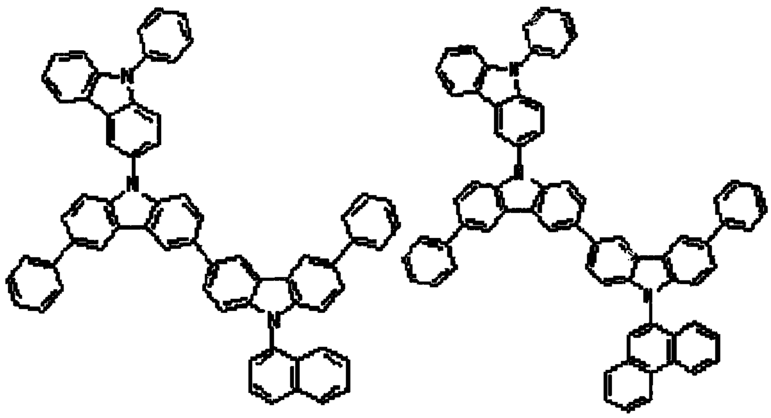

[Formula 34]

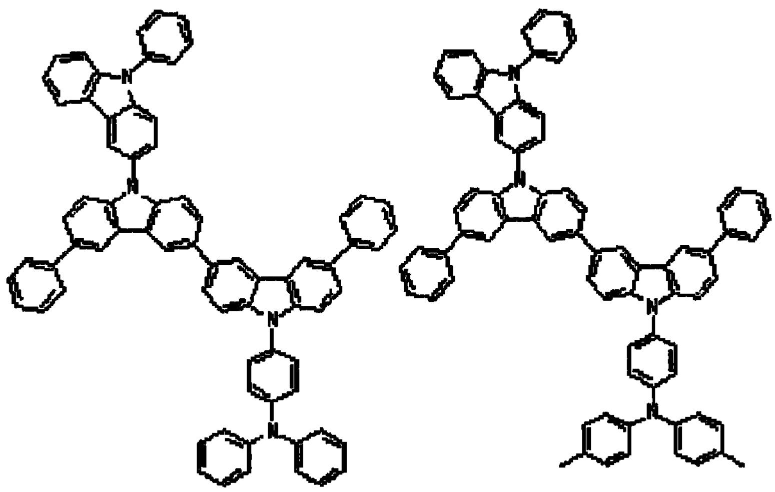

[Formula 35]

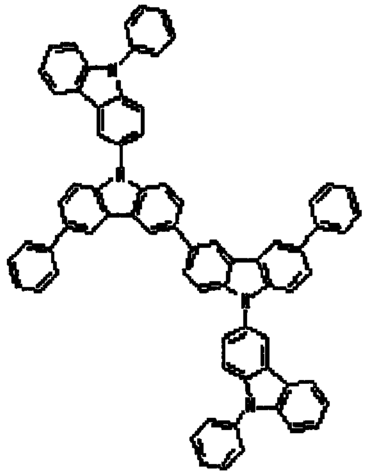

[Formula 36]

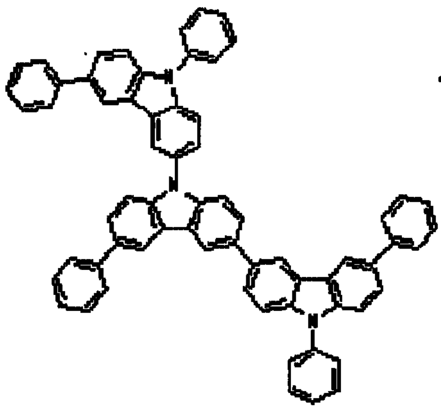

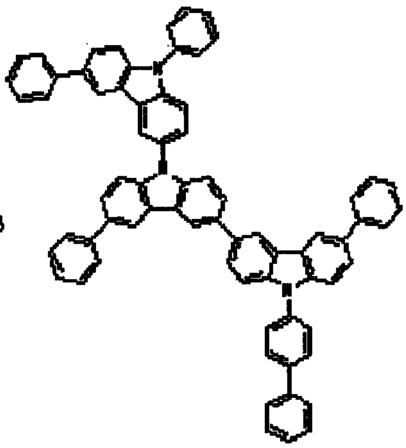

[Formula 37]

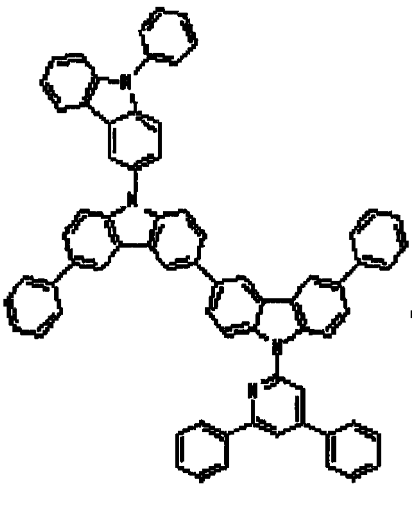

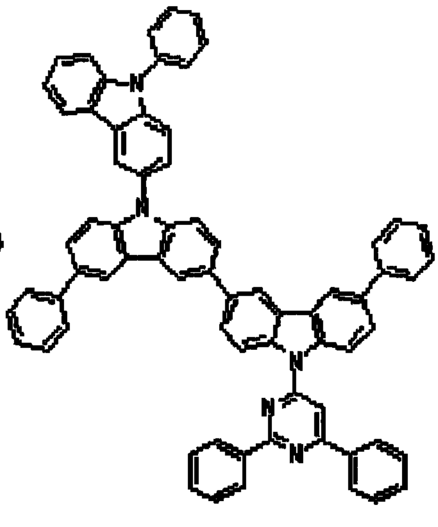

[Formula 38]

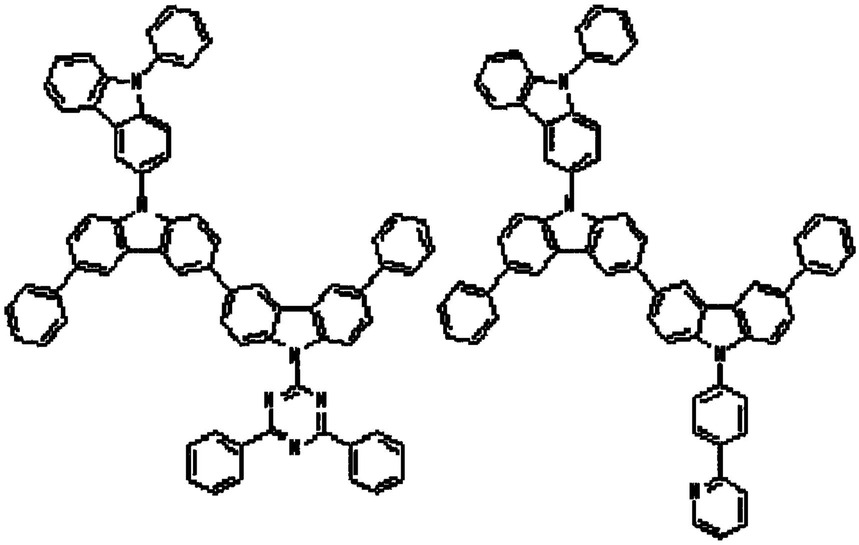

[Formula 39]

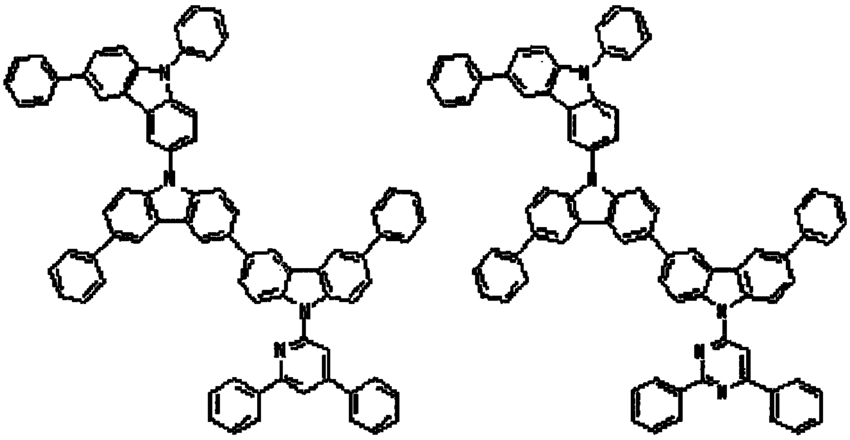

[Formula 40]

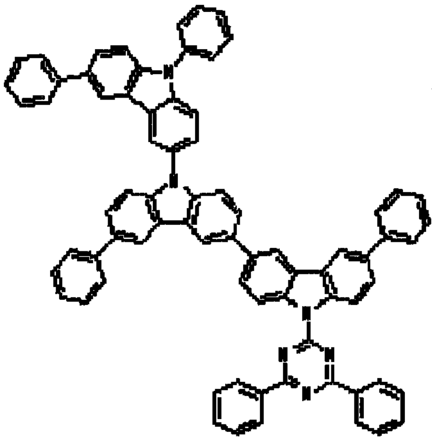

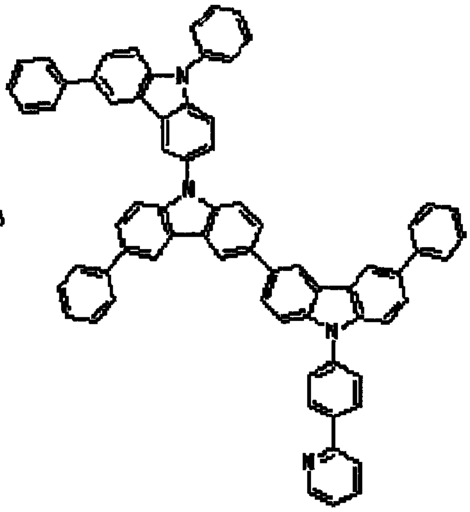

[Formula 41]

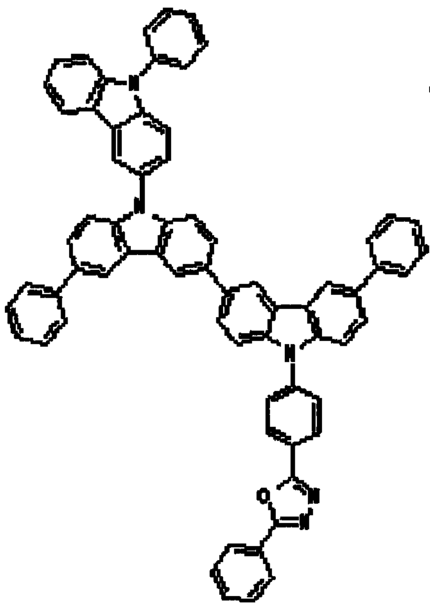

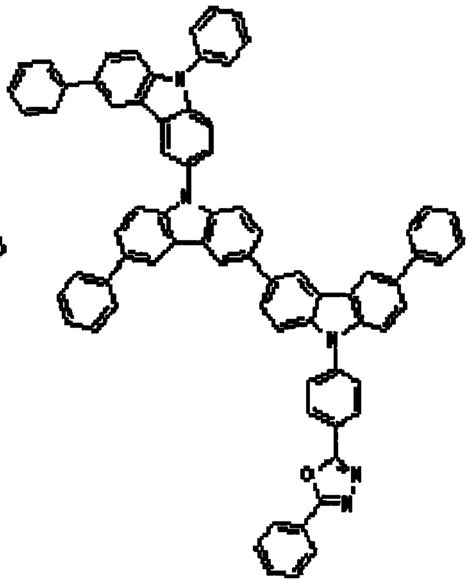

[Formula 42]

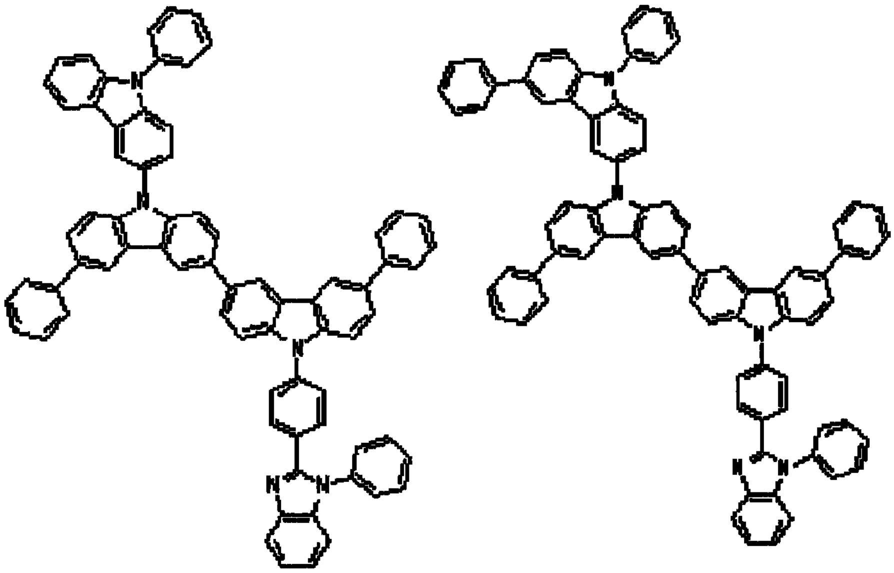

In the exemplary embodiment, the first host is preferably a compound represented by the following formula (13).

[Formula 43]

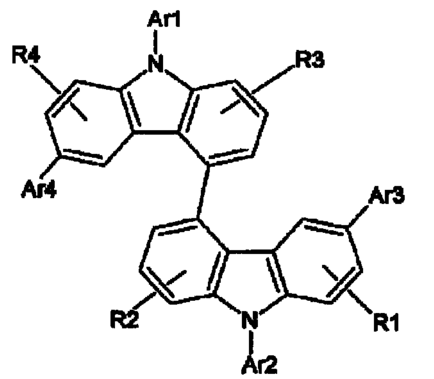

(13)

In the formula (13), R1 to R4 represent the same as R in the formula (1).
In the formula (13), Ar1 and Ar2 represent the aryl group or the heteroaryl group described in relation to R in the formula (1).
In the formula (13), Ar3 and Ar4 represent a hydrogen atom or the aryl group described in relation to R in the formula (1).

Among the compounds represented by the formula (13), a compound represented by the following formula (13A) is preferable.

[Formula 44]

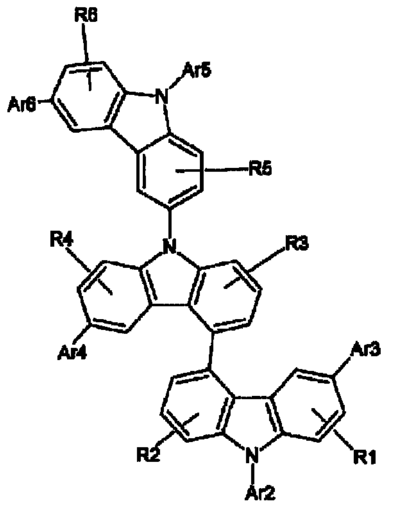

(13A)

In the formula (13A), R1 to R6 represent the same as R in the formula (1).
In the formula (13A), Ar5 represents the aryl group described in relation to R in the formula (1).
In the formula (13A), Ar6 represents a hydrogen atom or the aryl group described in relation to R in the formula (1).
Examples of the compounds represented by the formulae (13) and (13A) are shown below.

[Formula 45]

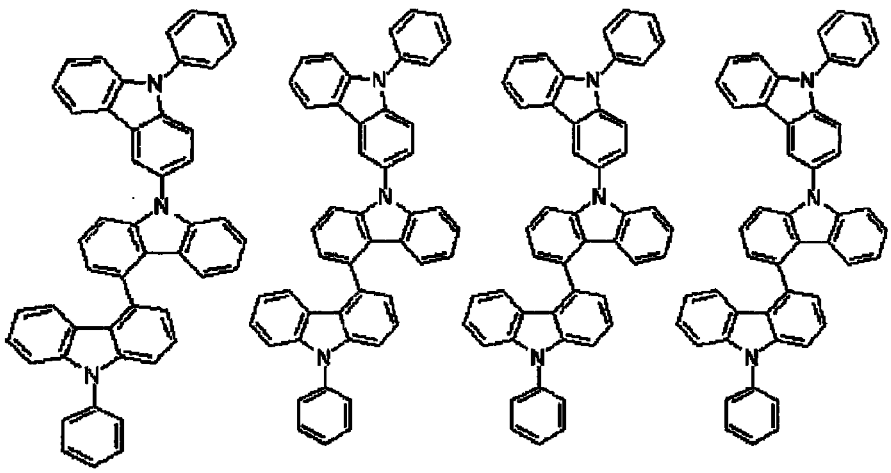

[Formula 46]

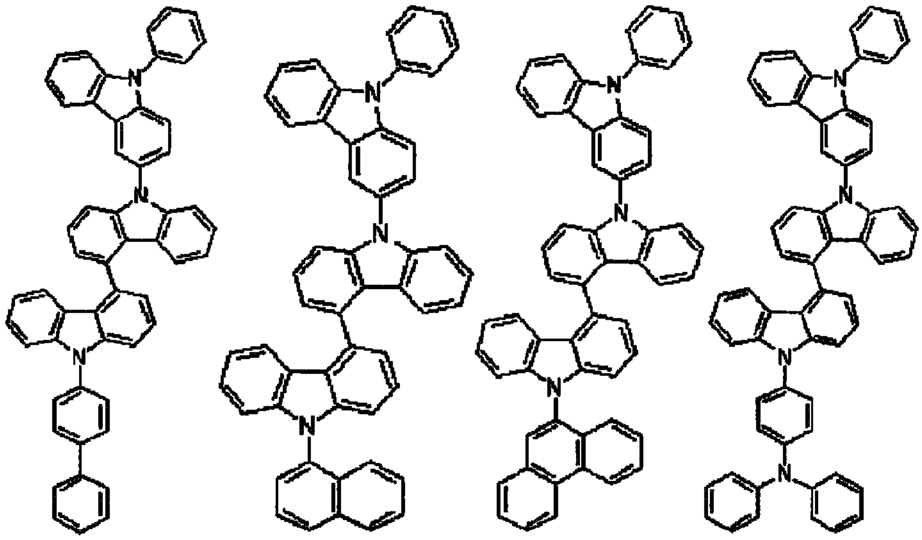

[Formula 47]

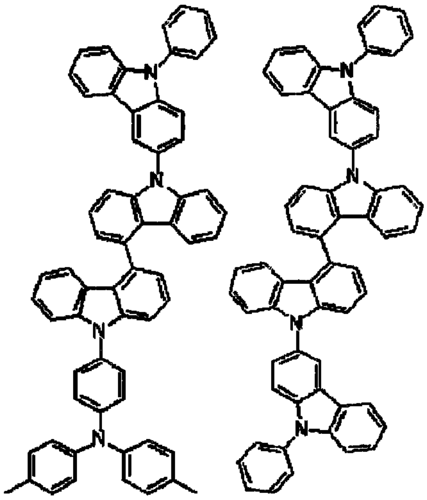

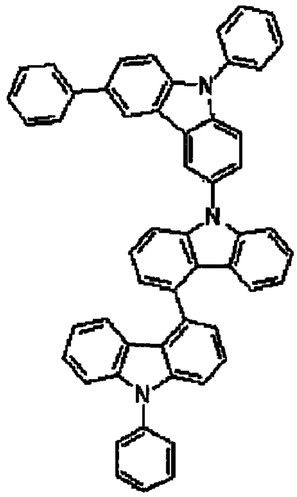

[Formula 48]

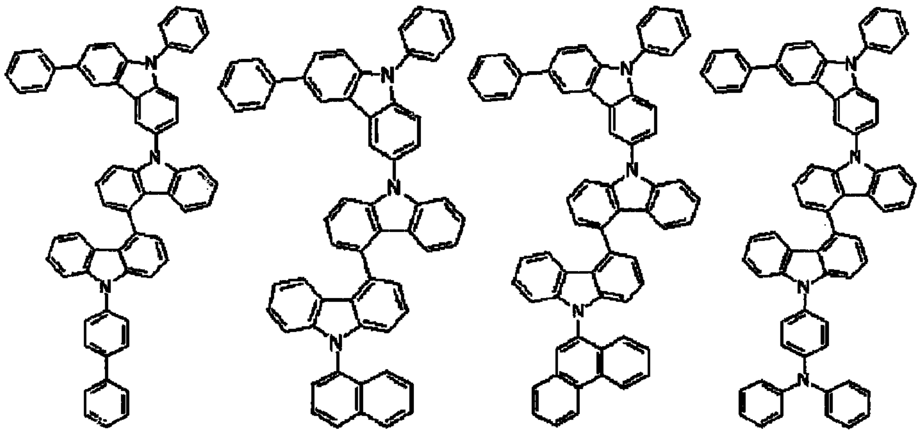

[Formula 49]

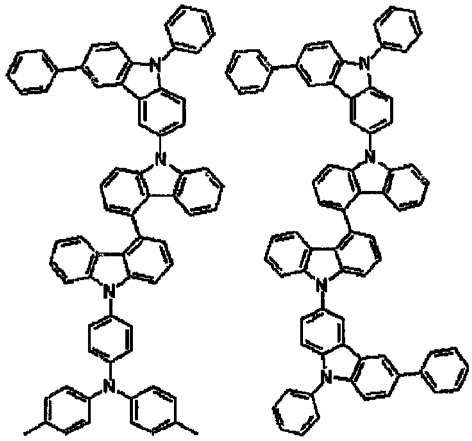
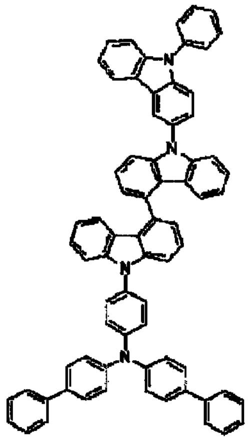

[Formula 50]

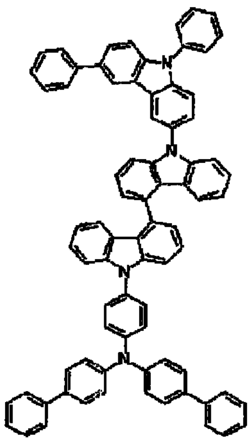
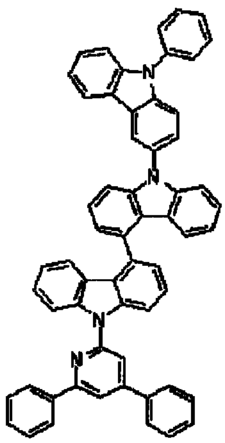

[Formula 51]

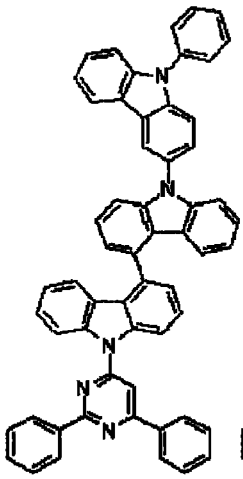
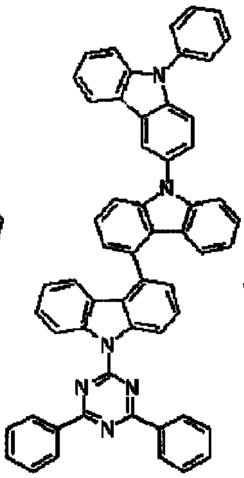
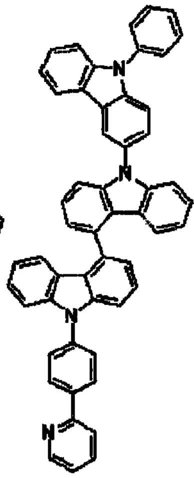
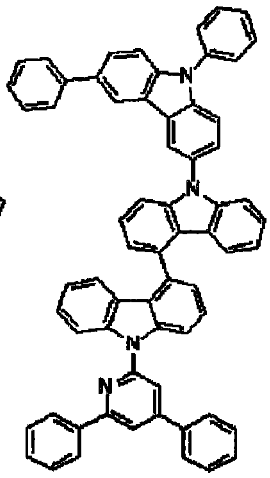

[Formula 52]

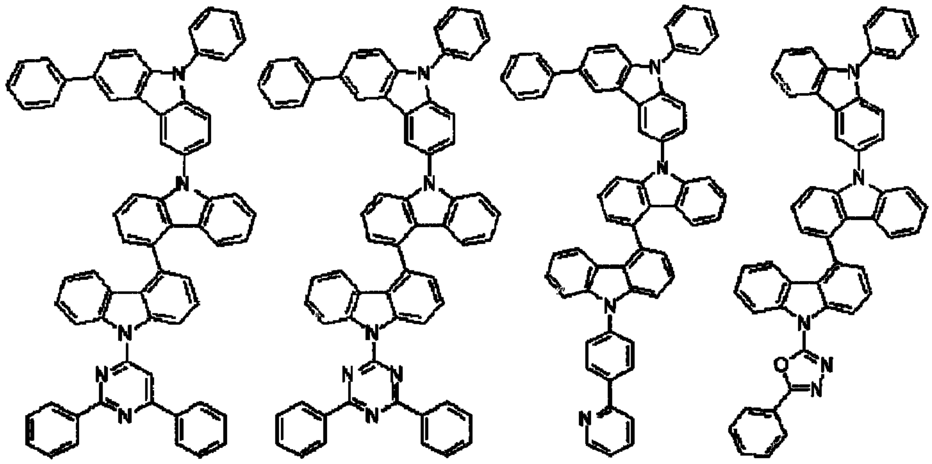

[Formula 53]

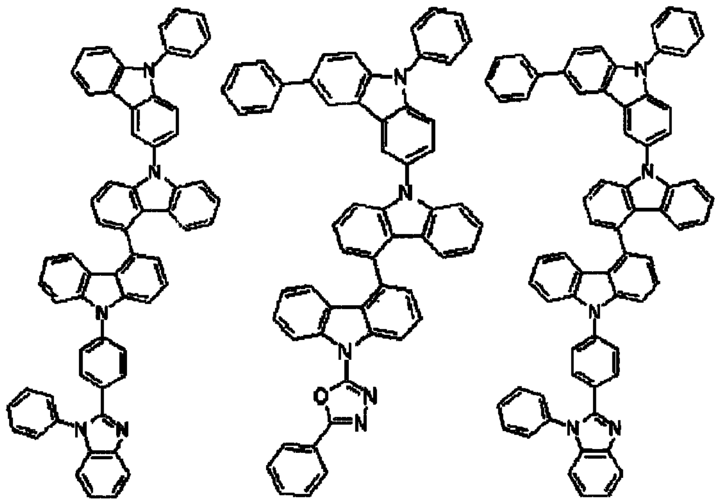

[Formula 54]

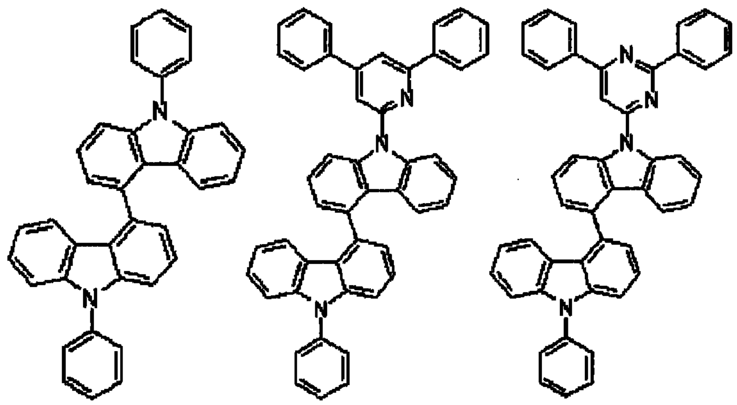

[Formula 55]

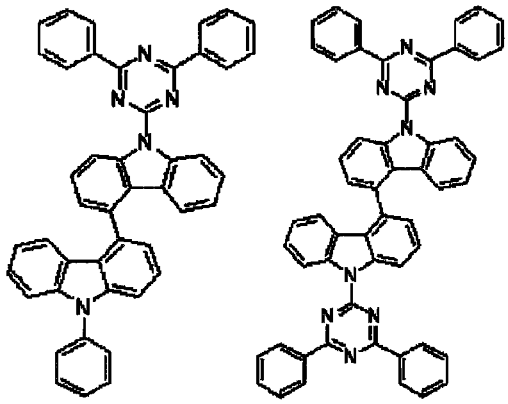

## Phosphorescent Dopant

In the exemplary embodiment, the phosphorescent dopant contains a metal complex. The metal complex preferably has a metal atom selected from Ir (iridium), Pt (platinum), Os (osmium), Au (gold), Cu (copper), Re (rhenium) and Ru (ruthenium), and a ligand. Particularly, the ligand preferably has an ortho-metal bond.

The phosphorescent material is preferably a compound containing a metal atom selected from Ir, Os and Pt because such a compound, which exhibits high phosphorescence quantum yield, can further enhance external quantum efficiency of an organic EL device. The phosphorescent material is more preferably a metal complex such as an iridium complex, osmium complex or platinum complex, among which an iridium complex and platinum complex are more preferable and ortho metalation of an iridium complex is the most preferable.

Examples of such a preferable metal complex are shown below.

[Formula 56]

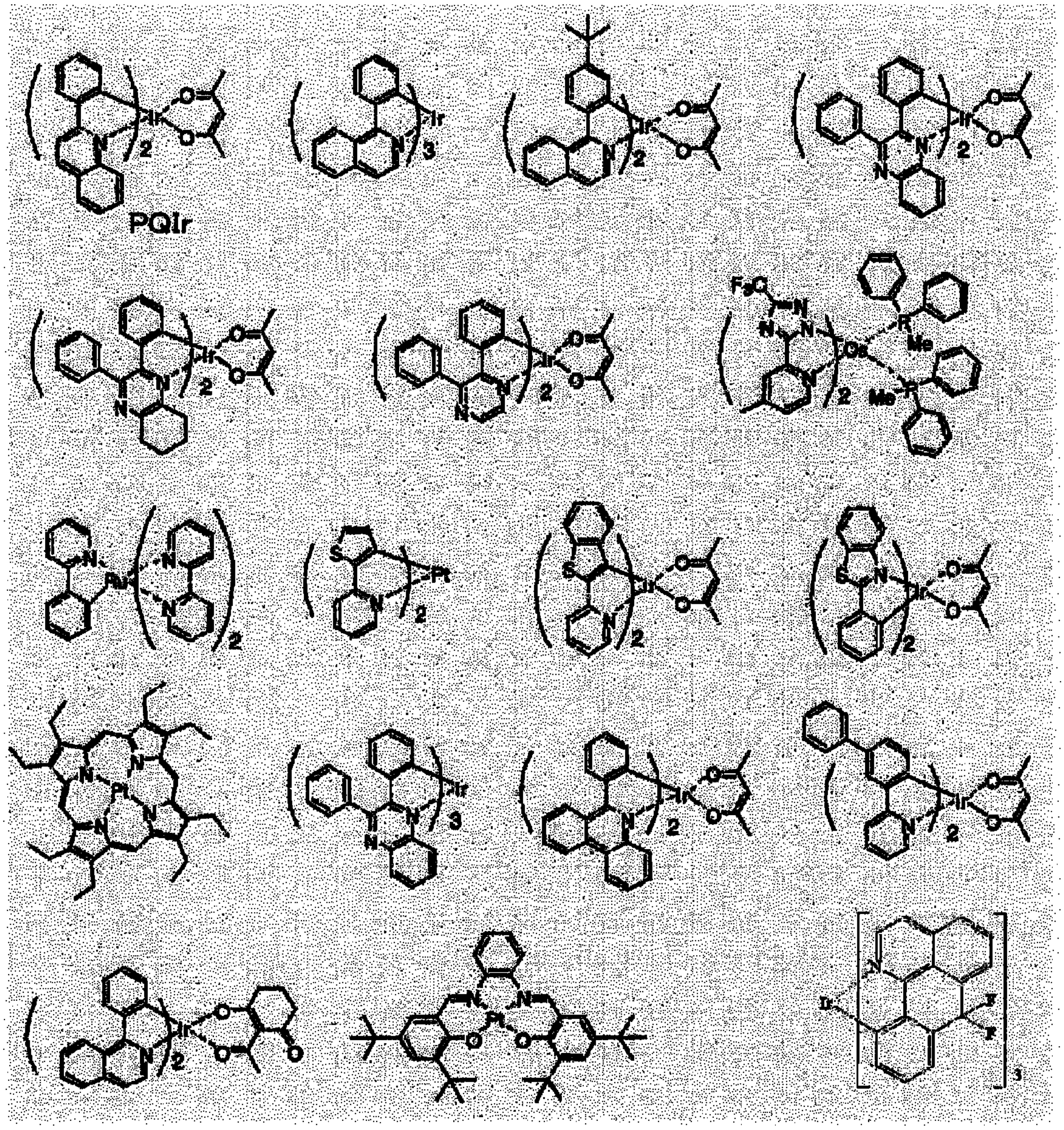

PQIr

[Formula 57]

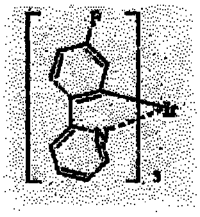
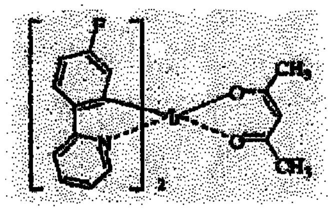
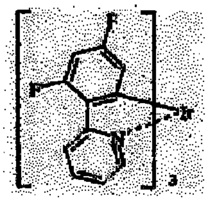

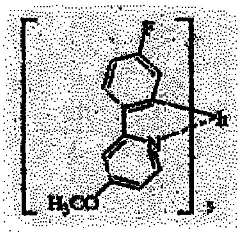
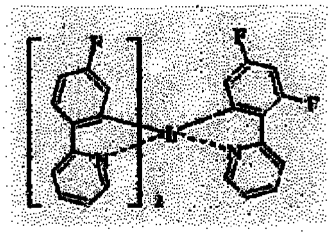
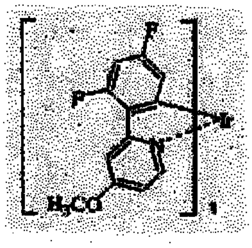

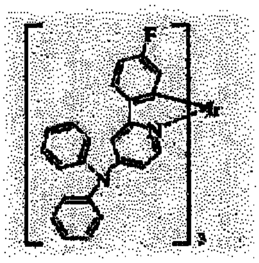
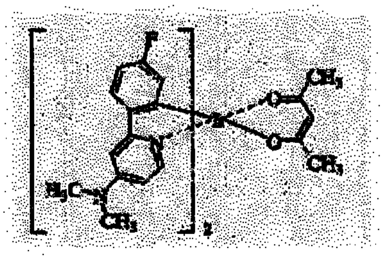
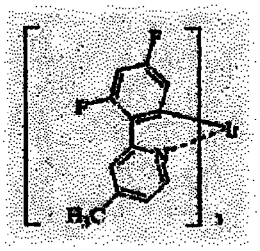

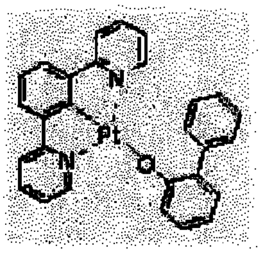
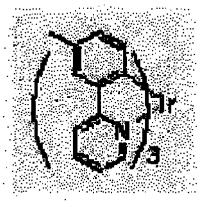
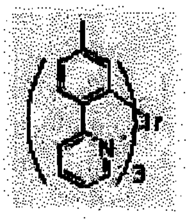

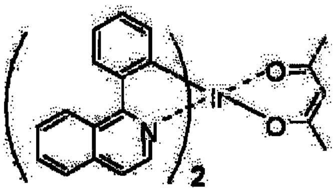
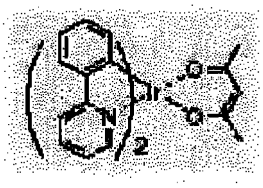
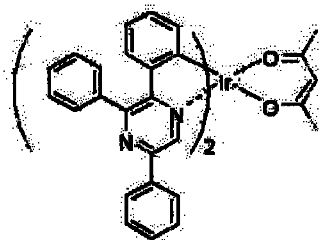

[Formula 58]

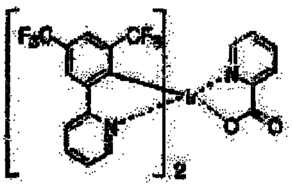
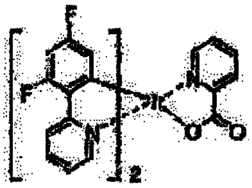
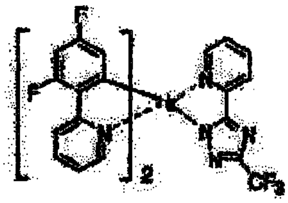

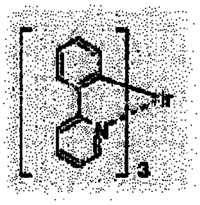

$Ir(ppy)_3$

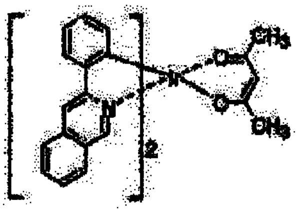
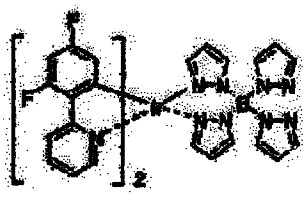

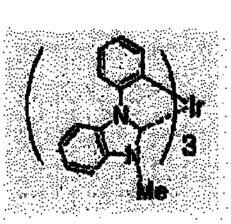
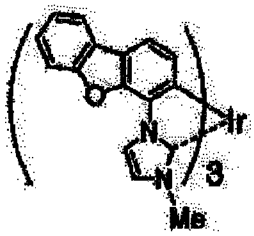
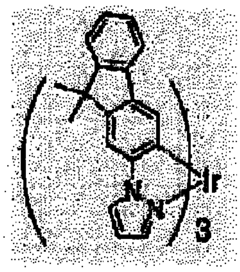

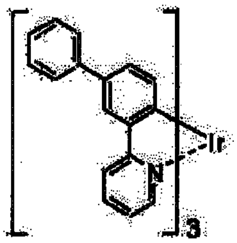
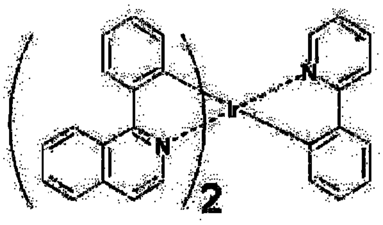
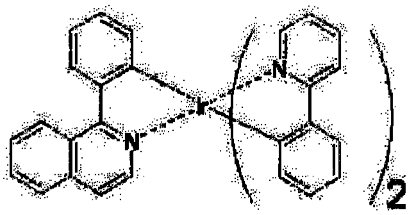

[Formula 59]

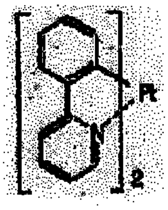
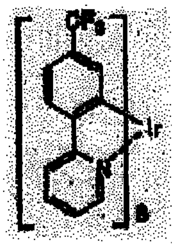
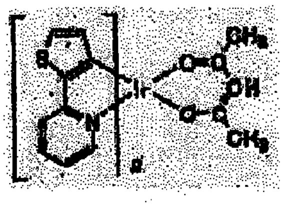

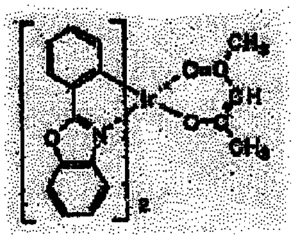
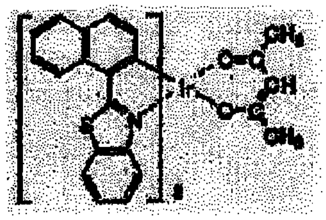

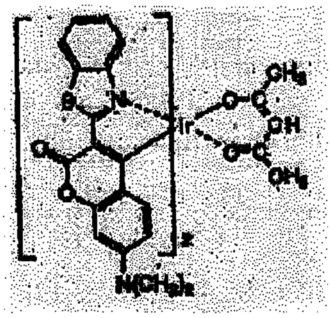
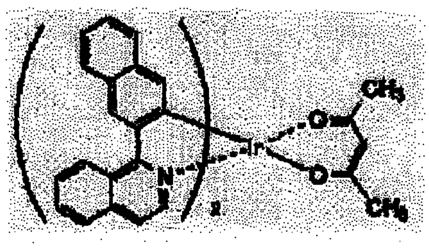

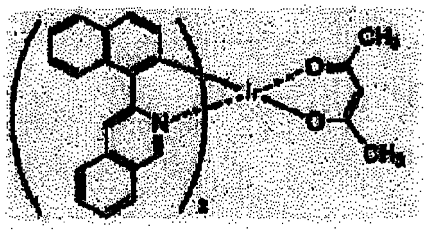
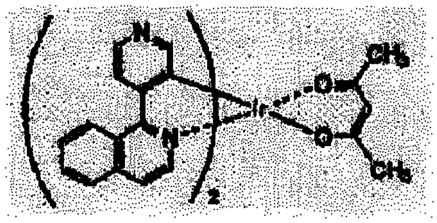

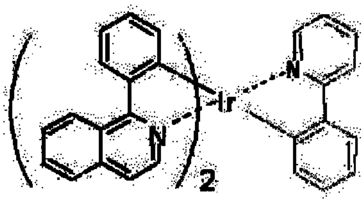
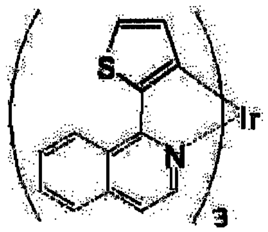

In the exemplary embodiment, at least one of the phosphorescent dopant contained in the emitting layer preferably emits light with a peak emission wavelength in a range of 420 nm to 720 nm.
By doping the phosphorescent dopant having such an emission wavelength to a specific host usable for the exemplary embodiment so as to form the emitting layer, the organic EL device can exhibit a high efficiency.
For enabling blue emission, a preferred peak emission wavelength is in a range of 420 nm to 480 nm.

Second Emitting Layer

The second emitting layer 52 is layered between the first emitting layer 51 and the electron transporting layer 7. The second emitting layer 52 is adjacent to the first emitting layer 51 and the electron transporting layer 7

The second emitting layer 52 contains a second host and a phosphorescent dopant.

A concentration of the phosphorescent dopant is not particularly limited in the exemplary embodiment but is preferably in a range from 0.1 mass% to 30 mass%, more preferably in a range from 1 mass% to 20 mass%.

Second Host

In the exemplary embodiment, the triplet energy of the second host is 2.8 eV or more.
The second host is preferably an azine compound.
In the exemplary embodiment, the second host is preferably a compound represented by the following formula (3).

[Formula 60]

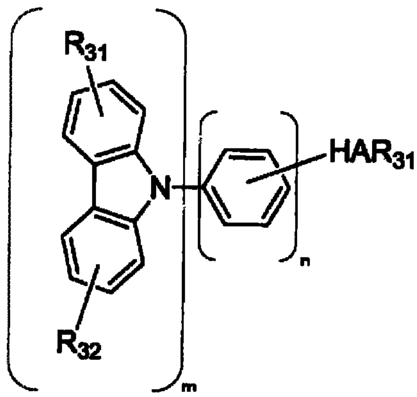

(3)

In the formula (3), $HAR_{31}$ is a substituted or unsubstituted heteroaryl.
In the formula (3), m is an integer of 0 to 5, preferably an integer of 1 to 3, more preferably an integer of 1 or 2.
In the formula (3), n is an integer of 0 to 3. When n is equal to 0, $HAR_{31}$ is bonded to a nitrogen atom in the carbazole skeleton.
In the formula (3), each of $R_{31}$ and $R_{32}$ is a substituted or unsubstituted alkyl group, aryl group or the like. $R_{31}$ and $R_{32}$ may be bonded to provide a cyclic structure with a fused benzene ring.

In the exemplary embodiment, the second host is preferably any one of the compounds represented by the following formulae (4) to (8) and (8A).

[Formula 61]

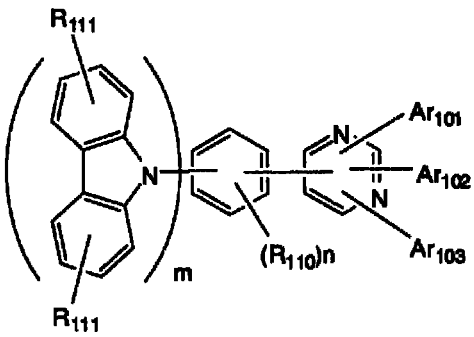

(4)

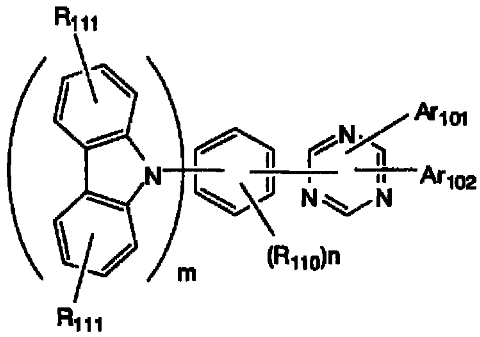

(5)

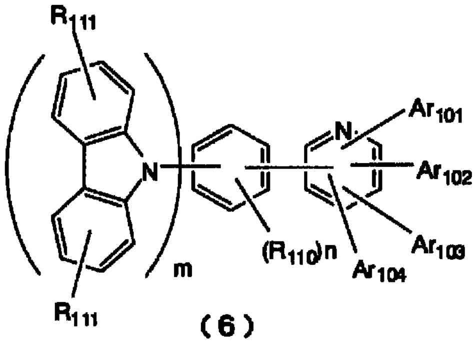

(6)

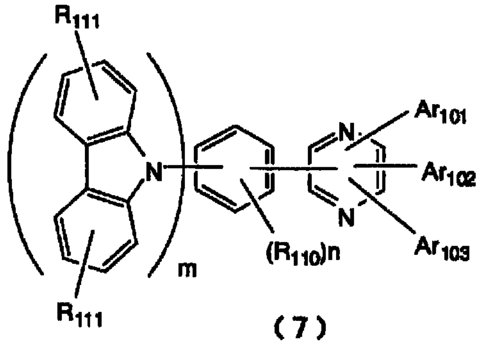

(7)

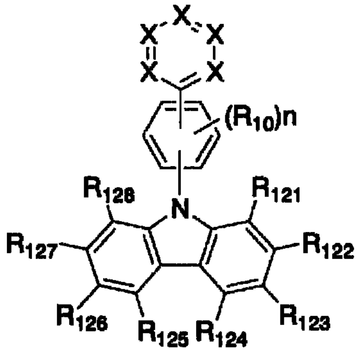

(8)

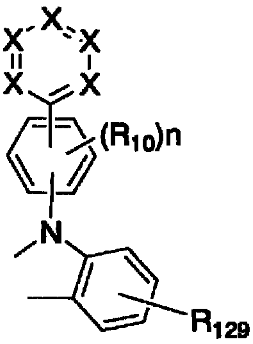

(8A)

In the formulae (4) to (7), each of $Ar_{101}$ to $Ar_{104}$ represents one of the following:

an aryl group having 6 to 60 carbon atoms (which may have a substituent); and
a heterocyclic group having 3 to 60 carbon atoms (which may have a substituent). Examples of the substituent may be the same as those mentioned in relation to R in the formula (1).

In the formulae (4) to (7), each of $R_{110}$ to $R_{111}$ represents a substituent, examples of which are the same as those mentioned in relation to R in the formula (1).
In the formulae (4) to (7), n is an integer of 0 to 4 and m is an integer of 0 to 5. The sum of n and m, i.e., (n + m), satisfies a relationship of $1 \leq (n + m) \leq 5$.
In the formulae (8) and (8A), X is N or CH and the number ofN is 1 to 4.
In the formula (8), each of $R_{121}$ to $R_{128}$ represents any one of the following:

a hydrogen atom;
an aryl group;
a heteroaryl group;
an alkyl group; and
a structure to which the skeleton of the formula (8A) is bonded. The aryl group, heteroaryl group and alkyl group

are the same as those mentioned in relation to R in the formula (1).

The structure in which the skeleton of the formula (8A) is bonded to $R_{121}$ to $R_{128}$ is a structure in which at least $R_{121}$ and $R_{122}$, $R_{122}$ and $R_{123}$, $R_{123}$ and $R_{124}$, $R_{125}$ and $R_{126}$, $R_{126}$ and $R_{127}$, or $R_{127}$ and $R_{128}$ are bonded to the skeleton of the formula (8A).

In the formula (8A), $R_{129}$ represents any one of the following:

a hydrogen atom;
an aryl group;
a heteroaryl group; and
an alkyl group. The aryl group, heteroaryl group and alkyl group are the same as those mentioned in relation to R in the formula (1).

In the formulae (8) and (8A), examples of $R_{10}$ are the same as those of R in the formula (1). In the formulae (8) and (8A), n is the number of $R_{10}$. n is an integer of 0 to 4.

In the exemplary embodiment, the second host is also preferably the following compound (A-6) or (A-9) having a dibenzofuran skeleton.

[Formula 62]

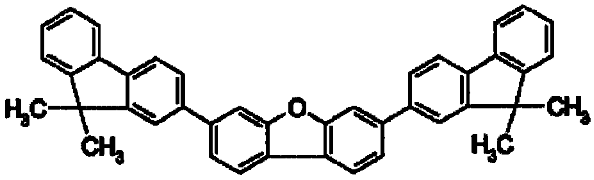

(A-6)

[Formula 63]

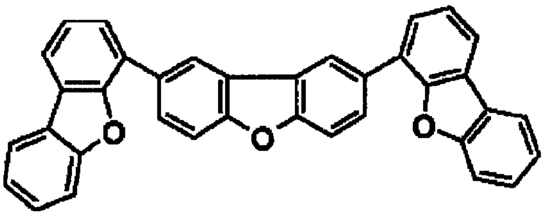

(A-9)

In the exemplary embodiment, the second host is preferably a compound represented by the following formula (14).

[Formula 64]

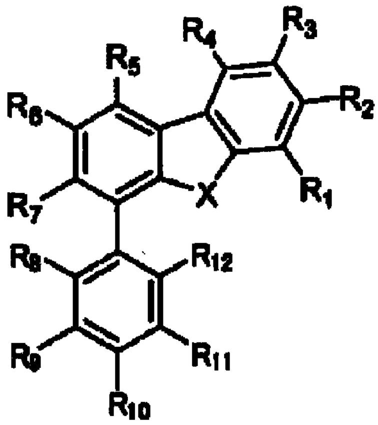

(14)

In the formula (14), each of $R_1$ to $R_{12}$ represents a substituent, examples of which are the same as those mentioned in relation to R in the formula (1). In the formula (14), adjacent ones of $R_1$ to $R_4$, $R_5$ to $R_7$ or $R^8$ to $R_{12}$, or $R_7$ and $R_8$ may form a saturated or unsaturated cyclic structure.
In the formula (14), X is an oxygen atom or a sulfur atom.

Examples of the compound represented by the formula (14) are shown below.

[Formula 65]

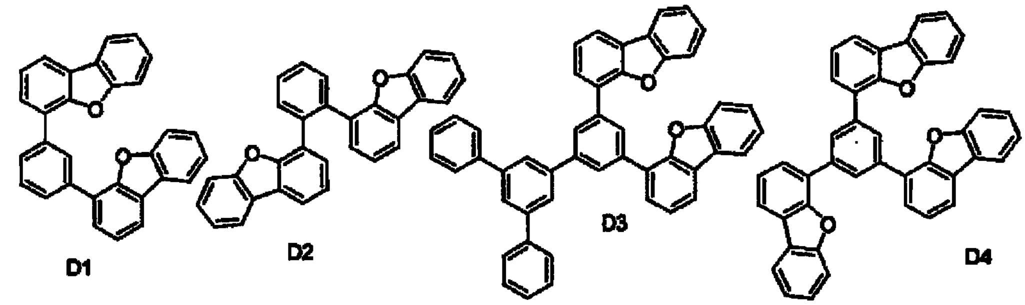

D1 D2 D3 D4

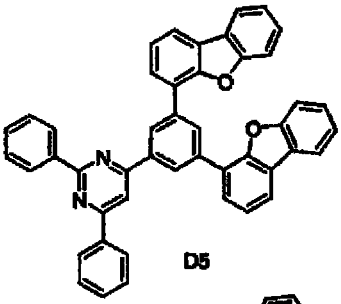

D5

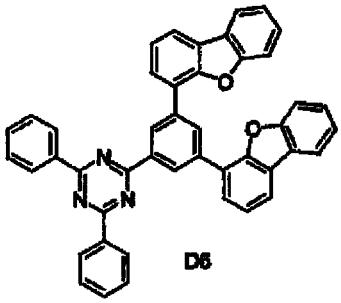

D6

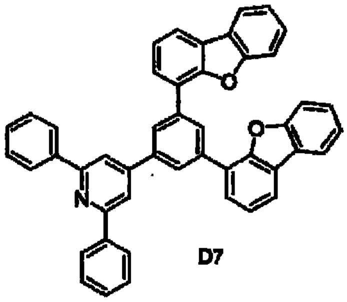

D7

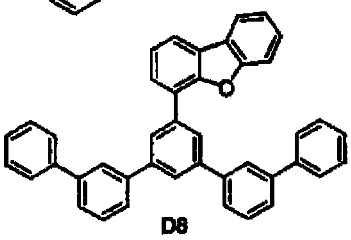

D8

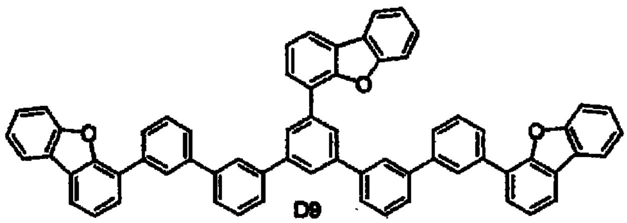

D9

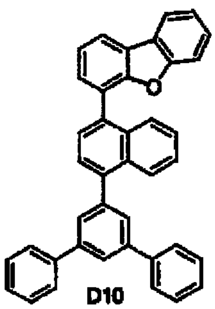

D10

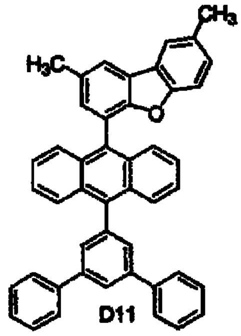

D11

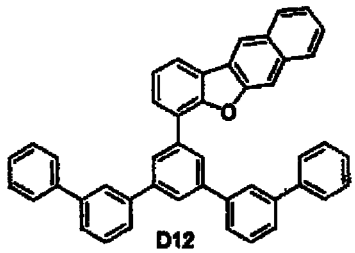

D12

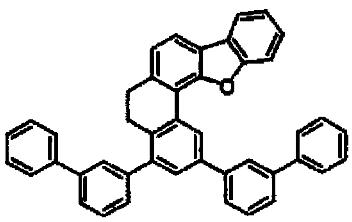

D13

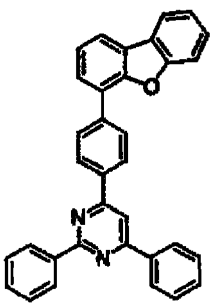

D14

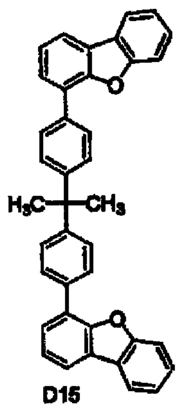

D15

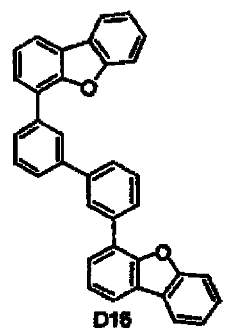

D16

[Formula 66]

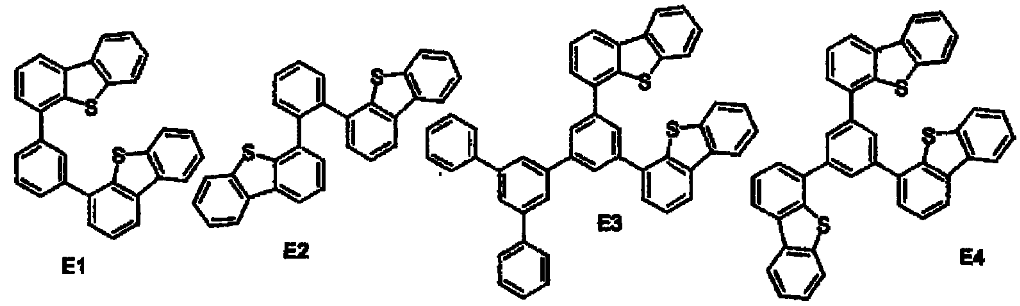

E1 E2 E3 E4

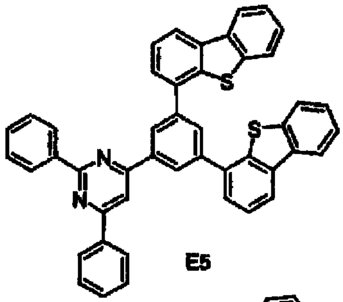

E5

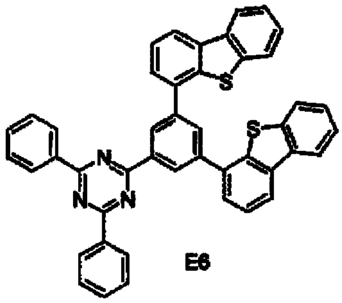

E6

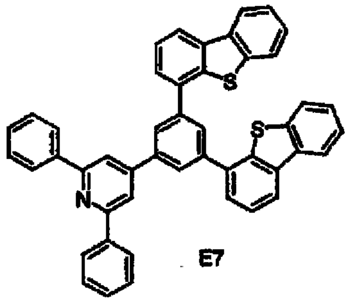

E7

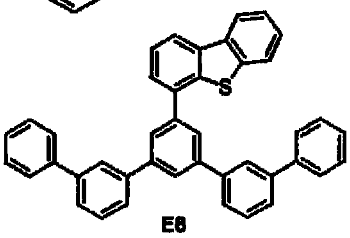

E8

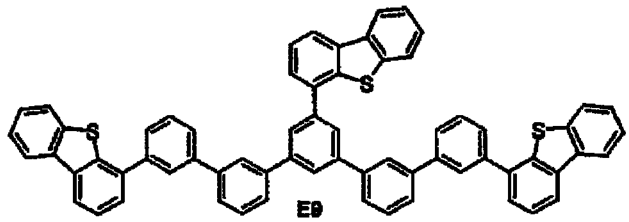

E9

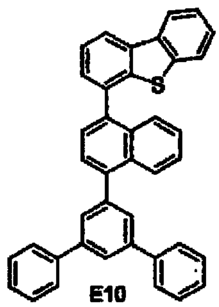

E10

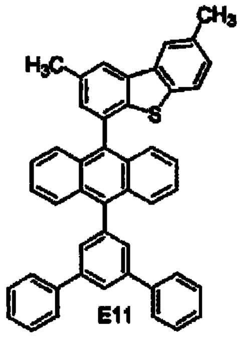

E11

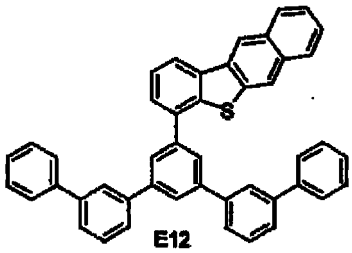

E12

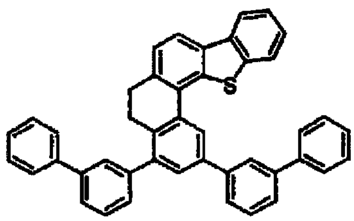

E13

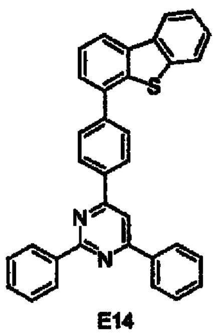

E14

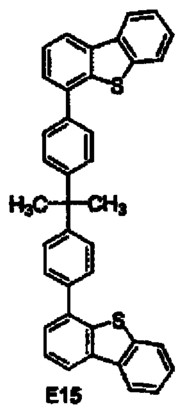

E15

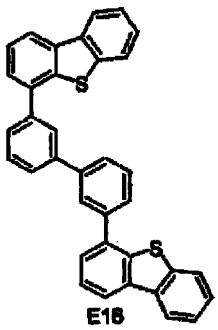

E16

In the exemplary embodiment, the second host is preferably a compound represented by the following formula (15A), (15B) or (15C).

[Formula 67]

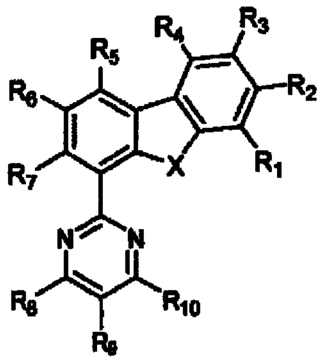

(15A)

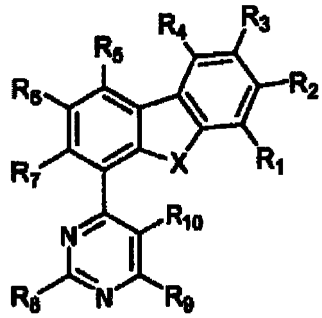

(15B)

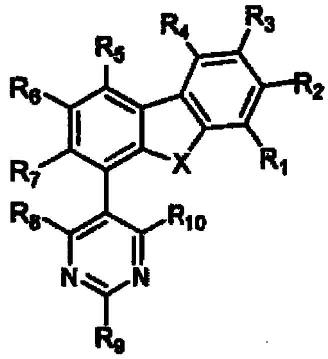

(15C)

In the formulae (15A), (15B) and (15C), each of $R_1$ to $R_{10}$ represents a substituent, examples of which are the same as those mentioned in relation to R in the formula (1).

In the formulae (15A), (15B) and (15C), adjacent ones of $R_1$ to $R_4$, $R_5$ to $R_7$ or $R^8$ to $R_{10}$, or $R_7$ and $R^8$ may form a saturated or unsaturated cyclic structure.

In the formulae (15A), (15B) and (15C), X is an oxygen atom or a sulfur atom.

In the exemplary embodiment, the second host is preferably a compound represented by the following formula (16A), (16B) or (16C).

[Formula 68]

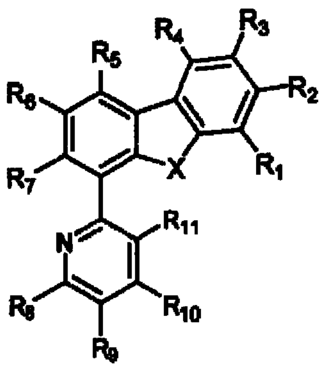

(16A)

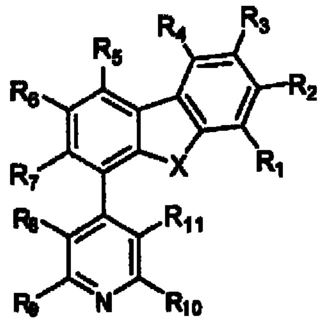

(16B)

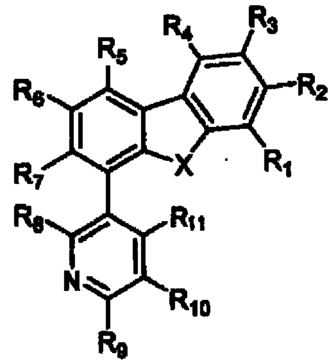

(16C)

In the formulae (16A), (16B) and (16C), each of $R_1$ to $R_{11}$ represents a substituent, examples of which are the same as those mentioned in relation to R in the formula (1).

In the formula (16A), adjacent ones of $R_1$ to $R_4$, $R_5$ to $R_7$ or $R_8$ to $R_{11}$ may form a saturated or unsaturated cyclic structure.

In the formula (16B), adjacent ones of $R_1$ to $R_4$, $R_5$ to $R_7$, $R_8$ to $R_9$ or $R_{10}$ to $R_{11}$, or $R_7$ and $R_8$ may form a saturated or unsaturated cyclic structure.

In the formula (16C), adjacent ones of $R_1$ to $R_4$, $R_5$ to $R_7$ or $R_9$ to $R_{11}$, or $R_7$ and $R_8$ may form a saturated or unsaturated cyclic structure.

In the formulae (16A), (16B) and (16C), X is an oxygen atom or a sulfur atom.

In the exemplary embodiment, the second host is preferably a compound represented by the following formula (17).

[Formula 69]

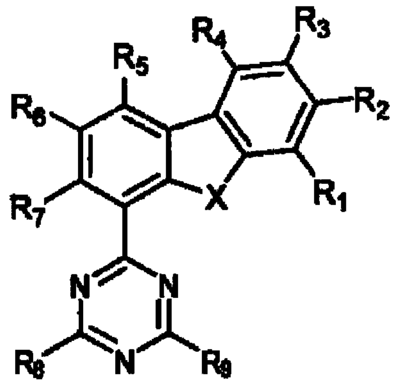

(1 7)

In the formula (17), each of $R_1$ to $R_9$ represents a substituent, examples of which are the same as those mentioned in relation to R in the formula (1).

In the formula (17), adjacent ones of $R_1$ to $R_4$ or $R_5$ to $R_7$ may form a saturated or unsaturated cyclic structure.

In the formula (17), X is an oxygen atom or a sulfur atom.

Examples of the compounds represented by the formulae (15A), (15B), (15C), (16A), (16B), (16C) and (17) are shown below.

[Formula 70]

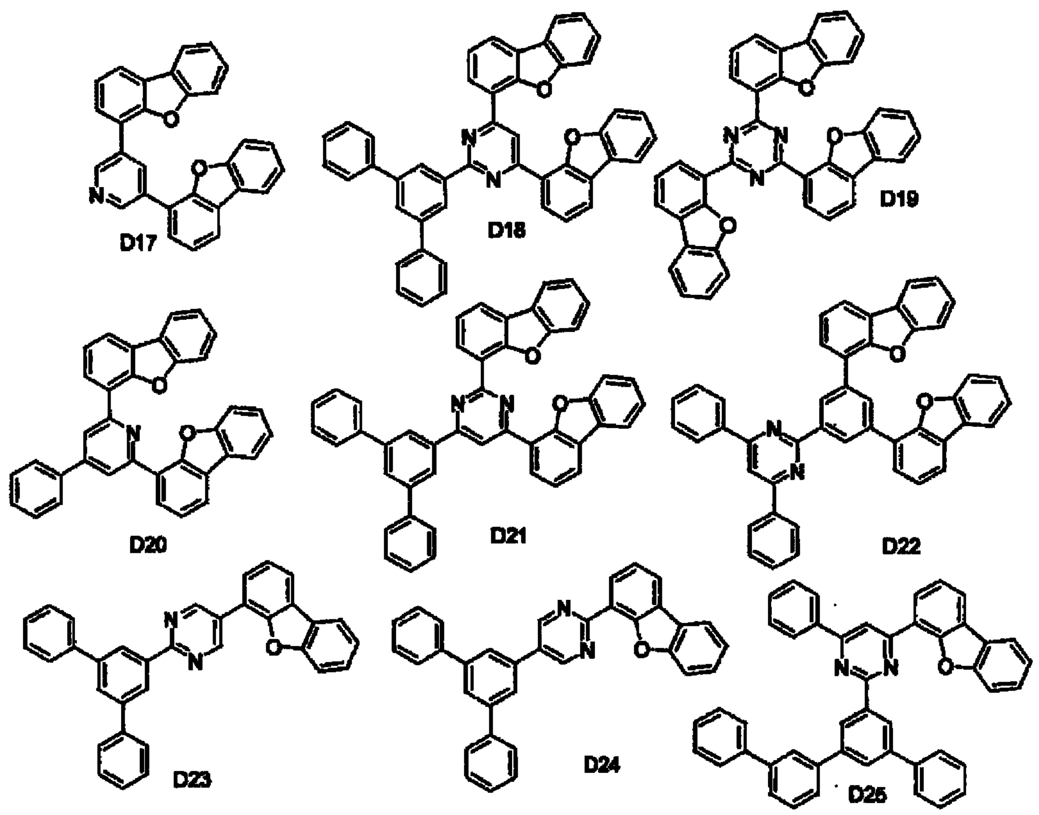

D17 D18 D19

D20 D21 D22

D23 D24 D25

[Formula 71]

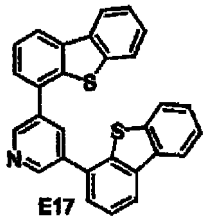

E17

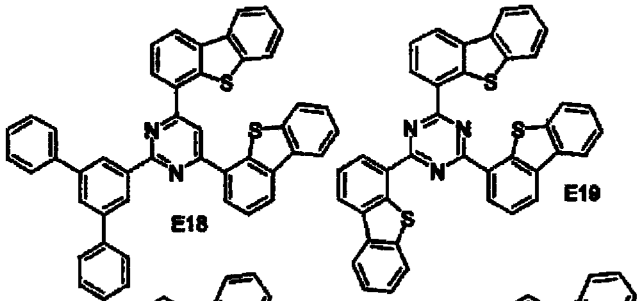

E18

E19

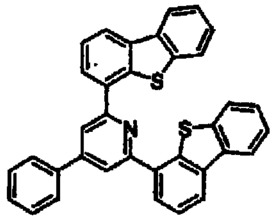

E20

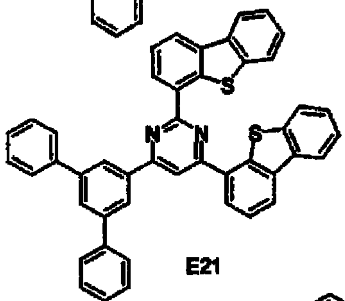

E21

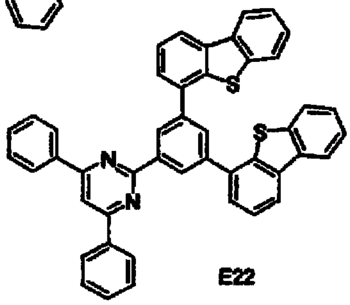

E22

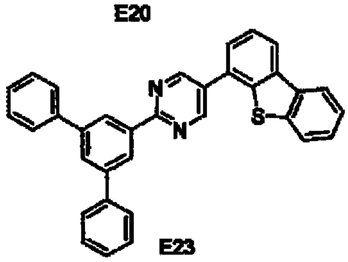

E23

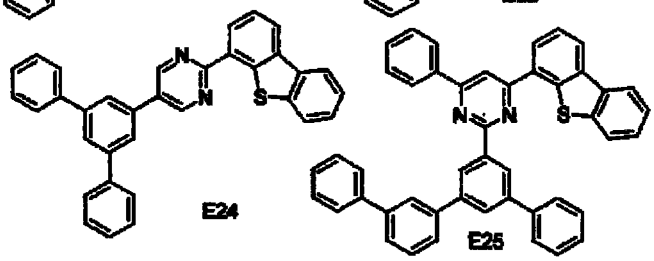

E24

E25

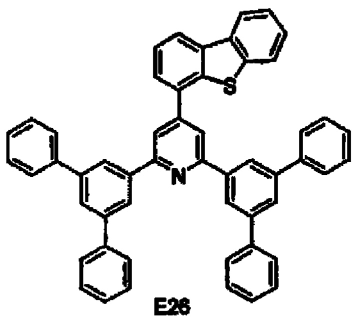

E26

In the exemplary embodiment, the second host is preferably a compound represented by the following formula (18) or (19).

[Formula 72]

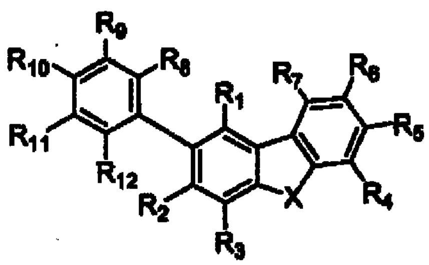

(18)

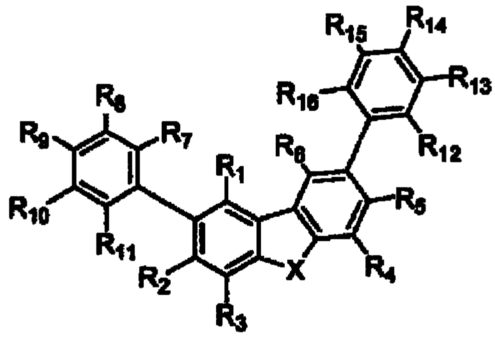

(19)

In the formulae (18) and (19), examples of each of $R_1$ to $R_{16}$ are the same as those mentioned in relation to R in the formula (1). In the formulae (18) and (19), each of $R_1$ to $R_{16}$ may represent one of the following:

a substituted or unsubstituted alkenyl group having 2 to 40 carbon atoms;
a substituted or unsubstituted aralkyl group having 7 to 20 carbon atoms;
a substituted or unsubstituted aralkylamino group having 7 to 60 carbon atoms;
a substituted or unsubstituted aralkylsilyl group having 8 to 40 carbon atoms;
a substituted or unsubstituted alkylgermanium group having 3 to 20 carbon atoms;
a substituted or unsubstituted arylgermanium group having 8 to 40 carbon atoms;
a substituted or unsubstituted aralkylgermanium group having 8 to 40 carbon atoms; and
a substituted or unsubstituted ketoaryl group having 7 to 40 carbon atoms.

In the formula (18), adjacent ones of $R_4$ to $R_7$ or $R_8$ to $R_{12}$ may form a saturated or unsaturated cyclic structure. In the formula (19), adjacent ones of $R_7$ to $R_{11}$ or $R_{12}$ to $R_{16}$ may form a saturated or unsaturated cyclic structure. In the formulae (18) and (19), X is an oxygen atom or a sulfur atom. When X is an oxygen atom, it is preferable that a fused aromatic hydrocarbon group is not included in the substituent for the dibenzofuran skeleton.
Examples of the compounds represented by the formulae (18) and (19) are shown below.

[Formula 73]

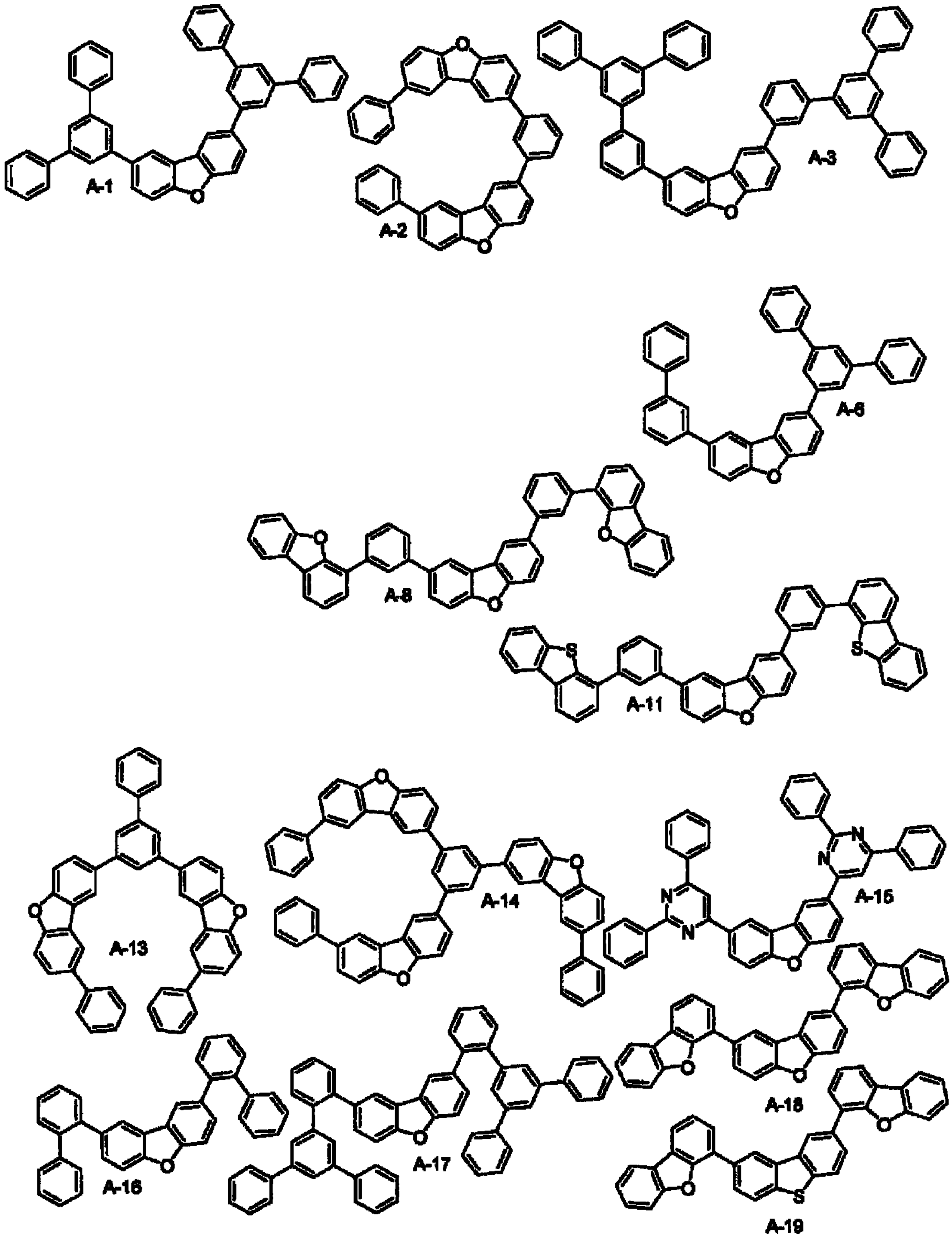

A-1 A-2 A-3 A-6 A-8 A-11 A-13 A-14 A-15 A-16 A-17 A-18 A-19

[Formula 74]

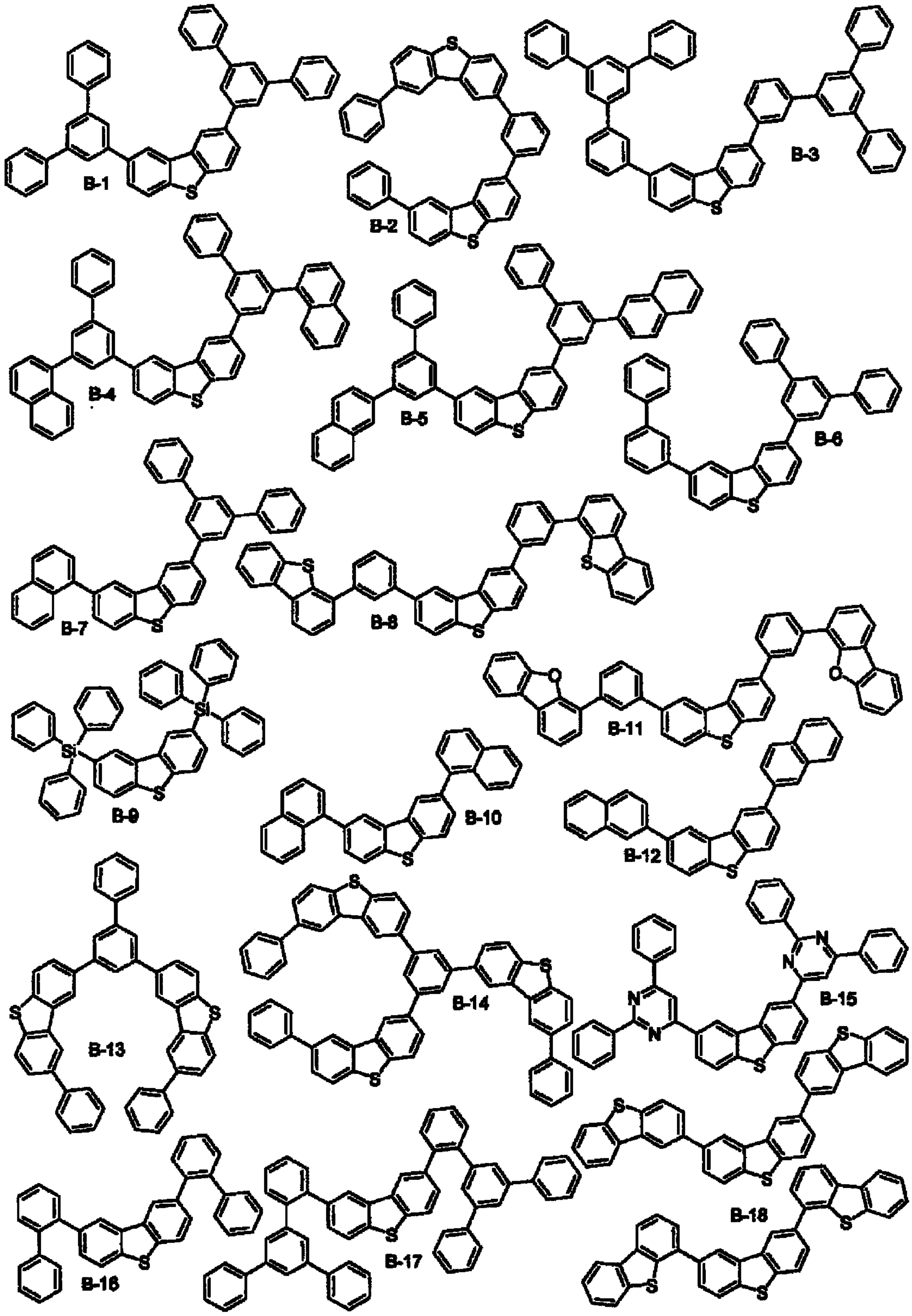

B-1 B-2 B-3

B-4 B-5 B-6

B-7 B-8

B-9 B-10 B-11 B-12

B-13 B-14 B-15

B-16 B-17 B-18 B-19

In the exemplary embodiment, it is preferable that the second host contains a compound having carbazole rings as a partial structure thereof and having in the molecule a benzene ring or a partial structure represented by the following formula (21), and all the carbazole rings of the compound are each substituted at the 9-position, substituted with a substituent(s) represented by the following formula (20) at one or more of the 1-position to the 8-position, and substituted at the 2-position or the 3-position.

[Formula 75]

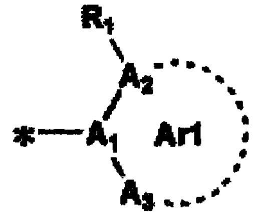

(20)

[Formula 76]

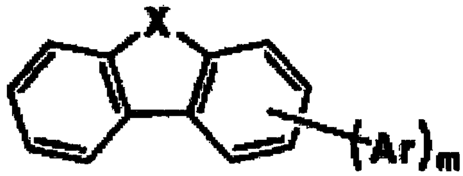

(21)

In the formula (20), * represents a bonding portion relative to the carbazole ring, and Ar1 represents an aromatic ring.
In the formula (20), each of $A_1$ to $A_3$ represents a carbon atom, nitrogen atom, oxygen atom or sulfur atom of the aromatic ring represented by Ar1. The carbon atom, nitrogen atom, oxygen atom and sulfur atom may have a hydrogen atom or a substituent.
In the formula (20), $R_1$ represents a substituent. When Ar1 is a fused ring, $R_1$ may be a part of the fused ring.
In the formula (21), X represents an oxygen atom or a sulfur atom.
In the formula (21), each of $R_3$, $R_4$, $R_5$ and $R_6$ represents a hydrogen atom or a substituent.
In the formula (21), Ar represents an aromatic substituent.
In the formula (21), m is an integer of 0 to 4.
In the formula (20), examples of the aromatic ring represented by Ar1 are an aromatic hydrocarbon ring and an aromatic heterocycle.
Examples of the aromatic hydrocarbon ring are a benzene ring, biphenyl ring, naphthalene ring, azulene ring, anthracene ring, phenanthrene ring, pyrene ring, chrysene ring, naphthacene ring, triphenylene ring, o-terphenyl ring, m-terphenyl ring, p-terphenyl ring, acenaphthene ring, coronene ring, fluorene ring, fluoranthrene ring, naphthacene ring, pentacene ring, perylene ring, pentaphene ring, picene ring, pyrene ring, pyranthrene ring and anthraanthrene ring. These rings may have a substituent R1. Examples of the substituent R1 are the same as those of R in the formula (1).
In the formula (20), preferable examples of the aromatic hydrocarbon ring represented by Ar1 are a benzene ring and a naphthalene ring.
Examples of the aromatic heterocycle are a furan ring, benzofuran ring, dibenzofuran ring, thiophene ring, oxazole ring, pyrrole ring, pyridine ring, pyridazine ring, pyrimidine ring, pyrazine ring, triazine ring, benzimidazole ring, oxadiazole ring, triazole ring, imidazole ring, pyrazole ring, thiazole ring, indole ring, benzimidazole ring, benzothiazole ring, benzoxazole ring, quinoxaline ring, quinazoline ring, phthalazine ring, carbazole ring, carboline ring and diazacarbazole ring (i.e., a ring in which one carbon atom in a hydrocarbon ring of a carboline ring is substituted with a nitrogen atom). These rings may have a substituent R1. Examples of the substituent R1 are the same as those of R in the formula (1).
In the formula (20), preferable examples of the aromatic heterocycle represented by Ar1 are a benzofuran ring, dibenzofuran ring, pyrrole ring, pyridine ring, imidazole ring and benzimidazole ring.
In the formula (21), the aromatic substituent represented by Ar is an aromatic hydrocarbon ring group (also referred to as an aromatic hydrocarbon group, an aryl group or the like) or an aromatic heterocyclic group. Examples of the aromatic hydrocarbon ring group are a phenyl group, p-chlorophenyl group, mesityl group, tolyl group, xylyl group,

naphthyl group, anthryl group, azulenyl group, acenaphthenyl group, fluorenyl group, phenanthryl group, indenyl group, pyrenyl group and biphenylyl group. These aromatic hydrocarbon ring groups may be unsubstituted or may have the substituent represented by R1 in the formula (20).

Examples of the aromatic heterocyclic group are a pyridyl ring, pyrimidinyl ring, furyl ring, pyrrolyl ring, imidazolyl ring, benzimidazolyl ring, pyrazolyl group, pyrazinyl group, triazolyl ring (e.g., 1,2,4-triazole-1-yl group and 1,2,3-triazole-1-yl group), oxazolyl group, benzoxazolyl group, thiazolyl group, isoxazolyl group, isothiazolyl group, furazanyl group, thienyl group, quinolyl group, benzofuryl group, dibenzofuryl group, benzothienyl group, dibenzothienyl group, indolyl group, carbazolyl group, carbolinyl group, diazacarbazolyl group (i.e., a group in which one carbon atom in a carboline ring of the carbolinyl group is substituted with a nitrogen atom), quinoxalinyl group, pyridazinyl group, triazinyl group, quinazolinyl group and phthalazinyl group. These aromatic heterocyclic groups may be unsubstituted or may have the substituent represented by R1 in the formula (20).

Examples of such a compound having such carbazole rings as a partial structure thereof are shown below.

[Formula 77]

(1)

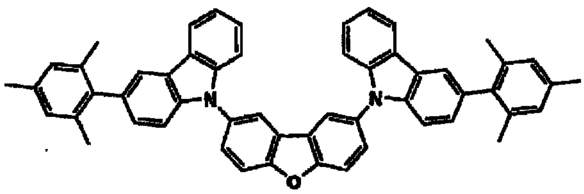

(2)

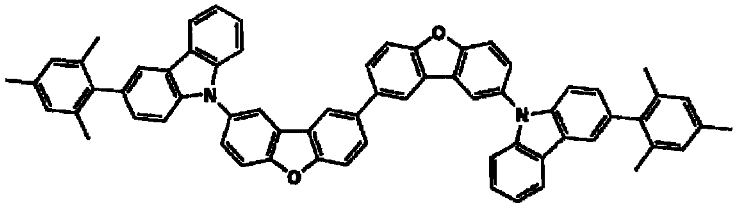

(3)

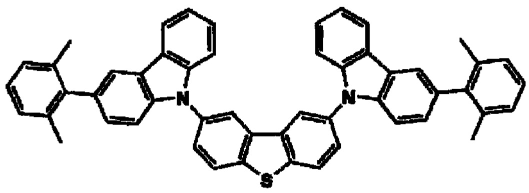

(4)

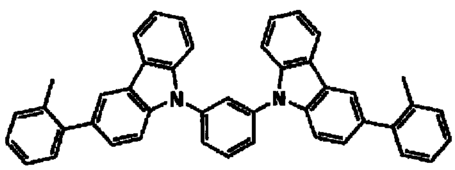

[Formula 78]

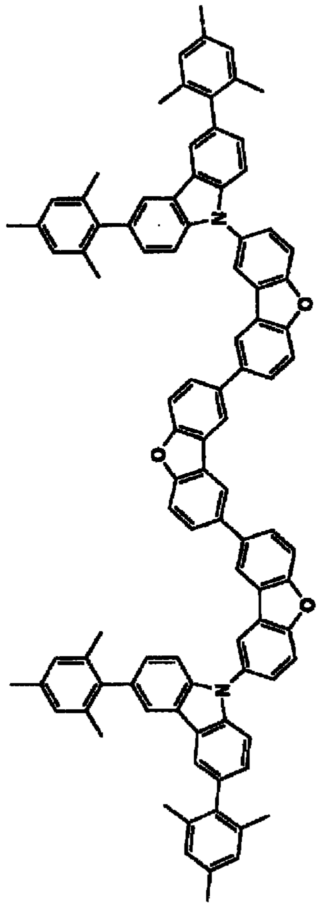

(5)

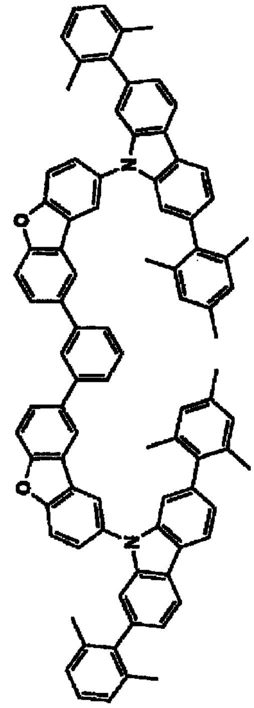

(6)

[Formula 79]

(7)

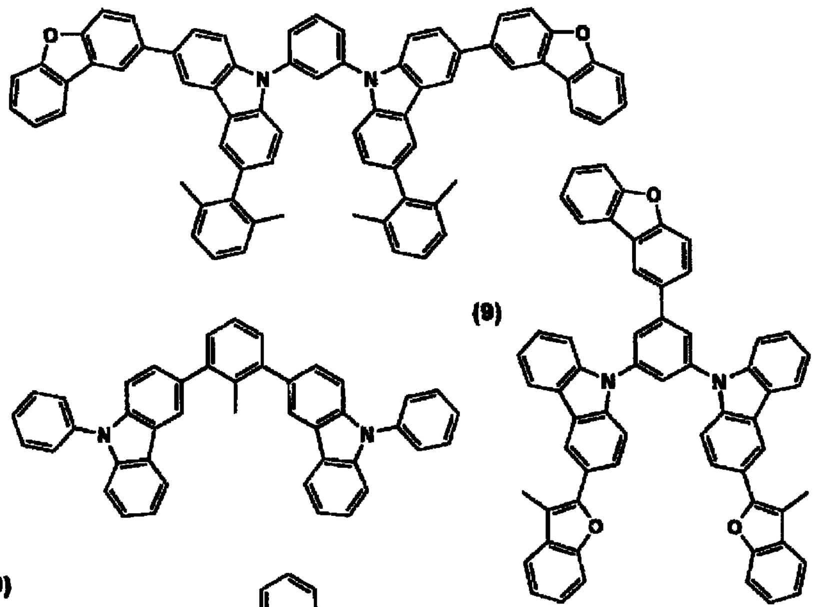

(8)

(9)

(10)

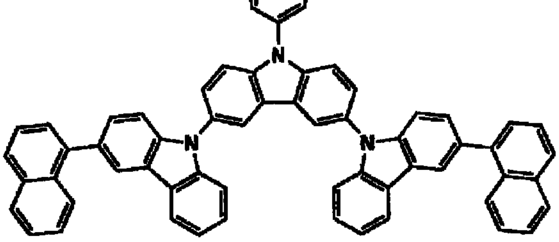

(11)

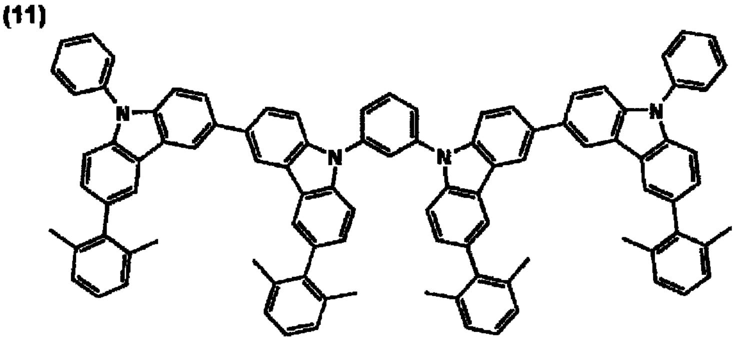

[Formula 80]

(12)

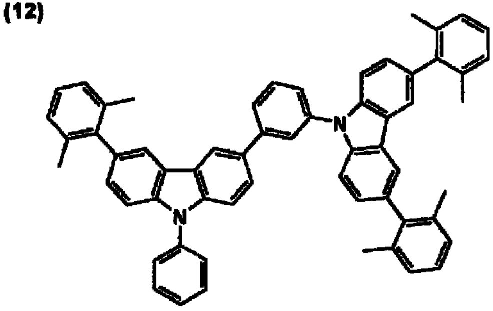

(13)

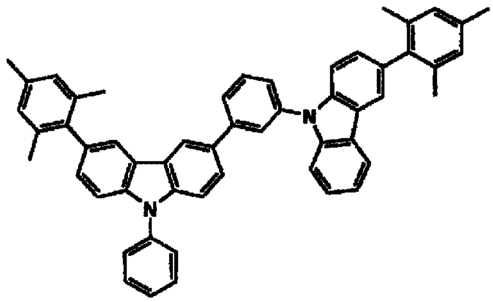

(14)

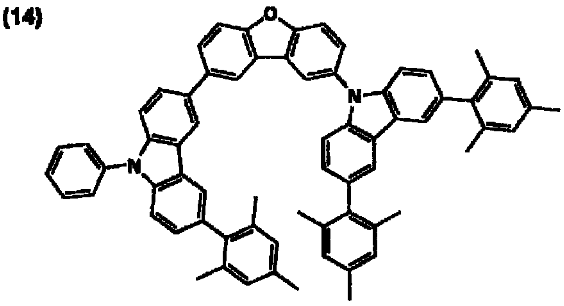

(15)

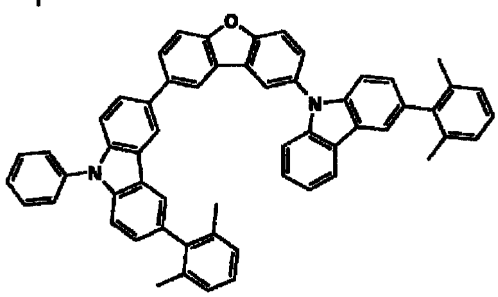

[Formula 81]

(16)

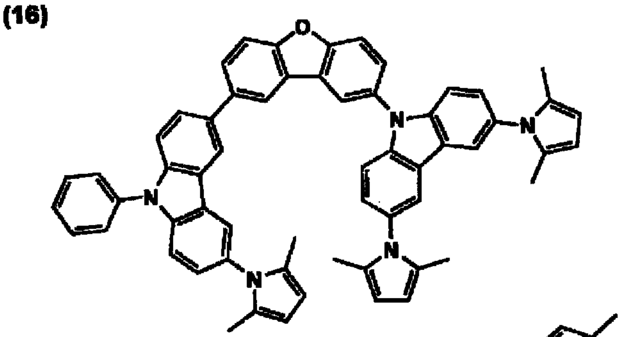

(17)

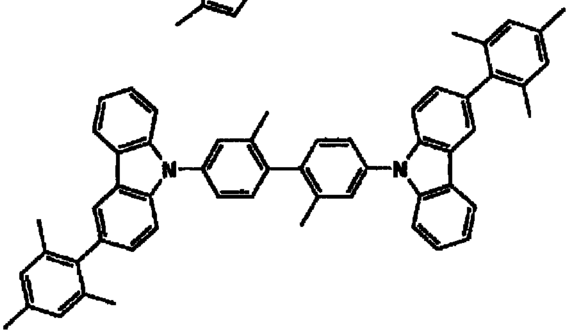

(18)

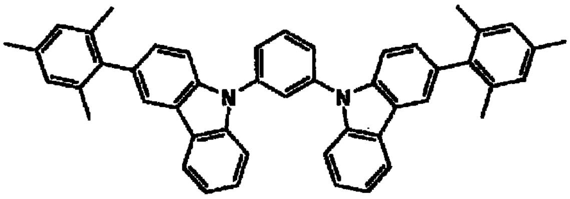

(19)

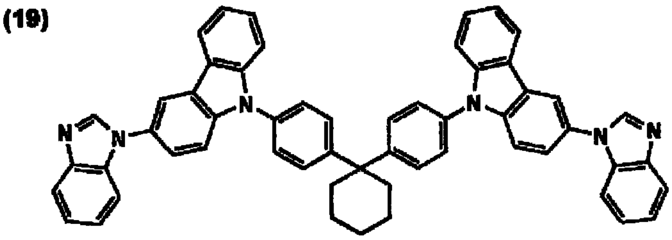

[Formula 82]

(20)

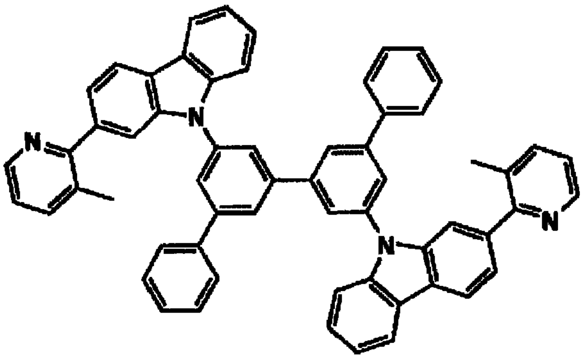

(21)

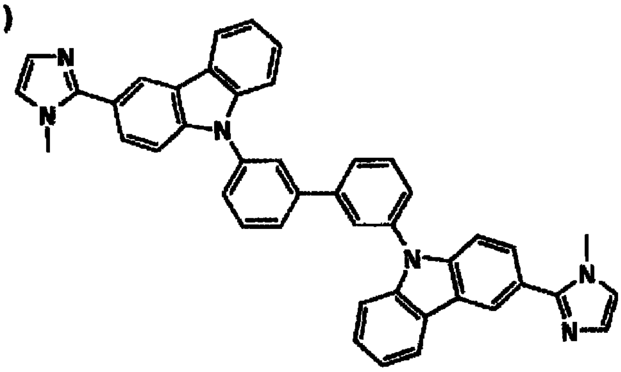

(22)

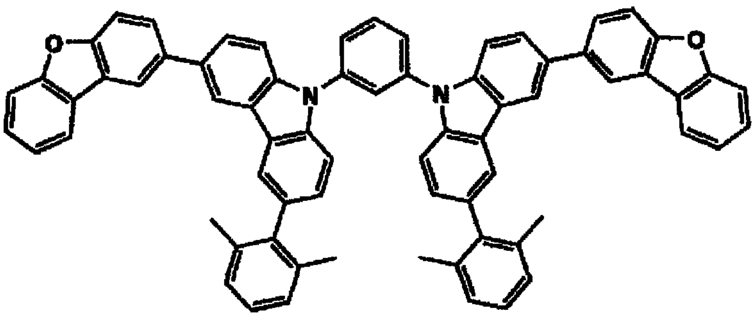

Additionally, compounds disclosed in WO2009/050281, WO2009/003898, WO2008/034758, WO2006/056418, WO2006/130598 and WO2009/085344 are also usable as the second host.

Phosphorescent Dopant

As the phosphorescent dopant contained in the second emitting layer 52, the same phosphorescent dopant described in the explanation of the first emitting layer 51 is usable. The phosphorescent dopant of the first emitting layer 51 may be the same as the phosphorescent dopant of the second emitting layer 52 or may be different from the phosphorescent dopant of the second emitting layer 52.

Relationship between First Emitting Layer and Second Emitting Layer

- Triplet Energy, Ionization Potential and Affinity -

In the exemplary embodiment, the triplet energy of the first host and the triplet energy of the second host are 2.8 eV or more and the ionization potential of the first host is 5.5 eV or less.

In the exemplary embodiment, an affinity $Af_1$ of the first host is smaller than an affinity $Af_2$ of the second host.

Although the compounds usable as the first host and the second host are described above, a different compound may be usable as the first host and the second host in the exemplary embodiment as long as the above relationship in energy between the first host and the second host is satisfied.

Fig. 2 shows an energy diagram of the organic EL device 1.
Since the ionization potential ($Ip_1$) of the first host is 5.5 eV or less, a gap between the ionization potential ($Ip_1$) and the work function of the anode 3 and a gap between the ionization potential ($Ip_1$) and the ionization potential of the hole transporting layer 6 become small. Thus, holes are easily injected from the hole transporting layer 6 into the first emitting layer 51. As a result, less holes are accumulated on or near an interface between the hole transporting layer 6 and the first emitting layer 51, so that a recombination region of holes and electrons can be located not near the hole transporting layer 6 but on or near an interface between the first emitting layer 51 and the second emitting layer 52.
Typically, in an organic EL device using a host having a large triplet energy for blue phosphorescent emission, since a larger band gap of the host results in a larger ionization potential of the host, it is difficult to inject holes into the emitting layer. A disadvantage of this arrangement is that the recombination region of holes and electrons is shifted toward the hole transporting layer 6 and thus electrons flow from the first host, which has small affinity and large band gap, into the hole transporting layer 6, which has a larger affinity than the host, so that the hole transporting layer 6 is likely to be deteriorated because the hole transporting layer 6 does not exhibit electron tolerance. In contrast, in the exemplary embodiment, although the first host has a large triplet energy such as 2.8 eV or more, holes are easily injected because the ionization potential ($Ip_1$) of the first host is 5.5 eV or less, and thus the recombination region of holes and electrons can be located not near the hole transporting layer 6 but on or near the interface between the first emitting layer 51 and the second emitting layer 52. Thus, electrons flowing into the hole transporting layer 6 are reduced and the hole transporting layer 6 is unlikely to be deteriorated.
The affinity $Af_2$ of the second host is larger than the affinity $Af_1$ of the first host and the triplet energy of the second host is 2.8 eV or more, so that an ionization potential ($I_{P2}$) of the second host is also increased. When the ionization potential ($Ip_2$) of the second host is larger than the ionization potential ($Ip_1$) of the first host, it is difficult for holes injected from the hole transporting layer 6 into the first emitting layer 51 to move to the second emitting layer 52, and thus the holes can be easily accumulated on or near the interface between the first emitting layer 51 and the second emitting layer 52.
In the exemplary embodiment, since the triplet energy of the first host is set at 2.8 eV or more and the ionization potential ($Ip_1$) of the first host is set at 5.5 eV or less, the affinity $Af_1$ of the first host becomes small. Thus, when the host contained in the emitting layer is provided only by the first host, energy barrier (i.e., a difference in affinity) between the electron transporting layer and the first host becomes large, which results in a rise in driving voltage because of an insufficient electron-injecting capability.
In this exemplary embodiment, the second host, the affinity $Af_2$ of which is smaller than the affinity $Af_1$ of the first host, is contained in the second emitting layer 52, so that energy barrier becomes small between the electron transporting layer 7 and the second emitting layer 52 and thus the capability of injecting electrons into the second emitting layer 52 is enhanced.
Additionally, since the affinity $Af_1$ of the first host is smaller than the affinity $Af_2$ of the second host, energy barrier is formed between the second emitting layer 51 and the second emitting layer 52. Thus, it is difficult for electrons injected from the cathode 4 into the second emitting layer 52 to move toward the hole transporting layer 6 and the anode 3, and thus the electrons can be easily accumulated on or near the interface between the first emitting layer 51 and the second emitting layer 52.
The affinity $Af_1$ of the first host and the affinity $Af_2$ of the second host preferably satisfy the following relationship.

$$Af_2 - Af_1 \geq 0.4\ [eV]$$

As long as this relationship is satisfied, the capability of injecting electrons into the second emitting layer is enhanced while the capability of injecting electrons into the first emitting layer is lowered, thereby efficiently preventing transfer of electrons toward the hole transporting layer 6 and the anode 3. As a result, the lifetime of the device can be prolonged.
As described above, since holes can be easily injected into the first emitting layer 51 while electrons can be easily injected into the second emitting layer 52, the electrons can be easily accumulated on or near the interface between the first emitting layer 51 and the second emitting layer 52. Thus, the electrons and the holes can be efficiently recombined at the region between the first emitting layer 51 and the second emitting layer 52 to improve the luminous efficiency.
Since the recombination region is located away from the hole transporting layer 6 and the electron transporting layer 7, less electrons move to the hole transporting layer 6 exhibiting a low electron tolerance and less holes move to the electron transporting layer 7 exhibiting a low hole tolerance. Thus, the hole transporting layer 6 and the electron transporting layer 7 are less deteriorative. As a result, the lifetime of the organic EL device can be prolonged.

Ionization Potential (Ip)

To measure the ionization potential (Ip), a material was irradiated with a light (excitation light) from a deuterium ramp dispersed through a monochromator. The resulting ejection of photoelectrons was measured by an electrometer. With reference to the obtained curve of radiated photon energy resulting from the ejection of photoelectrons, a threshold of the ejection of photoelectrons was calculated by extrapolation. As a measuring machine, the atmospheric ultraviolet photoelectron analyzer AC-3 (manufactured by Riken Keiki Co., Ltd.) was used.

Singlet Energy (Eg)

The singlet energy (Eg) was obtained by irradiating a toluene-diluted solution of each material with light and converting a maximum wavelength of the resulting absorption spectrum. As a measuring machine, a spectrophotometer (manufactured by Hitachi, Ltd., product name: U-3400) was used.

Triplet Energy (EgT)

The triplet energy (EgT) was obtained in the following method. An organic material was measured by a known phosphorescence measurement method (e.g., a method described on and near page 50 of "Hikarikagaku no Sekai" (edited by The Chemical Society of Japan, 1993)). Specifically, the organic material was dissolved in a solvent (sample: 10 $\mu$mol/L, EPA (diethylether : isopentane : ethanol = 5:5:2 in volume ratio, each solvent is in a spectroscopic grade)) to provide a sample for phosphorescence measurement. The sample set in a quartz cell was cooled down to 77 K and irradiated with an excitation light. The resulting phosphorescence was measured relative to a wavelength. A tangent line was drawn to be tangent to a rising section of the phosphorescence spectrum on the short-wavelength side, and the obtained wavelength value was converted into an energy value, which was defined as EgT. For the measurement, the body of the F-4500 fluorescence spectrophotometer (manufactured by Hitachi, Ltd.) and optional accessories for low-temperature measurement were used. In place of the above measuring device, a cooling device, a low-temperature container, an excitation light source and a light-receiving device may be used in combination for the measurement.
In the exemplary embodiment, the following expression was used for conversion of the wavelength.

$$\text{conversion expression: EgT (eV)} = 1239.85 / \lambda\text{edge}$$

When the phosphorescence spectrum is expressed in coordinates, the ordinate axis of which indicates the phosphorescence intensity and the abscissa axis of which indicates the wavelength, and a tangent is drawn to a rising section of the phosphorescence spectrum on the short-wavelength side, "$\lambda$edge" is a wavelength value at the intersection of the tangent and the abscissa axis. unit: nm
In the exemplary embodiment, the triplet energy refers to a difference between energy in the lowest triplet state and energy in the ground state. The singlet energy (often referred to as energy gap) refers to a difference between energy in the lowest singlet state and energy in the ground state.

Affinity (Af)

Using the measurement values Ip and Eg, the affinity (Af) was calculated by an expression Af = Ip - Eg.

Relationship between First Host and Second Host

-Hole Mobility and Electron Mobility-

In the organic EL device according to the exemplary embodiment, the first host preferably has a higher hole mobility for accelerating the transfer of holes to the second host, and the second host preferably has a higher electron mobility for accelerating the transfer of electrons to the first host.
In the organic EL device according to the exemplary embodiment, the hole mobility of the first host is preferably $10^{-4}$ $cm^2/Vs$ or more at application of an electrical field of $10^4$ to $10^6$ V/cm.
The electron mobility of the second host is preferably $10^{-5}$ $cm^2/Vs$ or more at application of an electrical field of $10^4$ to $10^6$ V/cm.
A ratio of the hole mobility of the first host to the electron mobility of the first host is preferably in a range of 1 to 100.
When the ratio is 1 or less, the hole-transporting capability is lowered, which results in deterioration of the hole transporting

layer. When the ratio is 100 is more, the electron tolerance is lowered, which results in deterioration of the first emitting layer.
A ratio of the electron mobility of the second host to the hole mobility of the second host is preferably in a range of 10 to 100.
A ratio of the hole mobility of the first host to the hole mobility of the second host is preferably in a range of 1 to 1000.
Additionally, a difference between a singlet energy and a triplet energy of a host contained in the first host is smaller than a difference between a singlet energy and a triplet energy of a host contained in the second host.
A method of measuring hole mobility and electron mobility is not specifically limited. Specifically, for instance, a time-of-flight method (i.e., a method according to which the mobility is calculated from a measured transit time of charge in an organic film) and a method according to which the mobility is calculated from the voltage characteristics of a space limited current are usable. According to the time-of-flight method, an arrangement of electrode / organic layer (an organic material layer forming an electron transporting layer or a hole transporting layer) / electrode is irradiated by a light having a wavelength in an absorption wavelength range of the organic layer to measure the time characteristics of the resulting transient current (transient characteristic time). The hole mobility or the electron mobility is calculated by the following expressions.

$$\text{mobility} = (\text{organic film thickness})^2 / (\text{transient characteristic time} \cdot \text{applied voltage})$$

$$\text{field intensity} = (\text{voltage applied to device}) / (\text{organic layer thickness})$$

Additionally, methods described in Electronic Process in Organic Crystals (M.Pope,C.E.Swenberg), Organic Molecular Solids (W.Jones), and the like are also usable.

Light-Transmissive Substrate

The anode 3, the first emitting layer 51, the second emitting layer 52, the cathode 4 and the like are layered on the light-transmissive substrate 2 to provide the organic EL device 1. The substrate 2, which supports the anode 3 and the like, is preferably a smoothly-shaped substrate that transmits 50% or more of light in a visible region of 400 nm to 700 nm.
Specifically, a glass plate, a polymer plate and the like may be employed.
The glass plate is formed of soda-lime glass, barium/strontium-containing glass, lead glass, aluminosilicate glass, borosilicate glass, barium borosilicate glass, quartz, or the like.
The polymer plate is formed of polycarbonate, acryl, polyethylene terephthalate, polyether sulfide, polysulfone or the like.

Anode and Cathode

The anode 3 of the organic EL device 1 is used for injecting holes into the hole injecting layer, the hole transporting layer 6 or the emitting layer 5. It is effective that the anode 3 has a work function of 4.5 eV or more.
Exemplary materials for the anode are alloys of indium-tin oxide (ITO), tin oxide (NESA), indium zinc oxide, gold, silver, platinum and copper.
The anode 3 can be manufactured by forming a thin film from these anode materials on, for instance, the substrate 2 through a method such as vapor deposition or sputtering.
When light from the emitting layer 5 is to be emitted through the anode 3 as in the exemplary embodiment, the anode 3 preferably transmits more than 10% of the light in the visible region. Sheet resistance of the anode 3 is preferably several hundreds Ω/ sq. or lower. Although depending on the material of the anode, the film thickness of the anode is typically in a range of 10 nm to 1 μm, and preferably in a range of 10 nm to 200 nm.
Although a material for the cathode is subject to no specific limitation, examples of the material are indium, aluminum, magnesium, alloy of magnesium and indium, alloy of magnesium and aluminum, alloy of aluminum and lithium, alloy of aluminum, scandium and lithium, and alloy of magnesium and silver.
Like the anode 3, the cathode 4 may be made by forming a thin film from the above materials on, for instance, the electron transporting layer 7 through a method such as vapor deposition or sputtering. In addition, light from the emitting layer 5 may be emitted through the cathode 4. When light from the emitting layer 5 is to be emitted through the cathode 4, the cathode 4 preferably transmits more than 10% of the light in the visible region.
Sheet resistance of the cathode is preferably several hundreds Ω/sq. or lower.

Although depending on the material of the cathode, the film thickness of the cathode is typically in a range from 10 nm to 1 μm, preferably in a range from 50 to 200 nm.

Other Layers

The organic EL device according to the exemplary embodiment may further include a hole injecting layer, a hole transporting layer, an electron injecting layer and the like as needed in order to increase a current (or luminous) efficiency. The organic EL device 1 exemplarily includes the hole transporting layer 6 and the electron transporting layer 7. A material for forming these layers is not specifically limited, and any organic material known as a typical organic electroluminescent material is usable. Specifically, an amine derivative, stilbene derivative, silazane derivative, polysilane, aniline copolymer and the like are usable.
In the exemplary embodiment, in order to enhance the capability of injecting holes into the emitting layer, the ionization potential $Ip_H$ of an adjacent layer being adjacent to the emitting layer on the anode side of the emitting layer (the hole injecting layer, the hole transporting layer or the like) and the ionization potential $Ip_1$ of the first emitting layer preferably satisfy a relationship of the following expression.

$$0\ \mathrm{eV} \leq Ip_H - Ip_1 \leq 0.3\ \mathrm{eV}$$

Additionally, in the exemplary embodiment, in order to enhance the capability of injecting electrons into the emitting layer, the affinity $Af_E$ of an adjacent layer being adjacent to the emitting layer on the cathode side of the emitting layer (the electron injecting layer, the electron transporting layer or the like) and the affinity $Af_2$ of the second emitting layer preferably satisfy a relationship of the following expression.

$$0\ \mathrm{eV} \leq Af_E - Af_2 \leq 0.4\ \mathrm{eV}$$

Hole Injecting Layer and Hole Transporting Layer

The hole injecting layer or the hole transporting layer (including the hole injecting/transporting layer) preferably contains an aromatic amine compound such as an aromatic amine derivative represented by the following formula (I).

[Formula 83]

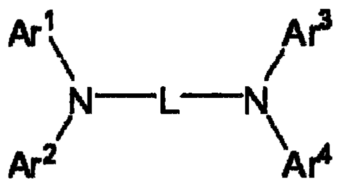

$\cdots$ (I)

In the formula (I), $Ar^1$ to $Ar^4$ each represent one of the following:

an aromatic or fused aromatic hydrocarbon group having 6 to 50 ring carbon atoms (which may have a substituent);
an aromatic or fused aromatic heterocyclic group having 2 to 40 ring carbon atoms (which may have a substituent); and
a group provided by bonding the aromatic or fused aromatic hydrocarbon group and the aromatic or fused aromatic heterocyclic group.

Aromatic amine represented by the following formula (II) can also be preferably used for forming the hole injecting layer or the hole transporting layer.

[Formula 84]

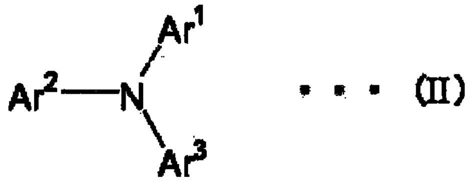

In the formula (II), $Ar^1$ to $Ar^3$ each represent the same as those represented by $Ar^1$ to $Ar^4$ of the formula (I).

Electron Injecting Layer and Electron Transporting Layer

The electron injecting layer or the electron transporting layer, which aids injection of the electrons into the emitting layer, has a high electron mobility. The electron injecting layer is provided for adjusting energy level, by which, for instance, sudden changes of the energy level can be reduced.
The organic EL device according to the exemplary embodiment of the invention preferably includes the electron injecting layer between the emitting layer and the cathode. The electron injecting layer preferably contains a nitrogen-containing cyclic derivative as the main component. The electron injecting layer may serve also as the electron transporting layer. It should be noted that "as the main component" means that the nitrogen-containing cyclic derivative is contained in the electron injecting layer at a content of 50 mass% or more.
A preferable example of an electron transporting material for forming the electron injecting layer is an aromatic heterocyclic compound having at least one heteroatom in the molecule. Particularly, a nitrogen-containing cyclic derivative is preferable. The nitrogen-containing cyclic derivative is preferably an aromatic ring having a nitrogen-containing six-membered or five-membered ring skeleton, or a fused aromatic compound having a nitrogen-containing six-membered or five-membered ring skeleton.
The nitrogen-containing cyclic derivative is preferably exemplified by a nitrogen-containing cyclic metal chelate complex represented by the following formula (A).

[Formula 85]

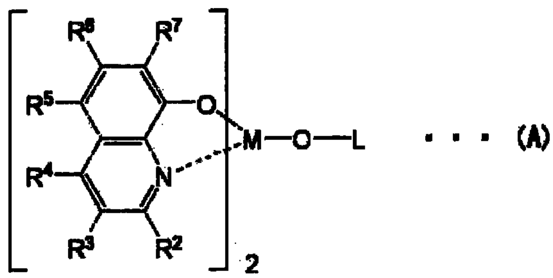

$R^2$ to $R^7$ in the formula (A) independently represent one of the following:

a hydrogen atom;
a halogen atom;
an oxy group;
an amino group;
a hydrocarbon group having 1 to 40 carbon atoms;
an alkoxyl group;
an aryloxy group;
an alkoxycarbonyl group; and
an aromatic heterocyclic group.
$R^2$ to $R^7$ may be substituted or unsubstituted.

Examples of the halogen atom are fluorine, chlorine, bromine and iodine. In addition, examples of the substituted or unsubstituted amino group include an alkylamino group, an arylamino group and an aralkylamino group.
The alkoxycarbonyl group is represented by -COOY'. Examples of Y' are the same as the examples of the above alkyl group. The alkylamino group and the aralkylamino group are represented by $-NQ^1Q^2$. Examples of each of

$Q^1$ and $Q^2$ are the same as the examples described in relation to the above alkyl group and the above aralkyl group (i.e., a group in which a hydrogen atom in the alkyl group is substituted with an aryl group), and preferable examples for each of $Q^1$ and $Q^2$ are also the same as those mentioned in relation to the above alkyl group and the above aralkyl group. Either one of $Q^1$ and $Q^2$ may be a hydrogen atom. It should be noted that the aralkyl group is a group in which a hydrogen atom in the alkyl group is substituted with the aryl group.
The arylamino group is represented by $-NAr^1Ar^2$. Examples for each of $Ar^1$ and $Ar^2$ are the same as the examples described in relation to the non-fused aromatic hydrocarbon group and the fused aromatic hydrocarbon group. Either one of $Ar^1$ and $Ar^2$ may be a hydrogen atom.

M represents aluminum (Al), gallium (Ga) or indium (In), among which In is preferable.
L in the formula (A) represents a group represented by a formula (A') or (A") below.

[Formula 86]

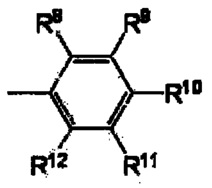

... (A')

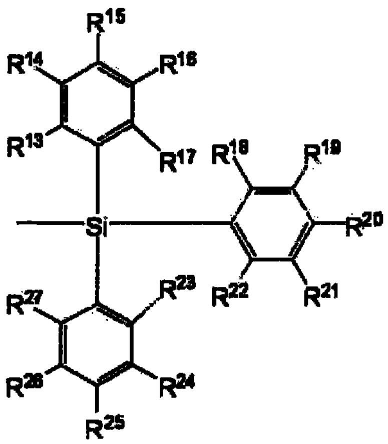

... (A")

$R^8$ to $R^{12}$ in the formula (A') independently represent a hydrogen atom or a hydrocarbon group having 1 to 40 carbon atoms (which may have a substituent, and an adjacent set of groups may form a cyclic structure.
$R^{13}$ to $R^{27}$ in the formula (A") independently represent a hydrogen atom or a hydrocarbon group having 1 to 40 carbon atoms (which may have a substituent), and an adjacent set of groups may form a cyclic structure.
Examples of the hydrocarbon group having 1 to 40 carbon atoms represented by each of $R^8$ to $R^{12}$ and $R^{13}$ to $R^{27}$ in the formulae (A') and (A") are the same as those of $R^2$ to $R^7$ in the formula (A).
Examples of a divalent group formed when an adjacent set of $R^8$ to $R^{12}$ and $R^{13}$ to $R^{27}$ forms a cyclic structure are a tetramethylene group, a pentamethylene group, a hexamethylene group, a diphenylmethane-2,2'-diyl group, a diphenylethane-3,3'-diyl group and a diphenylpropane-4,4'-diyl group.

The electron transporting layer preferably contains at least one of nitrogen-containing heterocyclic derivatives respectively represented by the following formulae (201) to (203).

[Formula 87]

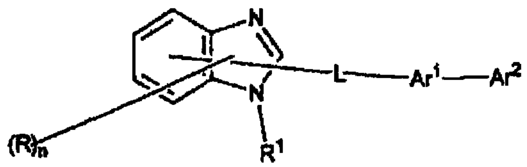

... (201)

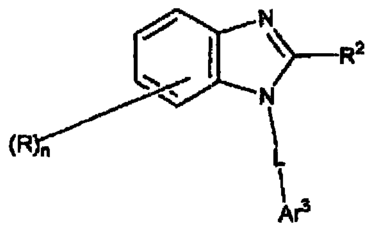

... (202)

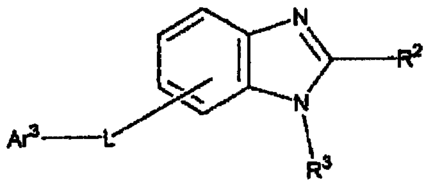

... (203)

R in the formulae (201) to (203) represents one of the following:

a hydrogen atom;
an aromatic or fused aromatic hydrocarbon group having 6 to 60 ring carbon atoms (which may have a substituent);
a pyridyl group (which may have a substituent);
a quinolyl group (which may have a substituent);
an alkyl group having 1 to 20 carbon atoms (which may have a substituent); and
an alkoxy group having 1 to 20 carbon atoms (which may have a substituent). n is an integer 0 to 4.

$R^1$ in the formulae (201) to (203) represents one of the following:

an aromatic or fused aromatic hydrocarbon group having 6 to 60 ring carbon atoms (which may have a substituent);
a pyridyl group (which may have a substituent);
a quinolyl group (which may have a substituent);
an alkyl group having 1 to 20 carbon atoms (which may have a substituent); and
an alkoxy group having 1 to 20 carbon atoms (which may have a substituent).

$R^2$ and $R^3$ in the formulae (201) to (203) independently represent one of the following:

a hydrogen atom;
an aromatic or fused aromatic hydrocarbon group having 6 to 60 ring carbon atoms (which may have a substituent);
a pyridyl group (which may have a substituent);
a quinolyl group (which may have a substituent);
an alkyl group having 1 to 20 carbon atoms (which may have a substituent); and an alkoxy group having 1 to 20 carbon atoms (which may have a substituent).

L in the formulae (201) to (203) represents one of the following:

an aromatic or fused aromatic hydrocarbon group having 6 to 60 ring carbon atoms (which may have a substituent);
a pyridinylene group (which may have a substituent);
a quinolinylene group (which may have a substituent); and
a fluorenylene group (which may have a substituent).

$Ar^1$ in the formulae (201) to (203) represents one of the following:

an aromatic or fused aromatic hydrocarbon group having 6 to 60 ring carbon atoms (which may have a substituent); and
a pyridinylene group or quinolinylene group (which may have a substituent).

$Ar^2$ in the formulae (201) to (203) represents one of the following:

an aromatic or fused aromatic hydrocarbon group having 6 to 60 ring carbon atoms (which may have a substituent);
a pyridyl group (which may have a substituent);
a quinolyl group (which may have a substituent);
an alkyl group having 1 to 20 carbon atoms (which may have a substituent); and
an alkoxy group having 1 to 20 carbon atoms (which may have a substituent).

$Ar^3$ in the formulae (201) to (203) represents one of the following:

an aromatic or fused aromatic hydrocarbon group having 6 to 60 ring carbon atoms (which may have a substituent);
a pyridyl group (which may have a substituent);
a quinolyl group (which may have a substituent);
an alkyl group having 1 to 20 carbon atoms (which may have a substituent);
an alkoxy group having 1 to 20 carbon atoms (which may have a substituent); and
a group represented by $-Ar^1-Ar^2$ (each of $Ar^1$ and $Ar^2$ is the same as described above).

As an electron transporting compound for the electron injecting layer or the electron transporting layer, 8-hydroxyquinoline or a metal complex of its derivative, an oxadiazole derivative, or a nitrogen-containing heterocyclic derivative is preferable. A specific example of the 8-hydroxyquinoline or the metal complex of its derivative is a metal chelate oxinoid compound containing a chelate of oxine (typically 8-quinolinol or 8-hydroxyquinoline). For instance, tris (8-quinolinol) aluminum can be used. Examples of the oxadiazole derivative are as follows.

[Formula 88]

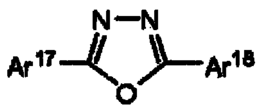

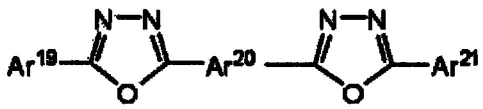

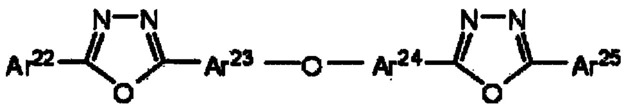

In the formula:
each of $Ar^{17}$, $Ar^{18}$, $Ar^{19}$, $Ar^{21}$, $Ar^{22}$ and $Ar^{25}$ represents a substituted or unsubstituted aromatic or fused aromatic hydrocarbon group having 6 to 40 ring carbon atoms; and
$Ar^{17}$ and $Ar^{18}$ may be mutually the same or different, $Ar^{19}$ and $Ar^{21}$ may be mutually the same or different, and $Ar^{22}$ and $Ar^{25}$ may be mutually the same or different.
Examples of the aromatic hydrocarbon group or fused aromatic hydrocarbon group having 6 to 40 ring carbon atoms are a phenyl group, naphthyl group, biphenyl group, anthranil group, perylenyl group and pyrenyl group. Examples of the substituent therefor are an alkyl group having 1 to 10 carbon atoms, alkoxy group having 1 to 10 carbon atoms and cyano group.
$Ar^{20}$, $Ar^{23}$ and $Ar^{24}$ each represent a substituted or unsubstituted divalent aromatic hydrocarbon group or fused aromatic hydrocarbon group having 6 to 40 ring carbon atoms. $Ar^{23}$ and $Ar^{24}$ may be mutually the same or different.
Examples of the divalent aromatic hydrocarbon group or fused aromatic hydrocarbon group are a phenylene group, naphthylene group, biphenylene group, anthranylene group, perylenylene group and pyrenylene group. Examples of the substituent therefor are an alkyl group having 1 to 10 carbon atoms, alkoxy group having 1 to 10 carbon atoms and

cyano group.

Such an electron transporting compound is preferably an electron transporting compound that can be favorably formed into a thin film(s). Examples of the electron transporting compounds are as follows.

[Formula 89]

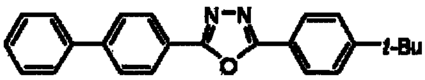

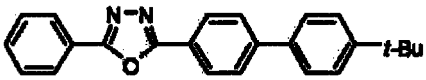

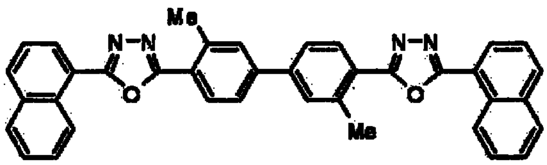

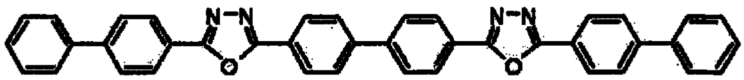

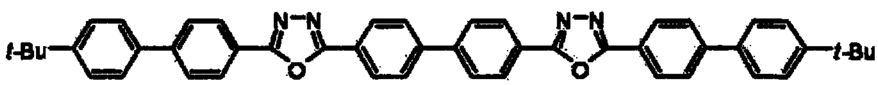

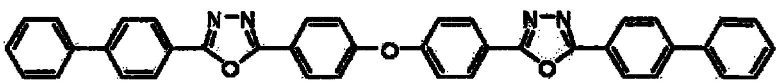

An example of the nitrogen-containing heterocyclic derivative as the electron transporting compound is a nitrogen-containing heterocyclic derivative that is not a metal complex, the derivative being formed of an organic compound represented by either one of the following formulae. Examples of the nitrogen-containing heterocyclic derivative are a five-membered ring or six-membered ring derivative having a skeleton represented by the following formula (B1) and a derivative having a structure represented by the following formula (B2).

[Formula 90]

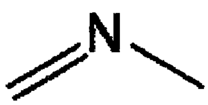

(B 1)

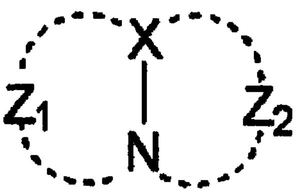

(B 2)

In the formula (B2), X represents a carbon atom or a nitrogen atom. $Z_1$ and $Z_2$ each independently represent a group of atoms capable of forming a nitrogen-containing heterocycle.

More preferably, the nitrogen-containing heterocyclic derivative is an organic compound having a nitrogen-containing aromatic polycyclic group having a five-membered ring or six-membered ring. Further, when the nitrogen-containing heterocyclic derivative is such a nitrogen-containing aromatic polycyclic group having plural nitrogen atoms, the nitrogen-containing heterocyclic derivative is preferably a nitrogen-containing aromatic polycyclic organic compound

having a skeleton formed by a combination of the skeletons respectively represented by the formulae (B1) and (B2), or by a combination of the skeletons respectively represented by the formulae (B1) and (C).

[Formula 91]

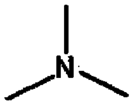

· · · (C)

A nitrogen-containing group of the nitrogen-containing aromatic polycyclic organic compound is selected from nitrogen-containing heterocyclic groups respectively represented by, for instance, the following formulae.

[Formula 92]

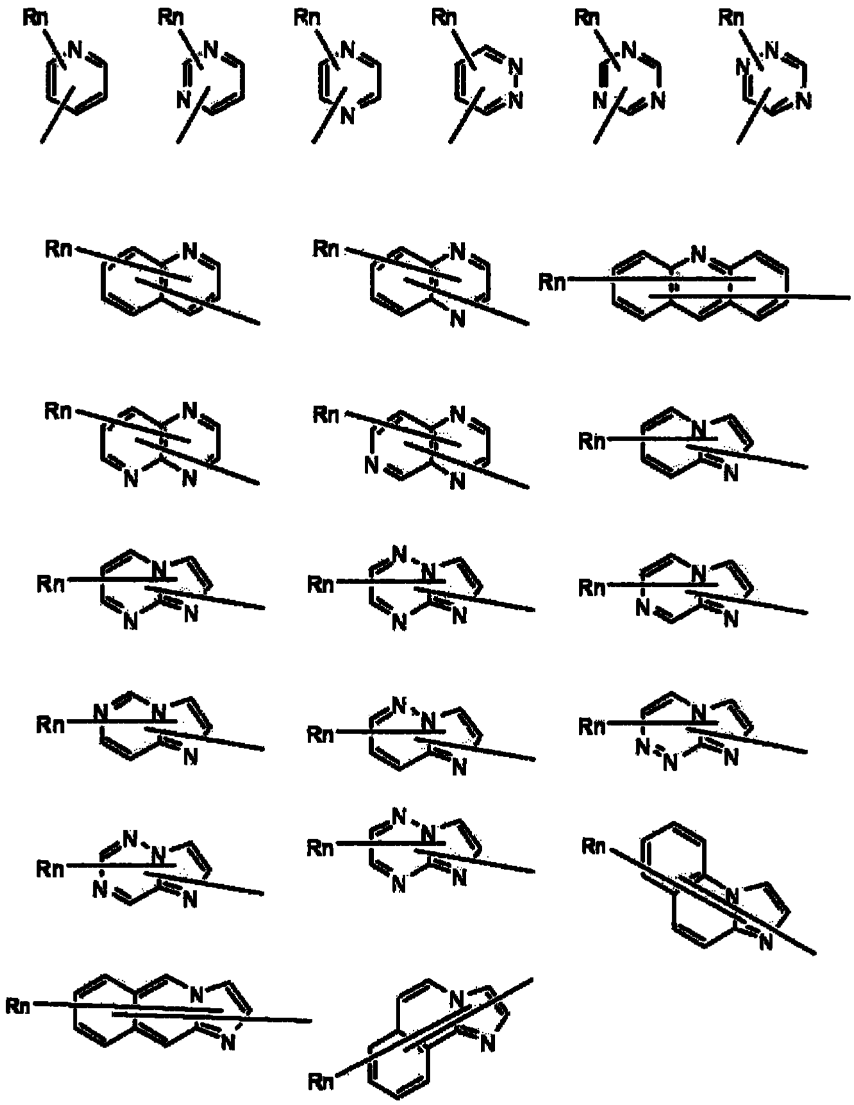

R in the formulae represents one of the following:

an aromatic or fused aromatic hydrocarbon group having 6 to 40 ring carbon atoms;

an aromatic or fused aromatic heterocyclic group having 2 to 40 ring carbon atoms;
an alkyl group having 1 to 20 carbon atoms; and
an alkoxy group having 1 to 20 carbon atoms.
n is an integer of 0 to 5. When n is 2 or more, a plurality of R may be mutually the same or different.

A preferable specific compound is a nitrogen-containing heterocyclic derivative represented by the following formula (D).

$$HAr\text{-}L^1\text{-}Ar^1\text{-}Ar^2 \quad \cdot\cdot\cdot (D)$$

In the formula (D), HAr represents a nitrogen-containing heterocyclic group having 1 to 40 ring carbon atoms (which may have a substituent).
In the formula (D), $L^1$ represents one of the following:

a single bond;
an aromatic or fused aromatic hydrocarbon group having 6 to 40 ring carbon atoms (which may have a substituent); and
an aromatic or fused aromatic heterocyclic group having 2 to 40 ring carbon atoms (which may have a substituent).

In the formula (D), $Ar^1$ represents a divalent aromatic hydrocarbon group having 6 to 40 ring carbon atoms (which may have a substituent).
In the formula (D), $Ar^2$ represents one of the following:

an aromatic or fused aromatic hydrocarbon group having 6 to 40 ring carbon atoms (which may have a substituent); and
an aromatic or fused aromatic heterocyclic group having 2 to 40 ring carbon atoms (which may have a substituent).
HAr is exemplarily selected from the following group.

[Formula 93]

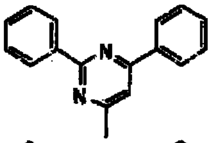 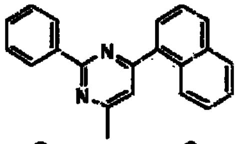 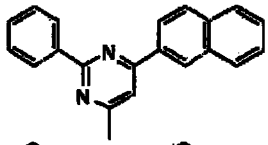

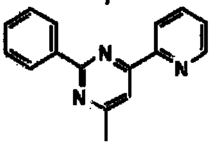 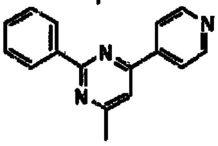 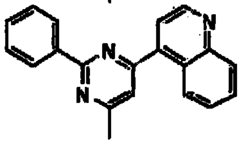

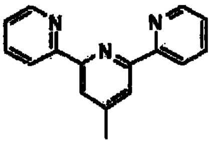 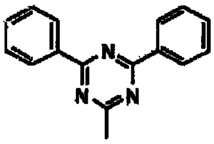 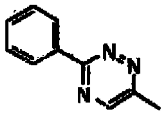

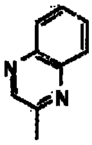 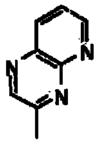 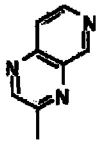 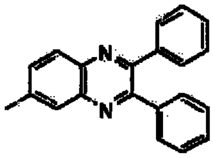

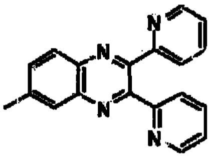 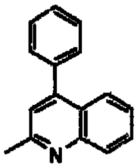 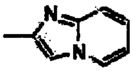 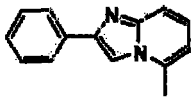

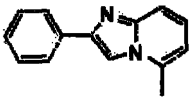 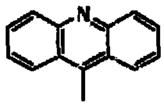 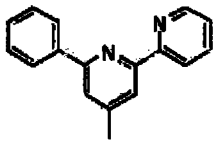

$L^1$ is exemplarily selected from the following group.

[Formula 94]

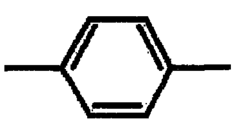 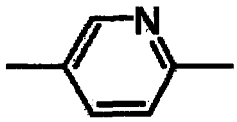

$Ar^1$ is exemplarily selected from the following arylanthranil groups.

[Formula 95]

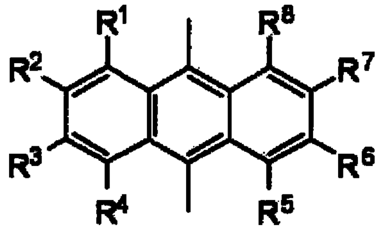

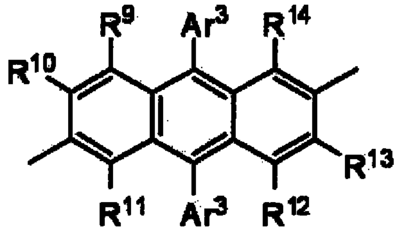

In the formula, $R^1$ to $R^{14}$ independently represent one of the following:

a hydrogen atom;
a halogen atom;
an alkyl group having 1 to 20 carbon atoms;
an alkoxy group having 1 to 20 carbon atoms;
an aryloxy group having 6 to 40 ring carbon atoms;
an aromatic or fused aromatic hydrocarbon group having 6 to 40 ring carbon atoms (which may have a substituent); and
an aromatic or fused aromatic heterocyclic group having 2 to 40 ring carbon atoms (which may have a substituent).
$Ar^3$ represents one of the following:

an aromatic or fused aromatic hydrocarbon group having 6 to 40 ring carbon atoms (which may have a substituent); and
an aromatic or fused aromatic heterocyclic group having 2 to 40 ring carbon atoms (which may have a substituent).
All of $R^1$ to $R^8$ of the nitrogen-containing heterocyclic derivative may be hydrogen atoms.

$Ar^2$ is exemplarily selected from the following group.

[Formula 96]

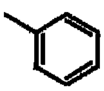
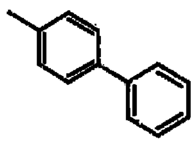
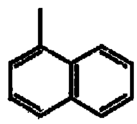
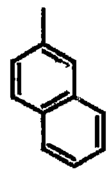

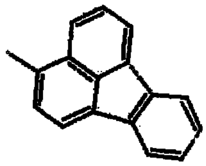
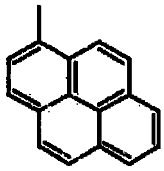
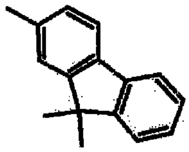

Other than the above, the following compound (see JP-A-9-3448) can be favorably used as the nitrogen-containing aromatic polycyclic organic compound (i.e., the electron transporting compound).

[Formula 97]

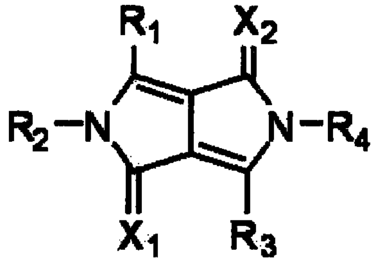

In the formula, $R_1$ to $R_4$ independently represent one of the following:

a hydrogen atom;
an aliphatic group (which may have a substituent);
an aliphatic cyclic group (which may have a substituent);
a carbocyclic aromatic cyclic group (which may have a substituent); and a heterocyclic group (which may have a substituent).
$X_1$ and $X_2$ independently represent an oxygen atom, a sulfur atom or a dicyanomethylene group.

The following compound (see JP-A-2000-173774) can also be favorably used as the electron transporting compound.

[Formula 98]

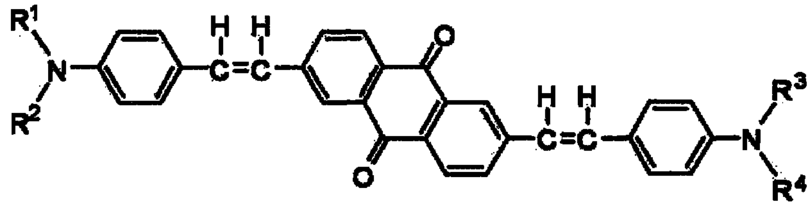

In the formula, $R^1$, $R^2$, $R^3$ and $R^4$, which may be mutually the same or different, each represent an aromatic hydrocarbon group or fused aromatic hydrocarbon group represented by the following formula.

[Formula 99]

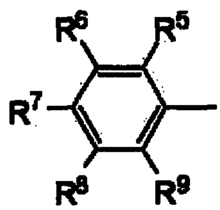

In the formula, $R^5$, $R^6$, $R^7$, $R^8$ and $R^9$, which may be mutually the same or different, each represent a hydrogen atom, saturated or unsaturated alkoxy group, alkyl group, amino group or alkylamino group. At least one of $R^5$, $R^6$, $R^7$, $R^8$ and $R^9$ represents a saturated or unsaturated alkoxy group, alkyl group, amino group or alkylamino group.
The electron transporting compound may be a polymer compound containing the nitrogen-containing heterocyclic group or nitrogen-containing heterocyclic derivative.
Although the thickness of the electron injecting layer or the electron transporting layer is not particularly limited, the thickness is preferably 1 nm to 100 nm.
The electron injecting layer preferably contains an inorganic compound such as an insulator or a semiconductor in addition to the nitrogen-containing cyclic derivative. Such an insulator or a semiconductor, when contained in the electron injecting layer, can effectively prevent a current leak, thereby enhancing electron injectability of the electron injecting layer.
As the insulator, it is preferable to use at least one metal compound selected from the group consisting of an alkali metal chalcogenide, an alkaline earth metal chalcogenide, a halogenide of alkali metal and a halogenide of alkaline

earth metal. By forming the electron injection layer from the alkali metal chalcogenide or the like, the electron injection capability can further be enhanced. Specifically, preferable examples of the alkali metal chalcogenide are $Li_2O$, $K_2O$, $Na_2S$, $Na_2Se$ and $Na_2O$, while preferable examples of the alkaline earth metal chalcogenide are CaO, BaO, SrO, BeO, BaS and CaSe. Preferable examples of the halogenide of the alkali metal are LiF, NaF, KF, LiCl, KCl and NaCl. Preferable examples of the halogenide of the alkaline earth metal are fluorides such as $CaF_2$, $BaF_2$, $SrF_2$, $MgF_2$ and $BeF_2$, and halogenides other than the fluoride.

Examples of the semiconductor are one of or a combination of two or more of an oxide, a nitride or an oxidized nitride containing at least one element selected from Ba, Ca, Sr, Yb, Al, Ga, In, Li, Na, Cd, Mg, Si, Ta, Sb and Zn. The inorganic compound for forming the electron injecting layer is preferably a microcrystalline or amorphous insulator film. When the electron injecting layer is formed of such an insulator film, a more uniform thin film can be formed, thereby reducing pixel defects such as a dark spot. Examples of such an inorganic compound are the above-described alkali metal chalcogenide, alkaline earth metal chalcogenide, halogenide of the alkali metal and halogenide of the alkaline earth metal.

When the electron injecting layer contains such an insulator or such a semiconductor, a thickness thereof is preferably in a range of approximately 0.1 nm to 15nm. The electron injecting layer according to the present invention may preferably contain the above-described reduction-causing dopant.

Reduction-causing Dopant

In the organic EL device according to this exemplary embodiment, a reduction-causing dopant may be preferably contained in an interfacial region between the cathode and the organic thin-film layer.

With this arrangement, the organic EL device can emit light with enhanced luminance intensity and have a longer lifetime. The reduction-causing dopant may be at least one compound selected from an alkali metal, an alkali metal complex, an alkali metal compound, an alkaline earth metal, an alkaline earth metal complex, an alkaline earth metal compound, a rare-earth metal, a rare-earth metal complex, a rare-earth metal compound and the like.

Examples of the alkali metal are Na (work function: 2.36 eV), K (work function: 2.28 eV), Rb (work function: 2.16 eV) and Cs (work function: 1.95 eV), and the alkali metal particularly preferably has a work function of 2.9 eV or less. Among the above, the reduction-causing dopant is preferably K, Rb or Cs, more preferably Rb or Cs, the most preferably Cs.

Examples of the alkaline earth metal are Ca (work function: 2.9 eV), Sr (work function: 2.0 eV to 2.5 eV) and Ba (work function: 2.52 eV), among which a substance having a work function of 2.9 eV or less is particularly preferable.

Examples of the rare-earth metal are Sc, Y, Ce, Tb and Yb, and the rare-earth metal particularly preferably has a work function of 2.9 eV or less.

Since the above preferred metals have particularly high reducibility, addition of a relatively small amount of the metals to an electron injecting zone can enhance luminance intensity and lifetime of the organic EL device.

Examples of the alkali metal compound are an alkali oxide such as $Li_2O$, $Cs_2O$ or $K_2O$ and an alkali halogenide such as LiF, NaF, CsF or KF, among which LiF, $Li_2O$ and NaF are preferable.

Examples of the alkaline earth metal compound are BaO, SrO, CaO and a mixture thereof, i.e., $Ba_xSr_{1-x}O$ ($0 < x < 1$), $Ba_xCa_{1-x}O$ ($0 < x < 1$), among which BaO, SrO and CaO are preferable.

Examples of the rare-earth metal compound are $YbF_3$, $ScF_3$, $ScO_3$, $Y_2O_3$, $Ce_2O_3$, $GdF_3$ and $TbF_3$, among which $YbF_3$, $ScF_3$ and $TbF_3$ are preferable.

The alkali metal complex, the alkaline earth metal complex and the rare-earth metal complex are not specifically limited, as long as at least one of alkali metal ion, alkaline earth metal ion and rare-earth metal ion is contained therein as metal ion. Ligand is preferably quinolinol, benzoquinolinol, acridinol, phenanthridinol, hydroxyphenyl oxazole, hydroxyphenyl thiazole, hydroxydiaryl oxadiazole, hydroxydiaryl thiadiazole, hydroxyphenyl pyridine, hydroxyphenyl benzoimidazole, hydroxybenzo triazole, hydroxy fluborane, bipyridyl, phenanthroline, phthalocyanine, porphyrin, cyclopentadiene, β-diketones, azomethines, or a derivative thereof, but the ligand is not limited thereto.

The reduction-causing dopant is added to preferably form a layer or an island pattern in the interfacial region. The layer of the reduction-causing dopant or the island pattern of the reduction-causing dopant is preferably formed by depositing the reduction-causing dopant by resistance heating deposition while an emitting material for forming the interfacial region or an organic substance as a electron-injecting material are simultaneously deposited, so that the reduction-causing dopant is dispersed in the organic substance. Dispersion concentration at which the reduction-causing dopant is dispersed in the organic substance is a mole ratio (organic substance to reduction-causing dopant) of 100:1 to 1:100, preferably 5:1 to 1:5.

When the reduction-causing dopant forms the layer, the emitting material or the electron injecting material for forming the organic layer of the interfacial region is initially layered, and the reduction-causing dopant is subsequently deposited singularly thereon by resistance heating deposition to form a preferably 0.1 nm to 15 nm-thick layer.

When the reduction-causing dopant forms the island pattern, the emitting material or the electron injecting material for

forming the organic layer of the interfacial region is initially formed in an island shape, and the reduction-causing dopant is subsequently deposited singularly thereon by resistance heating deposition to form a preferably 0.05 nm to 1 nm-thick island shape.
A ratio of the main component to the reduction-causing dopant in the organic EL device according to the exemplary embodiment of the invention is preferably a mole ratio (main component to reduction-causing dopant) of 5:1 to 1:5, more preferably 2:1 to 1:2.

Film Thickness

In the organic EL device of the exemplary embodiment, the thickness of each layer between the anode and the cathode is not specifically limited except for the thicknesses particularly specified above. However, the thickness of each layer is typically preferably in a range from several nanometers to 1 μm because an excessively thinned film is likely to entail defects such as a pin hole while an excessively thickened film requires application of high voltage and deteriorates efficiency.

Manufacturing Method of Organic EL Device

A manufacturing method of the organic EL device according to the exemplary embodiment is not particularly limited, and any manufacturing method used for forming a typical organic EL device is usable. Specifically, the respective layers can be formed by vacuum deposition, a casting method, a coating method, a spin coating method or the like. Moreover, in addition to the casting method, the coating method and the spin coating using a solution, in which the organic material of each layer is dispersed, on a transparent polymer such as polycarbonate, polyurethane, polystyrene, polyarylate and polyester, the respective layers can be formed by simultaneous deposition of the organic material and the transparent polymer, or the like.

It should be noted that the invention is not limited to the above description, but may include any modification as long as such modification stays within a scope and a spirit of the invention.
Although the organic EL device including the hole transporting layer provided between the anode and the first emitting layer is exemplarily described in the exemplary embodiment, the invention is not limited to such an arrangement. In other words, as long as the organic EL device includes an adjacent layer that is provided between the anode and the first emitting layer to be adjacent to the first emitting layer, the adjacent layer is not limited to the hole transporting layer. According to the invention, such an adjacent layer can be prevented from deterioration resulting from injection of electrons into the adjacent layer, thereby prolonging the lifetime of the organic EL device. An adjacent layer such as the electron injecting layer may be provided between the emitting layer and the cathode.

Examples

Examples of the invention will be described below. However, the invention is not limited by these Examples.

Example 1

The organic EL device according to Example 1 was manufactured as follows.
A glass substrate (size: 25 mm x 75 mm x 1.1 mm thick, manufactured by Geomatec Co., Ltd.) having an ITO transparent electrode (anode) was ultrasonic-cleaned in isopropyl alcohol for five minutes, and then UV/ozone-cleaned for 30 minutes. After the glass substrate having the transparent electrode line was cleaned, the glass substrate was mounted on a substrate holder of a vacuum deposition apparatus. A compound HT was initially formed onto a surface of the glass substrate where the transparent electrode line was provided so as to cover the transparent electrode. Thus, a 50-nm thick hole transporting layer was formed.
A compound PBH-01 (the first host) and a compound BD1 (the phosphorescent dopant) were co-deposited on the hole transporting layer. Thus, a 10-nm thick first emitting layer of blue emission was formed. A concentration of the compound BD1 was 10 mass%.
A compound PBH-04 (the second host) and the compound BD1 (the phosphorescent dopant) were co-deposited on the first emitting layer. Thus, a 40-nm thick second emitting layer of blue emission was formed. A concentration of the compound BD1 was 10 mass%.
The compound PBH-04 was layered on the second emitting layer to form a 5-nm thick exciton blocking layer. The exciton blocking layer is adapted to prevent diffusion of the triplet energy from the second emitting layer.
A compound ET was layered on the exciton blocking layer to form a 30-nm thick electron transporting layer.
Lithium fluoride (LiF) was vapor-deposited at a rate of 1 Å/min to form a 1-nm thick electron-injecting cathode. Metallic aluminum (Al) was vapor-deposited on the electron-injecting cathode to form an 80-nm thick cathode.

Examples 2 to 4 and Comparatives 1 to 5

The organic EL devices according respectively to Examples 2 to 4 and Comparatives 1 to 5 were formed in the same manner as in Example 1 except that the materials, a thickness of each of the layers and a concentration of each of the emitting materials were changed as shown in Table 1.
The numerals in parentheses in Table 1 indicate a thickness of each layer (unit: nm). The percentages in parentheses in Table 1 indicate a ratio of the phosphorescent material in each emitting layer (mass percentage).
Table 1

| | Arrangement of Organic EL Device |
|---|---|
| Example 1 | ITO / HT(50) / PBH-01: BD1 (10, 10%) / PBH-4: BD1 (40, 10%) / PBH-4(5) / ET(30) / LiF(1) / Al(80) |
| Example 2 | ITO / HT(50) / PBH-01: BD1 (10, 10%) / PBH-5: BD1 (40, 10%) / PBH-5(5) ET(30) / LiF(1) / Al(80) |
| Example 3 | ITO / HT(50) / PBH-02: BD1 (10, 10%) / PBH-4: BD1 (40, 10%) / PBH-4(5) / ET(30) / LiF(1) / Al(80) |
| Example 4 | ITO / HT(50) / PBH-03: BD1 (10, 10%) / PBH-4: BD1 (40, 10%) / PBH-4(5) / ET(30) / LiF(1) / Al(80) |
| Comparative 1 | ITO / HT(50) / CBP: BD1 (10, 10%) / TPBI: BD1 (40, 10%) / ET(30) / LiF(1) / Al(80) |
| Comparative 2 | ITO / HT(50) / mCp: BD1 (10, 10%) / TPBI: BD1 (40, 10%) / ET(30) / LiF(1) / Al(80) |
| Comparative 3 | ITO / HT(50) / PBH-01: BD1 (10, 10%) / PBH-01: BD1 (40, 10%) / ET(30) / LiF(1) / Al(80) |
| Comparative 4 | ITO / HT(50) / Host No. 1: BD1 (10, 10%) / Host No. 2: BD1 (40, 10%) / ET(30) / LiF(1) / Al(80) |
| Comparative 5 | ITO / HT(50) / Host No. 3: BD1 (10. 10%) / Host No. 4: BD1 (40, 10%) / ET(30) / LiF(1) / Al(80) |

Formulae of the first host, the second host, the phosphorescent dopant, the material of the hole transporting layer, and the material of the electron transporting layer used in Examples 1 to 4 and Comparatives 1 to 5 are shown below.
First Host
[Formula 100]

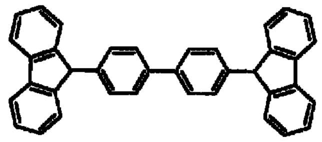

CBP

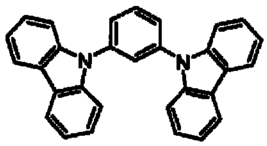

mCp

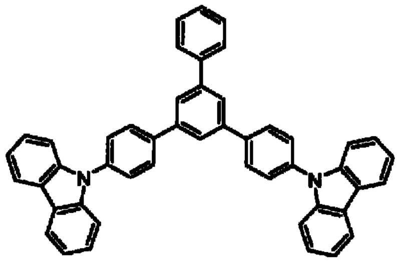

host No.1

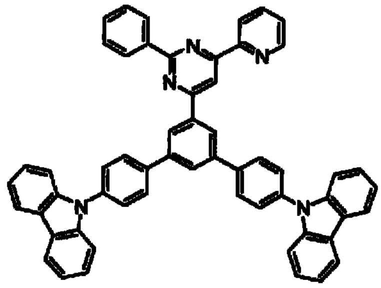

host No.3

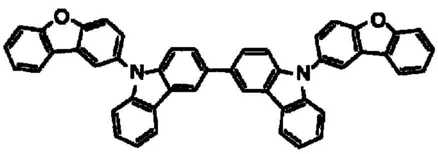

PBH-01

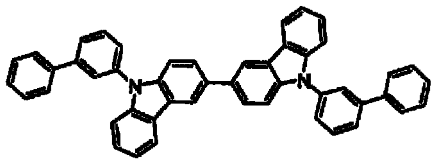

PBH-02

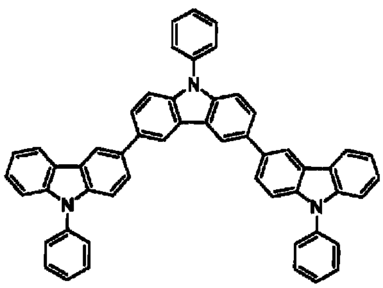

PBH-03

Second Host

[Formula 101]

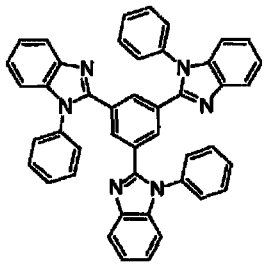

TPBI

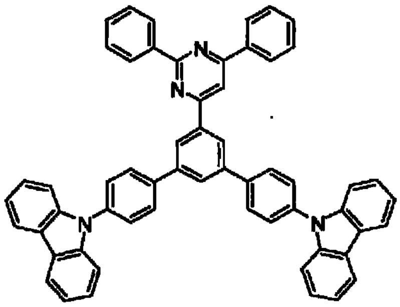

host No.2

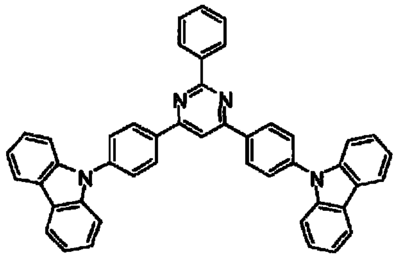

host No.4

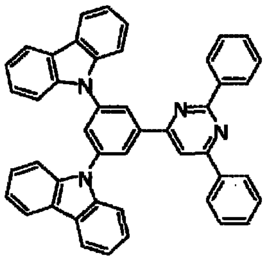

PBH-04

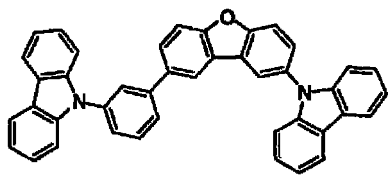

PBH-05

Phosphorescent Dopant

[Formula 102]

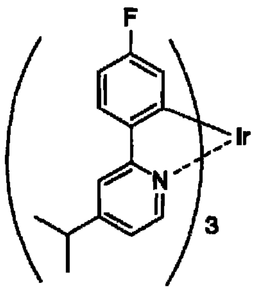

BD1

Material of Hole Transporting Layer

[Formula 103]

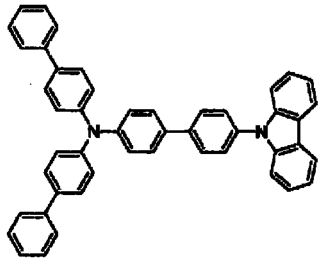

HT

Material of Electron Transporting Layer

[Formula 104]

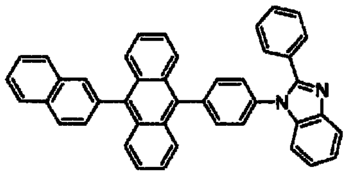

ET

The ionization potential, affinity and triplet energy of each of the first host, the second host, the material of the hole transporting layer, and the material of the electron transporting layer used in Examples 1 to 4 and Comparatives 1 to 5 were measured. The results are shown in Tables 2 to 4. A measurement method is the same as described hereinabove.

Table 2

| First Host | | | |
|---|---|---|---|
| Compound | Ionization Potential Ip [eV] | Affinity Af [eV] | Triplet Energy Eg(T) [eV] |
| CBP | 6.0 | 2.4 | 2.70 |
| mCP | 5.8 | 2.3 | 3.00 |
| Host No. 1 | 6.0 | 2.5 | 2.86 |
| Host No. 3 | 5.9 | 2.4 | 2.91 |
| PBH-01 | 5.5 | 2.2 | 2.90 |
| PBH-02 | 5.5 | 2.2 | 2.90 |
| PBH-03 | 5.5 | 2.2 | 2.80 |

Table 3

| Second Host | | | |
|---|---|---|---|
| Compound | Ionization Potential Ip [eV] | Affinity Af [eV] | Triplet Energy Eg(T) [eV] |
| TPBI | 6.1 | 2.6 | 2.60 |
| Host No. 2 | 6.1 | 2.6 | 2.90 |
| Host No. 4 | 6.1 | 2.9 | 2.78 |

(continued)

| Second Host | | | |
|---|---|---|---|
| Compound | Ionization Potential Ip [eV] | Affinity Af [eV] | Triplet Energy Eg(T) [eV] |
| PBH-04 | 6.0 | 2.6 | 3.00 |
| PBH-05 | 6.0 | 2.5 | 3.00 |

Table 4

| Material of Hole Transporting Layer or Electron Transporting Layer | | | |
|---|---|---|---|
| Compound | Ionization Potential Ip [eV] | Affinity Af [eV] | Triplet Energy Eg(T) [eV] |
| HT | 5.5 | 2.4 | 2.60 |
| ET | 6.0 | 3.1 | 1.80 |

Each of the organic EL devices according to Examples 1 to 4 and Comparatives 1 to 5 was driven at a current density of 10 $mA/cm^2$, and then voltage, luminous efficiency and durability (lifetime) were measured and evaluated. The results are shown in Table 5. A period of time elapsed until the initial luminescence intensity decreased to half was defined as the lifetime.

Table 5

| | Voltage [V] | Efficiency [cd/A] | Lifetime [hrs] |
|---|---|---|---|
| Example 1 | 4.5 | 28.8 | 2000 |
| Example 2 | 5.4 | 29.2 | 2200 |
| Example 3 | 4.7 | 28.1 | 1800 |
| Example 4 | 5.1 | 26.4 | 1800 |
| Comparative 1 | 6.0 | 23.1 | 400 |
| Comparative 2 | 6.2 | 24.8 | 300 |
| Comparative 3 | 7.9 | 10.8 | 200 |
| Comparative 4 | 6.2 | 25.5 | 1000 |
| Comparative 5 | 5.9 | 26.7 | 1000 |

As shown in Table 5, in each of the organic EL devices according to Examples 1 to 4, the respective triplet energies of the first host of the first emitting layer and the second host of the second emitting layer were 2.8 eV or more, the ionization potential of the first host was 5.5 eV or less, and the affinity $Af_1$ of the first host was smaller than the affinity $Af_2$ of the second host. In view of the above, it has been found out that each of the organic EL devices according to Examples 1 to 4 exhibits an excellent luminous efficiency and has a longer lifetime while requiring a lower driving voltage. In contrast, in each of the organic EL devices according to Comparatives 1, 2, 4 and 5, the ionization potential of the first host of the first emitting layer exceeded 5.5 eV, so that holes were not efficiently injected from the hole transporting layer into the first emitting layer. In view of the above, as compared with the organic EL devices according to Examples 1 to 4, it was found out that each of the organic EL devices according to Comparatives 1, 2, 4 and 5 exhibited a lower luminous efficiency and had a particularly shorter lifetime while requiring a higher driving voltage. It was found out that the organic EL device according to Comparative 3 exhibited a lower luminous efficiency and had a particularly shorter lifetime. Presumably, this is because although the first host of the first emitting layer of the organic EL device according to Comparative 3 had an ionization potential of 5.5 eV for efficient injection of holes into the first emitting layer, the first emitting layer and the second emitting layer thereof had the same value of affinity and thus the recombination region of holes and electrons coincided with the interfacial region between the electron transporting layer and the second emitting layer, so that the compound of the electron transporting layer was deteriorated due to a low hole tolerance thereof.

INDUSTRIAL APPLICABILITY

An organic EL device according to the invention is usable as a highly efficient and long-life organic EL device capable of blue emission.

EXPLANATION OF CODES

| | |
|---|---|
| 1 | Organic EL device |
| 2 | Substrate |
| 3. | Anode |
| 4 | Cathode |
| 5 | Emitting layer |
| 6 | Hole transporting layer |
| 7 | Electron transporting layer |
| 51 | First emitting layer |
| 52 | Second emitting layer |

**Claims**

**1.** An organic electroluminescence device comprising:

an anode;
a cathode being opposed to the anode; and a first emitting layer and a second emitting layer being provided between the anode and the cathode in this sequence from the anode, wherein
the first emitting layer and the second emitting layer each comprise a host and a phosphorescent dopant,
the host of the first emitting layer and the host of the second emitting layer each have a triplet energy of 2.8 eV or more,
the host of the first emitting layer has an ionization potential of 5.5 eV or less, and
an affinity $Af_1$ of the host of the first emitting layer is smaller than an affinity $Af_2$ of the host of the second emitting layer.

**2.** The organic electroluminescence device according to claim 1, wherein the affinity $Af_1$ of the host of the first emitting layer and the affinity $Af_2$ of the host of the second emitting layer satisfy a relationship of $Af_2 - Af_1 \geq 0.4$ [eV].

**3.** The organic electroluminescence device according to claim 1 or 2, wherein a difference between a singlet energy of the host of the first emitting layer and the triplet energy of the host of the first emitting layer is smaller than a difference between a singlet energy of the host of the second emitting layer and the triplet energy of the host of the second emitting layer.

**4.** The organic electroluminescence device according to any one of claims 1 to 3, wherein the first emitting layer and the second emitting layer are layered on each other.

**5.** The organic electroluminescence device according to any one of claims 1 to 4, wherein an emission peak of the phosphorescent dopants is 480 nm or less.

**6.** The organic electroluminescence device according to any one of claims 1 to 5, wherein a material for forming the phosphorescent dopant of the first emitting layer is different from a material for forming the phosphorescent dopant of the second emitting layer.

FIG.1

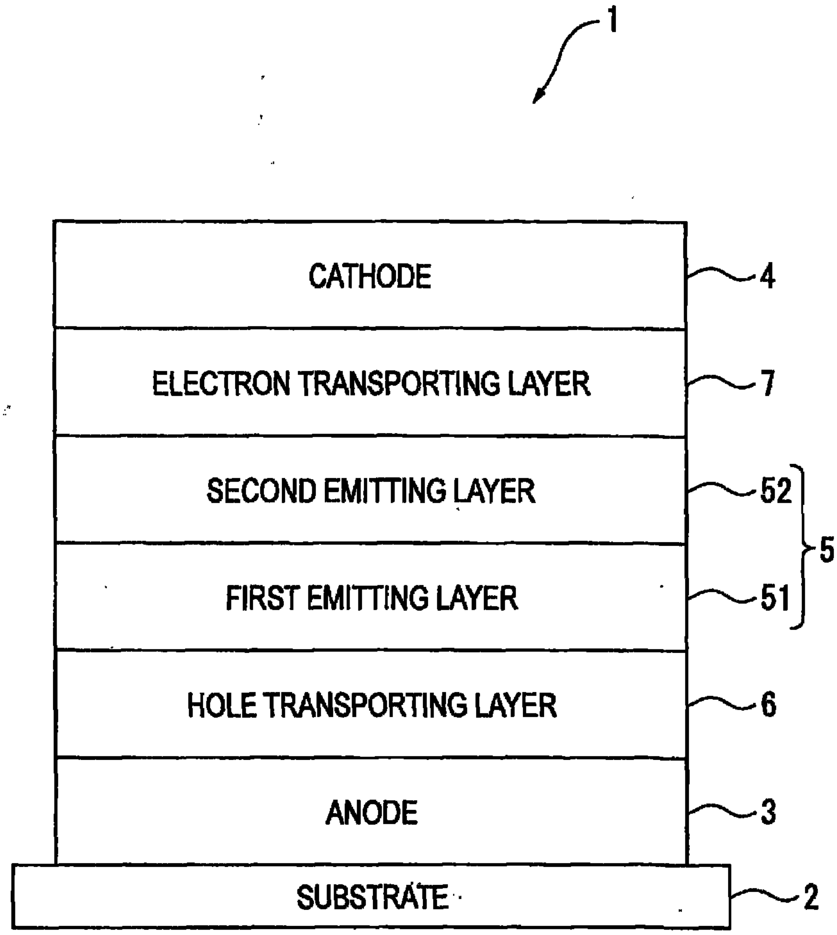
1
CATHODE
4
ELECTRON TRANSPORTING LAYER
7
SECOND EMITTING LAYER
52
5
FIRST EMITTING LAYER
51
HOLE TRANSPORTING LAYER
6
ANODE
3
SUBSTRATE
2

FIG.2

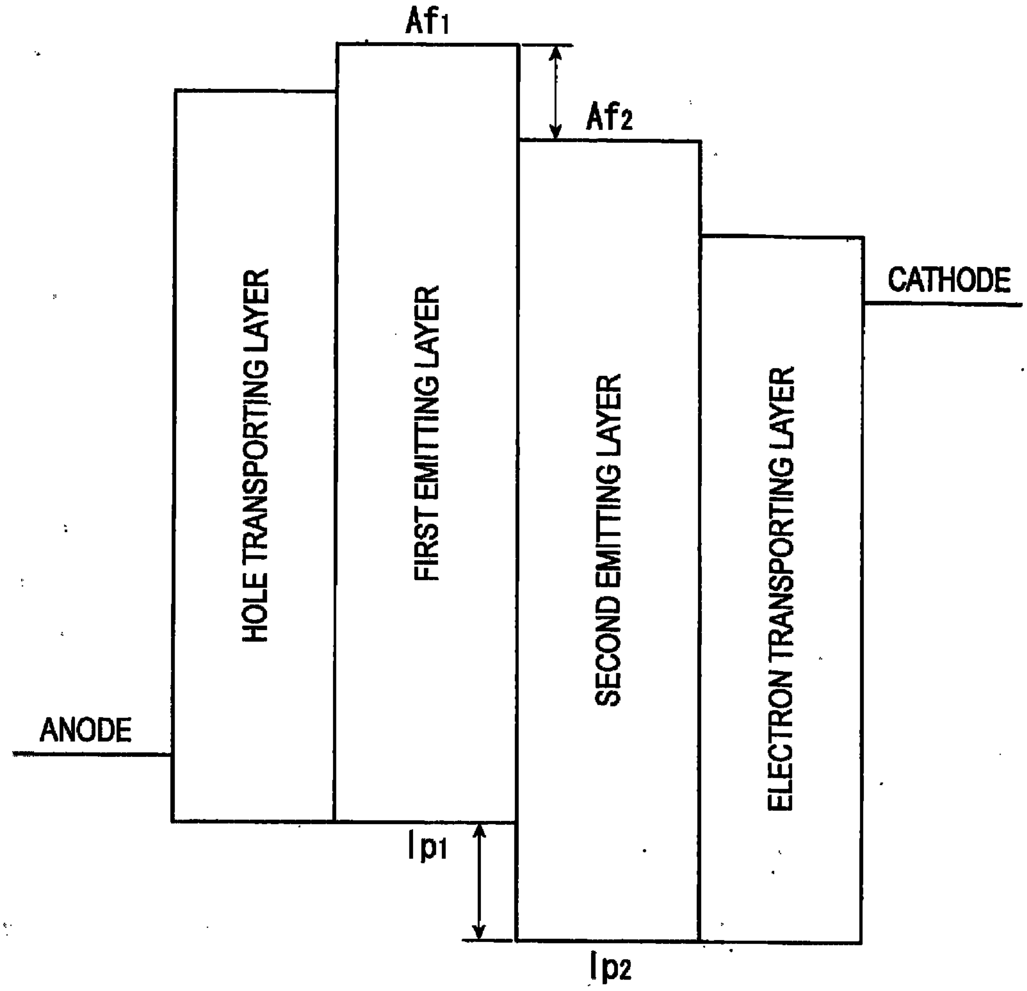
Af1
Af2
HOLE TRANSPORTING LAYER
FIRST EMITTING LAYER
SECOND EMITTING LAYER
ELECTRON TRANSPORTING LAYER
CATHODE
ANODE
Ip1
Ip2

**INTERNATIONAL SEARCH REPORT**

International application No.
PCT/JP2011/063103

A. CLASSIFICATION OF SUBJECT MATTER
*H05B33/12*(2006.01)i, *H01L51/50*(2006.01)i

According to International Patent Classification (IPC) or to both national classification and IPC

B. FIELDS SEARCHED

Minimum documentation searched (classification system followed by classification symbols)
H05B33/12, H01L51/50

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2011 |
| Kokai Jitsuyo Shinan Koho | 1971-2011 | Toroku Jitsuyo Shinan Koho | 1994-2011 |

Electronic data base consulted during the international search (name of data base and, where practicable, search terms used)
CAplus(STN), REGISTRY(STN)

C. DOCUMENTS CONSIDERED TO BE RELEVANT

| Category* | Citation of document, with indication, where appropriate, of the relevant passages | Relevant to claim No. |
|---|---|---|
| A | WO 2005/079118 A1 (Idemitsu Kosan Co., Ltd.), 25 August 2005 (25.08.2005), claims; paragraphs [0044], [0049] to [0059] & JP 2010-182699 A & US 2007/0159083 A1 & EP 1718122 A1 & KR 10-2006-0114009 A & CN 1918946 A | 1-6 |
| A | JP 2007-251097 A (Konica Minolta Holdings, Inc.), 27 September 2007 (27.09.2007), claims; paragraphs [0084], [0102] to [0103], [0198], [0213] (Family: none) | 1-6 |

☒ Further documents are listed in the continuation of Box C.

☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| | |
|---|---|
| Date of the actual completion of the international search<br>07 July, 2011 (07.07.11) | Date of mailing of the international search report<br>09 August, 2011 (09.08.11) |
| Name and mailing address of the ISA/<br>Japanese Patent Office<br>Facsimile No. | Authorized officer<br><br>Telephone No. |

Form PCT/ISA/210 (second sheet) (July 2009)

**INTERNATIONAL SEARCH REPORT**

International application No.
PCT/JP2011/063103

C (Continuation). DOCUMENTS CONSIDERED TO BE RELEVANT

| Category* | Citation of document, with indication, where appropriate, of the relevant passages | Relevant to claim No. |
|---|---|---|
| A | JP 2006-352046 A (Fujifilm Holdings Corp.), 28 December 2006 (28.12.2006), claims; paragraph [0040]; s d; paragraph [0111] (Family: none) | 1-6 |
| A | WO 2008/035571 A1 (Konica Minolta Holdings, Inc.), 27 March 2008 (27.03.2008), claims; paragraphs [0192], [0194], [0195], [0220] to [0223] (Family: none) | 1-6 |
| A | JP 2007-311460 A (Konica Minolta Holdings, Inc.), 29 November 2007 (29.11.2007), claims; paragraphs [0049], [0050], [0209] & US 2009/0167165 A1 & WO 2007/132886 A1 | 1-6 |
| A | JP 2008-135498 A (Toray Industries, Inc.), 12 June 2008 (12.06.2008), claims; paragraphs [0035], [0036] (Family: none) | 1-6 |
| A | JP 2007-288035 A (Konica Minolta Holdings, Inc.), 01 November 2007 (01.11.2007), claims; paragraphs [0056] to [0058], [0227] & US 2009/0302745 A1 & WO 2007/119816 A1 | 1-6 |
| A | WO 2009/066778 A1 (Idemitsu Kosan Co., Ltd.), 28 May 2009 (28.05.2009), claims; paragraphs [0243], [0248] & US 2011/0001130 A & EP 2221897 A1 & CN 101874316 A & KR 10-2010-0093085 A | 1-6 |
| P,A | JP 2011-8991 A (Konica Minolta Holdings, Inc.), 13 January 2011 (13.01.2011), claims; paragraphs [0032] to [0046], [0267], [0284] (Family: none) | 1-6 |

Form PCT/ISA/210 (continuation of second sheet) (July 2009)

**INTERNATIONAL SEARCH REPORT**

International application No.
PCT/JP2011/063103

Although claim 1 involves all constitutions using hosts having triplet energy, ionization potential and affinity each of which is in a specified value range, disclosed within the meaning of PCT Article 5 is only the constitution using a host which has a specified chemical structure set forth in the description, and therefore, claim 1 lacks the support within the meaning of PCT Article 6.

Consequently, this search has been carried out within the scope supported by and disclosed in the description, that is, with respect to mainly the constitution using a host which has a specified chemical structure specifically set forth in the description.

Form PCT/ISA/210 (extra sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2001319779 A
- JP 2008084913 A
- JP 2010034484 A
- WO 2005079118 A
- WO 2009050281 A
- WO 2009003898 A
- WO 2008034758 A
- WO 2006056418 A
- WO 2006130598 A
- WO 2009085344 A
- JP 9003448 A
- JP 2000173774 A


### Non-patent literature cited in the description


- **X.ZHOU et al.** *Appl.Phys.Lett.,* 2002, vol. 81, 4070-4072
- Hikarikagaku no Sekai. 1993, 50